# EUROPEAN PATENT SPECIFICATION

(11) **EP 2 985 079 B1**
(45) Date of publication and mention of the grant of the patent: **03.10.2018**
(21) Application number: 14180782.6
(22) Date of filing: 13.08.2014
(51) Int. Cl.: B01J 29/14, B01J 37/14, B01J 37/02, C23C 16/52, B01J 29/06, B01J 29/064, B01J 29/072, C23C 16/04, C23C 16/40, C23C 16/442, C23C 16/455, B01J 29/46, B01J 29/76, B01J 29/24

(54) **Production process of a core/shell structured solid support metal catalyst**
Herstellungsverfahren eines Metallkatalysators mit Kern/Schale Struktur und festem Träger
Procédé de fabrication d'un catalyseur metallique avec un structure noyau-enveloppe et support solide

(43) Date of publication of application: 17.02.2016
(73) Proprietor: Directa Plus S.p.A., 22074 Lomazzo (CO) (IT)
(72) Inventor: Cesareo, Giulio, 22074 Lomazzo (IT); Popescu, Razvan, 22074 Lomazzo (IT); Weinberger, Manuel, 89073 Ulm (DE); Dreer, Christian, 86153 Augsburg (DE)
(74) Representative: Cremer, Christian

(56) References cited:
- EP-A1- 2 767 337
- LI J ET AL: "Highly dispersed Pt nanoparticle catalyst prepared by atomic layer deposition", APPLIED CATALYSIS B: ENVIRONMENTAL, ELSEVIER, AMSTERDAM, NL, vol. 97, no. 1-2, 9 June 2010 (2010-06-09) , pages 220-226, XP027057416, ISSN: 0926-3373 [retrieved on 2010-04-14]
- ARJEN P. DIDDEN ET AL: "Fluidized-bed atomic layer deposition reactor for the synthesis of core-shell nanoparticles", REVIEW OF SCIENTIFIC INSTRUMENTS, vol. 85, no. 1, 31 January 2014 (2014-01-31), page 013905, XP055173241, ISSN: 0034-6748, DOI: 10.1063/1.4863099
- ARISTEIDIS GOULAS ET AL: "Scalable Production of Nanostructured Particles using Atomic Layer Deposition", KONA POWDER AND PARTICLE JOURNAL, vol. 31, no. 0, 1 January 2014 (2014-01-01), pages 234-246, XP055173217, ISSN: 0288-4534, DOI: 10.14356/kona.2014013
- GORDON R G ET AL: "A kinetic model for step coverage by atomic layer deposition in narrow holes or trenches", CHEMICAL VAPOR DEPOSITION, WILEY-VCH VERLAG, WEINHEIM, DE, vol. 9, no. 2, 20 March 2003 (2003-03-20), pages 73-78, XP002327127, ISSN: 0948-1907, DOI: 10.1002/CVDE.200390005
- LONGRIE DELPHINE ET AL: "Reactor concepts for atomic layer deposition on agitated particles: A review", JOURNAL OF VACUUM SCIENCE AND TECHNOLOGY: PART A, AVS /AIP, MELVILLE, NY., US, vol. 32, no. 1, 28 February 2014 (2014-02-28), pages 010802-1-13, XP012184400, ISSN: 0734-2101, DOI: 10.1116/1.4851676 [retrieved on 1901-01-01]

## Description

This invention relates to a process and an use of an apparatus for production of catalytically active metal composites comprising a solid support material. The metal composites can be designed with a combination of metallic or a combination of metallic and non-metallic materials. The process provides confinement of metal by a shell structure, which is also named eggshell-structure. The activation of at least one chemical reaction like a synthesis reaction, a molecular decomposition or an oxidation reaction can be facilitated. The production process and the apparatus provide a good quality of a catalyst, which can be used for a more efficient conversion of starting materials.

### Background art

Porous materials like zeolites and metal carbonyls as starting materials for production of catalyst materials are described in GB 364 586 A (assignor: I. G. Farbenindustrie AG; filing date: September 29^{th}, 1930) and in GB 937 749 A (assignor: Union Carbide Corporation; filing date: September 23^{rd}, 1959). The process comprises thermal decomposition of the metal carbonyl. Before the metal deposition, zeolite material is activated by driving off all of the adsorbed water. Hydrogen was added in order to improve the decomposition of the metal carbonyls. Similar aspects are described for the production of iron group metal catalysts in US 3 013 990 A (inventor: D. W. Breck et al.; filing date: September 11^{th}, 1961).

Several other approaches for the production of metallic films on different porous substrates using metal carbonyls are discussed in the patents US 3 075 494 A (assignor: H. A. Toulmin JR; filing date: February 19^{th}, 1960), US 3 158 499 A (assignor: W. C Jenkin; filing date: July 7^{th}, 1960), and US 3 998 758 A (assignor: R. A. Clyde; filing date: August 18^{th}, 1975). Metals are typically deposited by heating the substrates for thermal decomposition of the metal carbonyls. Metal carbonyls are also decomposed by heat in the gas phase.

In US 5 314 727 (assignor: Minnesota Mining & Mfg. Co./Regents of the University of Minnesota; filing date: July 28^{th}, 1992) an overview of CVD related processes that could be used for metallisation of substrates is given. A considerable amount of metal is deposited on outer surfaces of the substrates often smoothing out the porosity of the material to some extend. For thick substrate materials a temperature gradient through the substrate can in addition affect homogeneity of the deposition. In some cases a process of calcination by heating the catalyst in air to a few hundred °C is applied in order to improve catalyst activity.

An approach taught by US 2 900 245 A (assignor: General Aniline & Film Corp.; filing date: January 24^{th}, 1957) comprises a closed loop process. With an inert gas thermal decomposition of a metal carbonyl may be controlled by controlling conditions of temperature, pressure and gas velocity. Metal particles in a dimension of 1 micron size and bigger can be produced.

US 5 064 464 (inventor: Y. Sawada et al.; assignor: Mitsubishi Petrochemical Company Ltd.; filing date: Nov. 9^{th}, 1989) claims production of ultrafine metal particles in a reactor with a process by which a high temperature diluent gas from a conduit is brought in contact with a mixed gas with the transition metal carbonyl compound from a nozzle outlet of a conduit. Heat of 300 °C to 800 °C for decomposition is instantaneously supplied from high temperature diluent gas. Clogging of conduits and nozzles by metal may occur when thermal decomposition of metal carbonyl is applied.

WO 2007/136 389 A2 (applicant: Directa Plus Patent & Technology Limited; priority date: August 10^{th}, 2005) proposes to employ a flow-reactor vessel which may be operated in a certain temperature range, pressure range and with controlled amount of added energy. Thus, the process of producing nano-scale metallic particles is basically controlled by the environmental conditions within the reactor. In a further embodiment, the reactants can be borne on a stream like a fluid stream, especially an inert gas stream which may pass through an injector into the reactor vessel. While WO 2007/136 389 A2 proposes to operate the reactor by feeding at least one metal carbonyl, a similar patent application by the publication number WO 2007/021 768 A2 (applicant: Directa Plus Patent & Technology Limited; priority date: August 10^{th}, 2005) refers to continuously feeding at least one decomposable moiety selected from a group of complexes or compounds.

Additional further details on how to produce nano-scale particles may be derived from WO 2007/021 769 A2 (applicant: Directa Plus Patent & Technology Limited; priority date: August 10^{th}, 2005), WO 2007/021 770 A2 (applicant: Directa Plus Patent & Technology Limited; priority date: August 10^{th}, 2005), WO 2007/142 662 A2 (applicant: Directa Plus Patent & Technology Limited; priority date: August 10^{th}, 2005). More details of production facilities and of the method using a heating gas for moiety decomposition and metal nano-particle production are described in EP 2 425 915 A2 (applicant: Directa Plus SRL; filing date: September 1^{st}, 2010) and in EP 2 425 916 A2 (applicant: Directa Plus SRL; filing date: September 1^{st}, 2010).

The Patent US 5 641 723 A (assignor: Studiengesellschaft Kohle mbH; filing date: April 7^{th}, 1992) describes yet another method for the production of doped metal supported catalysts. The support material is exposed to a solution of the metal compound at a temperature between -18 °C and +25 °C. The method also involves an optional after-treatment of the sample. Several of the examples given in document US 5 641 723 A are referring to activated carbon catalysts, which are produced with metal clusters or aggregates formed in solution.

A similar method was used for metal zeolite catalysts, in particular nickel zeolite catalysts e. g. in C. Zhao and J. A. Lercher, Angew. Chem. Int. Ed. 51, p. 1 to p. 7 (2012). The method referred to was named incipient impregnation, where the solution of the active metal precursor is drawn into pores by capillary action. The catalyst is thought to be useful for production of biofuels.

An overview of selective catalytic reduction (SCR) of NOₓ gases with ammonia by Iron zeolite catalyst is given in S. Brandenberger et al., Catalysis Reviews 50, p. 492 to p. 531 (2008). Catalysts for SCR are often required to have good catalytic activity at low temperatures and hydrothermal stability at high temperatures. It was found that both the topology and the metal at the active sites, introduced e. g. by metal ion exchange processes in liquids, can be important factors in this respect. At high temperatures processes like de-alumination of zeolite and loss of the introduced metal like iron can impede or suppress any catalyst activity. Further studies of Iron-zeolite properties, where the catalyst is produced with the ion exchange method in a liquid, are described e. g. in S. Brandenberger et al., Applied Catalysis B: Environmental 95, p. 348 to p. 357 (2010). The Journal of Catalysis 268, p. 297 to p. 306 (2009) is discussing the relevance of zeolite Brønstedt acidity for binding metal ions in aqueous solutions. Spectroscopic data and calculation of statistical distributions of different Iron species in zeolites can be found in Applied Catalysis A: General 373, p. 168 to p. 175 (2010). Further approaches for catalyst optimization are discussed in Ind. Eng. Chem. Res. 50, p. 4308 to p. 4319 (2010) by the same research group.

M. S. Kumar et al. describe in the Journal of Catalysis 227, p. 384 to p. 397 (2004) an analysis of UV/Vis diffuse reflection spectra (DRS) of catalysts for distinguishing between different types of isolated Fe species as well as FeₓO_{y} aggregates of different size. Further details on this spectroscopic method can be found in J. Perez-Ramirez et al., Journal of Catalysis 223, p. 13 to p. 27 (2004) and in S. Bordiga et al., Journal of Catalysis 158, p. 486 to p. 501 (1996).

Deposition of cobalt (Co) on zeolite was investigated by J. Dědeček et al., Journal of Catalysis 211, p. 198 to p. 207 (2002). Several distinct adsorption sites could be identified and attributed to monomeric Co. Samples were prepared by means of ion exchange reaction of zeolite material in cobalt nitrate solution at room temperature.

An iron impregnated zeolite catalyst for reduction of NOₓ with CO or C₃H₆ is described in Y. Okamoto et al., Studies in Surface Science and Catalysis 105 p. 2051 to p. 2058 (1997), but detailed understanding of the catalytic activity still requires further scientific research. In a following article published in Physical Chemistry Chemical Physics, vol. 4, no. 12, p. 2852 to p. 2862 (2002), synthesis of molybdenum oxide clusters confined in zeolite supercages using Mo(CO)₆, which is adsorbed in the pores, is described. Dimeric species can be transformed into monomeric species with an additional heat treatment at 673 K. The clusters are used for catalysis of the oxidation reaction of ethyl alcohol to produce acetaldehyde.

Some residual solvent molecules or impurities of the solvents used may have unfavourable effects on catalyst activity or stability. There are some limits with such technologies e. g. for the control of locations, where the metal nano-particles can be deposited, in particular when access to the locations is spatially limited or when solvent molecules shield surface adsorption sites. Furthermore, nano-particles or thin metallic films deposited on a support or prepared from solution may not show the desired catalytic activity.

Deposition of TiO₂, Cr₂O₃, CeO₂ and ZrO₂ and other metals or respective metal oxides like manganese oxide or copper oxide by means of spray pyrolysis for use as dopants has been carried out in patent US 8 114 808 B2 (assignee: University of Cincinnati; filing date: December 10^{th} 2009). This patent and the article by K. Chen et al., J. Phys. Chem B 104, p. 1292 to p. 1299 (2000) offer a detailed list of Tammann temperatures, which present invention refers to.

In the article by G. A. Ozin et al. in Acc. Chem. Res. 25, p. 553 to p. 560 (1992), tungsten and molybdenum carbonyls were used for deposition on zeolites. In some specific cases monomeric metal was found. Photooxidation was applied for decomposition of the moieties. Another example of monomeric metal on zeolite is mentioned by R. Bal et al. in Angew. Chem. Int. Ed. 45, p. 448 to p. 452 (2006). The monomer metal was obtained by treatment of a Rhenium deposit with oxygen, but the samples showed no catalytic activity.

The patent US 6 489 258 B1 (assignor: Massachusetts Institute of Technology; filing date: October 15^{th} 1999) describes a method for binding molecular compounds to specific surface sites of a zeolite, namely oxygen functionalities. These sites can be activated with initial process steps using silane and formation of covalent bonds to compounds, which are adsorbed on the substrate as precursor for metal or metal oxide catalyst. In this process compounds like palladium organic complex were used.

Studies from F. Seel et al. in Z. anorg. Chem. 534, p. 159 to p. 174 (1986) show that the physisorption of iron pentacarbonyl on zeolites leaves the pore structures intact. The energy required for desorption appears to be higher than the energy required for decomposition of physisorbed iron pentacarbonyl. Desorbed fragments, so called sub-carbonyls tend to migrate to the outer surface of zeolite particles and aggregate there in relatively large iron particles. Thermal desorption of Iron pentacarbonyl from specific zeolites was also investigated by T. C. Golden et al. in Ind. Eng. Chem. Res., 30, p. 502 to p. 507 (1991) and efficient desorption due to heat treatment for regeneration of a filter was found.

The use of Iron pentacarbonyl catalysts for Fischer-Tropsch type catalysis is discussed by Th. Bein et al. in the Journal of Physical Chemistry 90, p. 4851 to p. 4856 (1986). The catalyst was prepared by crushing a zeolite into fine powder, adsorption of iron pentacarbonyl at room temperature followed by a degassing procedure. Afterwards the catalyst sample was exposed to oxygen at 77 K liquid air temperature in order to transform the iron pentacarbonyl. Experiments carried out by exposure to oxygen at room temperature gave similar results as discussed in Th. Bein et al., Ber. Bunsenges. Phys. Chem. 90, p. 395 to p. 398 (1986). When alumina or silica support materials were used, aggregation of iron particles occurred at lower temperature than using zeolite. An example for production method of low bulk density silica can be found in US 3 556 725 (inventor: V. Chiola et al.; filing date: February 26^{th}, 1969).

Aspects elucidating the role of diffusion for the synthesis of C₅₊ molecules using cobalt as catalyst metal for Fischer-Tropsch type catalysis are described in the article by E. Iglesia et al. in Topics in Catalysis 2, p. 17 to 27 (1995). Since impregnation is carried out using solutions, control over contact time by means of filtration techniques is not very satisfying. Formation of CH₄ is considered as an unwanted by-product in this type of synthesis. Eggshell structured catalysts were studied in an article by the same first author, namely E. Iglesia et al. in Journal of Catalysis 153, p. 108 to p. 122 (1995). A molten salt of cobalt was used, which penetrates a porous support pellet by imbibition. Extended periods of several hours time were necessary, e. g. for removal of excess liquid, surface wiping, and sample drying in air followed by high temperature treatment with up to at least 693 K under H₂ atmosphere, passivation with exposure to 1% O₂ in Helium at room temperature and another re-reducing step at 693 K. Even though some control over the production process was stated, the authors have observed that impregnated species can re-equilibrate quickly during drying and pre-treatment leading to rather uniform distributions, in particular when adsorption strength is rather weak.

In US 4 532 229 (inventor: R. A. Fiato et al.; filing date December 14^{th} 1983), a process for preparing a Fischer-Tropsch mixed metal Fe-Co catalyst from metal carbonyl in a slurry liquid is suggested. The catalyst is used for alpha-olefin production from metal carbonyl by conversion of CO/H₂ into hydrocarbons in the size range C₂-C₄. A Fischer-Tropsch Fe-Co catalyst for C₅₊ hydrocarbons, where Fe has a high concentration at the outside of a particle and a lower concentration towards the centre, is described in US 2010/0 004 346 A1 (inventor: R. Haswell et al.; filing date July 12^{th}, 2007). Cobalt is homogeneously distributed throughout the catalyst particle. Difficulties controlling the concentration of the iron in the catalyst were noticed and therefore iron was added after reduction of the cobalt catalyst and at an upstream end of a packed bed of particles at a temperature of 180 °C to 300 °C.

Examples of different eggshell catalysts produced by adsorption from solution or liquid and calcination are described in the articles of B. Liu et al., Applied Catalysis A: General 388, p. 248 to 255 (2010); J. M. Badano et al., Applied Catalysis A: General, 390 p. 166 to 174 (2010); J. Wang et al., Molecules 18, p. 8289 to 8297 (2013); E. Peluso et al., Chemical Engineering Science 56, p. 1239 to p. 1245 (2001); S. A. Gardezi et al., Ind. Eng. Chem. Res. 51, p. 1703 to p. 1712 (2012); and E. Iglesia et al., Topics in Catalysis 2, p. 17 to p. 27 (1995).

An example of a fluidized bed reactor design is described in US 5 876 793 (inventor: Sherman et al., assignee: Ultramet; filing date: February 21^{st}, 1996). The reactor is used for production of encapsulating coatings on fine particulates of materials, like diamond. Chemical vapour deposition is carried out in a heated reaction zone within the reactor. Another design of a reactor that can be used for production of a catalyst material is shown in the article by D. M. King et al., Surface & Coatings Technology 201, p. 9163 to p. 9171 (2007). The floating bed reactor vessel comprises a mass spectrometer connected to a pump outlet. In a chemical vapour deposition process, entering precursor molecules are exposed to nucleation sites within the bed until very high stochastic surface conversion is reached. Mechanical agitation and stirring can be carried out. In the reactor, a fill of e. g. 50 g ultrafine spherical powder is treated. A trimethylaluminium (TMA) - Water (H₂O) reaction is used for deposition of Al₂O₃, e. g. on TiO₂, in order to produce a photocatalytically active material. In a following article, by J. Li et al., Applied Catalysis B: Environmental 97, p. 220 to p. 226 (2010) with several authors in common, the fluidized bed reactor was used for production of nanoparticulate platinum on porous silica gel particles. Platinum particles of about 1.2 nm were produced and used for catalysis of CO oxidation.

The fluidized bed apparatus according to patent application US 5 891 517 A (inventor: Kenneth W. Cox; filing date: 19.07.1996) is used for production of pyrolytic carbon coatings of particles by heating particles and the carbonaceous substances and by thermal decomposition. An injection device above the upper end closure of the reactor is designated to feed small particles into the reaction chamber. In document US 2012/085 284 A (inventor: Mark W. Dassel; filing date: 28.09.2011) a mechanically fluidized reactor system, for production of silicon is described. The system is obviating the requirement for a fluidizing gas stream due to mechanical suspension or fluidization by repetitive momentum transfer using oscillations.

Further details concerning a fluidized-bed reactor can be found in the article by Arjen P. Didden et al.: "Fluidized-bed atomic layer deposition reactor for the synthesis of core-shell nanoparticles", published in Review of Scientific Instruments, Vol. 58, No. 1, 31.01.2014, p. 013905.

Some aspects of decoration of so called nanostructured particles having platinum e. g. on a TlO₂ surface are described in the article by Aristeidis Goulas et al.: "Scalable Production of Nanostructured Particles using Atomic Layer Deposition", published in KONA Powder and Particle Journal, Vol. 31, No. 0, 01.01.2014, p. 234 to 246.

The article by Gordon R. G. et al.: "A kinetic model for step coverage by atomic layer deposition in narrow holes or trenches", published in Chemical Vapor Deposition, Vol. 9, No. 2, 20.03.2003, tries to provide a numerical model for kinetic aspects for diffusion of precursor molecules. The model concerns atomic layer deposition of atoms to be released from the molecules and takes diffusion in holes into consideration, aiming for uniform coatings.

Longrie Delphine et al.: "Reactor concepts for atomic layer deposition on agitated particles: A review", published in the Journal of Vacuum Science and Technology: Part A, Vol. 32, No. 1, 28.02.2014, p. 010802-1-13 investigates reactors for atomic layer deposition using using static or dynamic particles.

Details of a fluidized bed reactor for catalyst production using decomposition of a pre-cursor molecule by oxidation in order to provide metal on a solid material catalyst surface is described in EP 13 155 174.9 (applicant: Directa Plus S.p.A., filing date: February 14^{th}, 2013), published later as EP 2 767 337 A1 on August 20, 2014, and in PCT/EP2014/05905 (applicant: Directa Plus S.p.A., filing date: February 14^{th}, 2014), published later as WO 2014/125 068 A1 on August 21, 2014.

All cited prior art documents are incorporated by reference in this document, which means that the content of the cited documents may be considered to be incorporated by their subject matter. This is done with the objective to avoid re-defining generally known terms of the present invention newly although known by persons skilled in the art. The cited documents inter alia serve as basis for definitions used herein unless a different meaning is given by the present specification.

### Difficulties known from prior art and approach to the problems

There is a general demand by the chemical industry or by industries providing raw materials or fuels for simple production methods that can provide catalysts with good activity. Catalysts, which improve productivity over unwanted by-products, are of particular interest. Since some technological obstacles may not be overcome too soon by tuning material properties, more emphasis is put on ease of manufacturing and cost efficiency for improvements of catalysts in industrial production. On the other hand, catalysis may depend on structural properties of catalysts. Therefore, it is one objective of the present invention to improve control over catalyst material production. Another objective of the present invention is the formation of a high density of catalytically active sites and thus the production of efficient metal catalyst materials. Furthermore the production is supposed to be environmentally friendly or at least ecologically acceptable, e. g. in terms of consumption of energy and consumption of rare materials.

### Description of the invention

The difficulties known from prior art and further problems can be overcome at least to some extent by using the inventive production process according to claim 1 for producing solid catalyst material. Furthermore, some difficulties are rooted in aspects of an apparatus, in which solid catalyst material is produced, especially in accordance with claim 1. The inventive use of an apparatus of claim 15 enables overcoming such problems. Catalyst material can be produced based on this invention, which may be used for improved yield from various reaction processes and applications.

Solid catalyst materials are primarily used for heterogeneous catalysis. Catalysed reactions can be gas-phase reactions or reactions in liquids, whereas the catalyst is solid. A basic material for the catalyst is a solid material. In a production process for producing the solid catalyst material, a solid material is activated for specific catalytic reactions by means of a number of process steps, like adding metal. Process steps are preferably carried out in gas-solid phase interaction. It is advantageous to carry out process steps while keeping the reaction materials, like solid material and catalyst, in a gas-solid phase. A change of phase requires intermediate steps e. g. for drying, which can take several hours time and thus slow down production. Since catalyst activity depends on a surface area exposed to reactants, the solid material has preferably a rough surface. The solid material can be perforated.

Solid catalyst materials can be particularly effective, when the materials have a shell structure. In a shell structure, an area of solid catalyst material is adjacent to an area of solid material. The terms shell, shell structure or shell-like structure are synonym and refer by one aspect to a structure established in a three-dimensional body. A skin-like layer built-up around a three-dimensional body, like a thin film enclosing the three-dimensional body on the outside, is not understood by the term shell. In other words, a shell structure has a thickness and throughout the thickness, the solid material exists side by side with metal forming the metal catalyst material. Especially any volume element of the shell structure, which is larger than a metal atom or a metal particle of the solid catalyst material, like a cubic-nanometre, and which comprises metal from metal complex, therefore also comprises solid material. The shell may also be named a sphere of a solid body. The term "shell structured" may refer also to the aspect that the shell comprises actually structured matter in contrast to dense matter. The solid catalyst material can be split into at least two parts, especially for measuring a cross section or for distinguishing different sections within a cross-section. A first part can comprise a first solid material. A second part can comprise a second solid material, which can have different or more efficient catalytic properties as compared to the first part. By another aspect, the first part, e. g. of a pellet, can be solid catalyst material. The second part can be solid material, also. A first section can provide catalytic activity by being activated, especially by means of an added metal. A second section can be catalytically passive, in particular for a reaction catalysed within the first section. In one configuration, the solid catalyst material can form an enclosure around a solid material. In another configuration, a solid catalyst material can have a core of pristine solid material. Other possible configurations have an outer layer of a catalyst material, being shell-like, that catalyses e. g. a polymerization reaction and an inner layer of solid material or of a second catalyst material that catalyses a different second reaction, like a polymerization termination reaction. A shell can also be formed from the inside of a hollow cylinder, like a pipe or a tube. In such a configuration, the first, solid catalyst section is located at the inner wall of the hollow cylinder and the outer wall of the hollow cylinder belongs to another section of the solid material, which may be a second section or a second catalyst section. In particular a layer thickness can be controlled by a process according to this invention. In other words, a pre-defined ratio between a shell diameter and a core diameter can be produced. The ratio improves especially the specificity of catalytic activity.

At least one pore or channel of the solid material is leading from an outer surface into an inner volume of the material. The pore reaches in one dimension by at least a factor of 10 further than in a second dimension. Several of such pores or cavities, generally the pores or the cavities, can also be named voids. Even larger surfaces can be achieved by using a sponge-like solid material. The solid material can have a multiwall structure, reminiscent of a cross-section of a Russian doll, with walls comprising cavities or pores. A structure comprising interspaces between walls facilitates penetration of the solid material by gas. A plurality of pores can traverse the solid material in at least one direction. The pores or also the channels can have branches. At least one pore, preferably more than one pore, can have second orifices through which gases can enter or leave. Pores are often cylindric due to crystalline arrangements. There are also pores with circular, elliptic or other cross-sections, which can be useful. A gas can enter at least one pore or at least one cavity through at least one orifice. Within the pore or within a channel the gas spreads out by diffusion. Gas diffuses through the pore or cavity. However, diffusing gas also interacts with the wall of a pore or a cavity, in particular by collision, especially by transfer of energy or transfer of momentum. Therefore, as an alternative, solid material can be used in the production process, which has a surface that is enlarged by at least one cavity. The cavity is preferably located in the inner volume of the solid material and has an opening, through which gas from an outside atmosphere, a gas reservoir or a gas source can enter into the cavity. The cavity can be spherical, like a bubble or a group of bubbles. Solid materials having a network of interconnected cavities are particularly useful because the surface to volume ratio is larger compared to such ratio of solid material of the same mass that has no pores or cavities. Gas can penetrate solid material from one cavity to another cavity. The pores can be aligned throughout the volume of the solid material. Cavities can be ordered, like in a chain, from one side of a solid material to a second side of the solid material. However, disordered meso-structures may be preferred in some applications, in particular when ordered structures cannot be obtained, or come with other disadvantages. Also disordered structures can provide good catalytic activity. Ordered pores or cavities may provide larger surface area, especially when pores or cavities with a first diameter are combined with pores or cavities of a second diameter e. g. in a lattice-like configuration. A high density of pores, alternatively or additionally a high density of cavities in a solid material corresponds to a large surface area and to a low unit weight. The floating behaviour of a solid material can also be improved by having a large internal surface area.

The solid material can be a layered structure, e. g. having an outer, shell-like structure, which can also be named a shell, and an inner structure, which in resemblance of the structure of an egg, can be named egg-shell, membrane, egg-white, or yolk, respectively. The inner structure, however, is preferably also porous, comprising channels. Diameters of pores or channels of the inner structure can be narrower than diameters of pores or channels of the outer structure, like the shell or the membrane. Other solid materials used, in particular solid catalyst materials, can have a shell with pores or channels of smaller diameter than the diameter of pores or channels of the inner structure or core, especially in respect of average diameters. Within such a structure, diffusion of metal bearing molecules or catalytically synthesized molecules can be improved, especially in a pre-defined direction. The inner structure is located in a second section of the solid material. The outer structure is located at the first section of a solid material. Gas, which penetrates the first section, gets into the second section. The gas diffuses from an entrance of a pore or a cavity in a through-flow direction before the gas molecules arrive in the second section.

The pore or cavity can be formed in a crystallisation process, a foaming process or a templating process carried out with the solid material. Typical pores or cavities of solid materials used have one diameter of less than one micrometer. The total surface area can be even larger by using solid materials with pores or cavities of less than 50 nm (nanometre). Using pores or cavities of less than 2 nm provides an even greater surface area. An additional benefit from using such microporous solid materials is the use as a molecular sieve, since molecules, which are e. g. larger than 2 nm, cannot enter pores or cavities of the solid material thus being separated from a flow of gas into the pores. Particularly good properties in respect of solid catalyst production can be achieved with materials like zeolites having pores of less than 0.7 nm diameter. Good filter properties for particles and good transmission of gases are combined in such solid materials. The pores or cavities are preferably larger than 0.2 nm so that gaseous molecular substances, like H₂, CO, NOₓ, metal carbonyl or metal complex, can enter the solid material.

The solid material can be a mesoporous silica-based material. Natural silica-based materials that can be used as solid materials are known from frustules of diatoms or radiolarian. Typical outer diameters of such materials are 0.1 to 0.2 mm. Mesoporous materials have typical diameters of pores between 2 and 15 nm. Also macroporous materials having diameters greater than 15 nm can be used. Other types of solid materials useful for catalyst production with mesoporous structures can be based on alumina. Mesoporous materials can also comprise oxides of titanium (TiₓO_{y}), tantalum (TaₓO_{y}), niobium (NbₓO_{y}), tin (SnO_{y}) or other metals (the letters "x" and "y" indicate numbers representing stable materials of respective different combination of constituents). Amorphous silica can form the skeleton of the solid material having pores between 1.5 and 20 nm depending e. g. on the chain length of surfactants used for preparation of the silica.

Another group of materials that is often used for catalyst production are zeolites. Zeolite particles are made typically by microporous materials having pores of less than 3 nm diameter. The zeolites are often formed by elements like aluminium (Al), silicon (Si), phosphor (P) and oxygen (O), especially in controllable proportions giving a majority of elements of oxygen in comparison to elements of aluminium or silicon. Some zeolites bear additional elements like Ca (calcium), Sr (strontium) or barium (Ba). The elements like aluminium (Al), silicon (Si), phosphor (P) and oxygen (O) form a framework structure for pores, which is also named host. The host can be amorphous, having a short range order with respect to diffraction experiments, or crystalline. The framework structure can also be polymorph or basically crystalline but with a degree of stacking disorder. Often zeolites also contain crystalline water. Other components of zeolites are cations like sodium (Na⁺), potassium (K⁺), calcium (Ca²⁺) or Mg²⁺ (magnesium), which can be replaced by other cations since they are rather loosely bonded to the crystalline structure. Other types of zeolites that could be used for catalyst production can have crystalline structures with anionic core and cationic periphery. Other names for zeolites are aluminum silicates or molecular sieves. On the atomic scale, pores of the zeolite are cage structures, which can be categorized e. g. by periodic atomic ring structures of Si or Al atoms. The ring structures can typically not be penetrated by molecules larger than water (H₂O). In an advantageous production process the molar ratio of SiO₂ to AlO₂ of the used zeolite is around 37.4.

The surface area of mesoporous materials can be further increased by depositing a layer of microporous materials like zeolites on the mesoporous structures. At least some of the pores can be closed on one end.

Yet another group of solid materials, which can also be used as a skeleton-type structural template of a solid material and which can be used for solid catalyst material production are metal foams (also called metallic foams). Metal foams have a cellular structure, where the walls are made of solid metal. The metal foam can be of any metal, even though foamed aluminium is frequently used. Closed cell foam has a particularly rough surface and a low weight. The available surface for catalysis is even larger, when open cell foams are used. Typically 75 % to 95 % of the volume consists of spaces that can be filled with gas. Open cell metal foams can be produced based on a skeleton material like polyurethane foam. The foams can have cavities of less than 2 mm in diameter. Cavities are preferably smaller than 0.1 mm in diameter. Metal foams can be mesoporous or macroporous materials. However, also microporous thin metallic films can be produced e. g. by electrochemical processes and be used in metal catalyst production.

Instead of using the before-named solid materials, similar effects may be achieved by using an activated carbon, a structured surface area carbon material or material comprising at least one graphene layer or carbon black as starting material, especially for building the solid material. The graphene can have a flat or a bent structure. Structured surface area material, which can be used as solid material, is a material which has a larger surface than the area of an enveloping surface of a dense package of the same chemical configuration material having the same mass, in particular under standard conditions. The structured surface area material can also be named a large or high surface area material. The term high surface area material expresses the aspect of having a stack of surfaces next to each other. Internal structures of the material can provide surfaces linked with the outer enveloping surface. Solid material comprised by only a small number of graphene layers, like one graphene layer, two graphene layers or ten graphene layers, is very attractive to be used as a solid material. An interlayer distance can support diffusion of gas, especially gas comprising a metal complex.

A small number, by other words, few graphene layers are present, if less than 10 layers, more preferably, less than 5 layers are counted. Structures comprising a few graphene layers are in general available as mixtures of particles with different numbers of layers and the term "graphene layer structure" refers to such a distribution. The distribution may comprise particles with on average five layers or 10 layers or on average 50 layers. A layer can also be named a sheet by a geometric aspect. (for a suitable production method, please refer to the teaching of EP 2 038 209 B1, which is incorporated herein).

For catalyst production, in other words the production of solid catalyst material, the solid material is exposed to a pre-cursor molecule, more precisely, pre-cursor molecules, for introducing a metal into the structures or onto the surfaces of the solid material. Diffusing gas of pre-cursor molecules can reach a penetration depth of solid material, especially before the pre-cursor molecules are physisorbed or chemisorbed by the solid material. Molecules can bond to suitable surface sites of solid material, like coordination sites. Free molecules can be scattered from surface sites without bonding. In other words, the penetration depth of molecule, like a pre-cursor molecule, inside e. g a channel of a solid material depends on the number of interactions with the surface of the solid material and the sticking probability on the surface. Adsorption is another word for sticking. By one aspect, the sticking probability depends on the polarity of the molecule. By another aspect, the sticking probability depends on the polarizability of a molecule. A pre-cursor molecule can be scattered from a surface of a solid material due to local electrostatic repulsion. For some pre-cursor molecules, the sticking probability to each other or the sticking probability to other pre-cursor molecules adsorbed on the surface of a solid material is lower than the sticking probability to the surface of the solid material. Adsorption, in particular gas adsorption can also comprise a light quantum-absorption reaction and excited atomic or molecular state formation. By this token, a pre-selected species of pre-cursor molecules can enter a pore or a cavity through a depth until a suitable sticking site is reached at the surface of the solid material. Thus clogging of the pore or the cavity, in particular at the entrance, can be avoided.

A metal complex for a production of nano-particles of metal can be a moiety like organometallic compounds, metal coordination compounds or inorganic metal bearing molecular educts. Preferably, metal carbonyls are used but other metal containing molecules and mixtures thereof can be supplied into a fluidized bed reactor through a feeder. Catalyst metal produced in the fluidized bed reactor is selectively produced from metal complex containing at least one of the following chemical elements:
niobium (Nb), zirconium (Zr), tantalum (Ta), titanium (Ti), vanadium (V), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au). Other metals can be added, e. g. as a promoter or as a stabilizing additive.

This list of usable chemical elements is not meant to exclude other metals like Lanthanides or Actinoides or other metals of the periodic table and combinations thereof not mentioned explicitly by name for production of metal nano-particles. Metal-organic compounds of at least one such metal atom with at least one NH₃ (ammine) or at least one H₂O (aqua) or at least one CO (carbonyl) or at least one NO (nitrosyl) or at least one H₂S (hydrogen sulfide) or combinations thereof are used in different preferred production processes of solid catalyst material. The metal can be provided in a metal complex, like metal carbonyl molecules. The metal can also be provided by metal organic compounds like metal bond to aromatic or aliphatic hydrocarbons. The process is particularly suited for volatile moieties being fed into a reactor vessel. Some metal-organic compounds previously described can be fed into the reactor vessel in preferred applications for the production of compound metal nano-particles. Such compound nano-particles contain a number of constituents bonded together in a matrix of metal. The metal is activated by stripping off other constituents of metal complex or metal-organic compounds. A solid material can adsorb a metal complex. The metal complex is transformed into a catalytically active surface site by an exothermic chemical reaction using a gaseous promoter of the reaction. The metal set free by fragmentation or decomposition, in particular of a metal carbonyl, binds to the solid materials. The metal can aggregate in nano-particles while decomposition of the metal complex occurs.

The concept of this process and of the apparatus can also be applied for the production of small particles preferably with nanometre-scale dimensions, which contain metal. The production is carried out on the surface of a solid material, preferably within a channel or a cavity.

Particles in general can be understood as nano-particles with an average diameter on the scale of 1 nanometre (nm) to 1000 nm. Occasionally nano-particles are defined in the scientific community as particles with less than 100 nm diameter. In some preferred applications, the scale for nano-particles relates to sub-nanometre dimensions in the range from typical atomic dimensions to a diameter of 0.7 nm. Such particles can also be named cluster or islands on a surface, having specific size dependent magnetic, electronic and catalytic properties e. g. due to a strong surface curvature or the density or package of atomic or molecular components. For reasons of catalytic activity, nano-particle diameters can be required in the range of 0.5 nm to 5 nm, preferably in the range 2.5 nm to 25 nm.

Such particles could be 5 nm particles of nickel. The particles can comprise metal that is at least partially oxidized. One advantage of the process and use of the apparatus of this invention is the capacity to produce metal or metal oxide that is dispersed on a solid surface on an atomic size scale. Another advantage of the present invention is a narrow size distribution of metal like nano-particles of iron in the range of less than 0.5 nm, comprising at least 50 % of the particles produced. Also when different metals or different materials are combined, control of the dispersion of the metal is possible. A narrow size distribution can be produced below 10 nm. Such metal containing deposits can be smaller than 0.2 nm and comprise e. g less than 100 atoms.
Furthermore, particles, like pellets, having a large load of metal can be separated from particles having just a small load of metal, e. g. less than 1 % of their load. Such distributions can be separated into at least one narrow size distribution of less than one hundred nanometre width, more preferably less than thirty nanometre width, most preferably less than ten nanometre width for example by using separator means like a cyclonic separator or a filter connected to the reactor. Further aspects of catalyst particle production are the crystallinity, the geometry, the surface structure or the surface roughness of solid catalyst material particles with nanometre-scale dimensions. The solid material used can have micrometre-scale dimensions, like particles of less than 1 mm diameter. Also solid material having a diameter of more than 1 mm can be used, especially when the solid material is a component, in particular a pre-formed element, of a machine or a reactor.
The metal is preferably adsorbed and bond to a structure of the solid material, which is concave in at least one direction, like a potential well, or a lens-shaped structure. The complex or compound providing the metal is selected to fit into the pore or cavity of the solid material. The metal complex or the organic compound is stable under conditions used for adsorption to the solid material. The metal complex or metal organic compound can be vaporized, especially for being mixed or diluted with a carrier gas, preferably without chemical reactions that are setting free the metal. During exposure to the solid material, the metal complex or the metal organic compound enters the pore or cavity of the solid material. An adsorption of metal complex inside the structure of the solid material is one aspect of an impregnation of the solid material with the metal. Another name for this process is infusion. However, the process of this invention is a gas-phase or vapour-phase process and therefore clearly distinguished from a liquid-phase process. One disadvantage of a liquid phase process is the time-consuming removal of excess liquid.
In the production process, the metal complex is adsorbed on the surface of the solid material.

Adsorption is particularly efficient in the pore or the cavity of the solid material, since after entering these structures, the metal complex can have a plurality of subsequent interactions with the surface. The metal complex is trapped inside the structure and unable to escape in at least two spatial directions. The adsorption to the surface can be chemisorption or physisorption depending on the strength of attractive interaction that is established between the metal complex, which is the first pre-cursor molecule, and the solid material. The first pre-cursor molecule can be transformed, e. g. by oxidation, to a second pre-cursor molecule that has a higher sticking coefficient than the first pre-cursor molecule. Therefore the second pre-cursor molecule has a smaller diffusion depth within a channel of a solid material as compared to the first pre-cursor molecule. A layer thickness of a shell structured catalyst material can be better controlled, when chemical, reactive decomposition is applied. In contrast, using thermal effects, e. g. by heating the solid material, can enhance diffusion along a channel in a solid material.

It is yet another advantage of the present invention, that adsorption of the metal complex can be carried out for a controllable depth or length through a layer thickness of a solid material along the pores or cavities. Therefore a first section or a first length of a pore or cavity, like a section adjacent to an enveloping or outer surface of a solid material is exposed to metal complex, and a second section, namely an inner section of this pore or cavity that is located at a distance of the enveloping or outer surface of the solid material is not reached by metal complex. Adsorption of metal complex can only take place where the solid material is exposed to metal complex. Surface contact of metal complex with solid material can be established for a controlled depth of the solid material. A radial dimension of the first section toward an inner, second section of the solid material, which can also be named the catalytically active section, can be less than 1 mm, more preferable less than 0.1 mm, or even less than 50 µm. Control can be carried out by a choice of parameters used for impregnation of solid material with metal complex, e. g. by setting a fixed exposure time and regulating a predetermined temperature of the solid material. A catalyst produced by means of this control has a three dimensional activity part, which is limited in at least two directions, like a radial direction within the solid material and a normal direction, especially in respect to an enveloping surface. Such a catalyst material is limited in a second direction by the enveloping surface of the solid material. The enveloping surface is a surface that is closely following the macroscopic shape of the solid material or particle, like a shrink wrap membrane, a skin or an eggshell, without entering into pores or cavities. The first direction, which can be named the radial direction, is a direction of diffusion of gas or vapour, like metal complex or oxidizing gas, within the solid material.

The catalyst can support reactions where concentration of at least a first reactant, like CO, and a second reactant, like H₂, is sufficient by diffusion inside the pore or cavity. Synthesis of unwanted molecular species, by an educt concentration gradient along the pore or cavity is suppressed within the chemical reaction equilibrium. This process can e. g. lead to carbon chain termination with excess hydrogen and thus to an unwanted production of short hydrocarbons, like CH₄, when liquid hydrocarbons are demanded.

Another step of the catalyst production method is a decomposition of the adsorbed metal complex. The metal complex is activated by interaction with a means of oxidation like an oxidizing gas. The interaction of oxidizing gas molecules with metal complex is preferably exothermic leading to a chemical reaction. With the chemical reaction, at least partial liberation of the metal provided with the metal complex occurs. The metal complex is oxidized by the oxidizing gas. Where the metal complex is oxidized, at least one ligand of the metal complex can be replaced by oxidizing gas. The oxidizing gas can be air, especially because of availability. Also pure oxygen can be used as oxidizing gas. Other oxidizing gases can be halogen or ammonia, depending on the metal complex. Further aspects for a choice of oxidizing gas or a choice of conditions of providing the oxidizing gas can be the limitation of the amount of thermal energy or kinetic energy released by the oxidation reaction. The choice of oxidizing gas may affect the type or the quality of catalyst produced. In some cases it is advantageous when the oxidizing gas is diluted by a first carrier gas. A first carrier gas can be mixed with an oxidizing gas, having e. g. a partial pressure of less than 10 %, preferably less than 1 % of oxidizing gas in a carrier gas pressure. The carrier gas can also enter the pore or the cavity of the solid substrate. The carrier gas may in some cases provide activation energy to bring about or to facilitate reaction between oxidizing gas and metal complex. However, the oxidation of the moiety is preferably carried out without supply of any additional energy from a source of energy, like a radiating source of energy. In particular, the decomposition of the moiety is achieved without supply of photonic energy, like light in the ultraviolet, visible or infrared spectrum. In other words, the oxidizing gas can decompose the moiety in the dark, in the absence of any light, which can also be named a dark-reaction, in particular in the presence of daylight or room lighting. Decomposition of the moiety can especially be carried out without energy from a source of heat, like a radiator means. Therefore the process can be most energy efficient in a range of room temperatures, like temperatures between 0 °C and 40 °C, in particular for the operation of the reactor of the apparatus.

The first section and the second section of the solid material are connected with each other. Gas or vapour can be fed into solid material having pores or cavities or channels, especially through an opening of the first section. The opening of the first section is accessible by Gas or vapour fed into the reactor. The opening can also be named the entrance into the pore, cavity, or channel. Gas can flow through the first section into the second section. By one aspect, the flow can be brought about by a diffusion process. By another aspect, a section can comprise a first and a second cross-section or a first and a second diameter. Gas can also flow through the second section, provided that the molecules of the gas can arrive at or enter into the second section, in particular after passing through the opening of the first section. The gas can be gas or vapour used for adsorption or gas used for oxidation. The gas can also be a carrier gas. The gas flow into the second section can be hindered by a size of a pore or a length of a channel, in particular of the first section. In other words, through-flow of the first section can be terminated by limiting the period of time in which gas or vapour is provided. A second section adjacent to a first section stays as solid material that is free of metal complex, in particular free of surface adsorbed metal complex. The first section is connected to the second section so that a structural continuation exists. Exposure of solid material to gas or vapour can be ended after a given exposure time, e. g. by closing a feeding valve. In due course, interaction of gas or vapour with the surface of solid material, like adsorption of gas or vapour at the solid material or adsorption of oxidizing gas on the metal complex adsorbate, or interaction of oxidizing gas with metal complex will come to an end. Adsorption of gas or vapour can be terminated after an exposure time, which can be named adsorption time, by removing excess gas or vapour through evacuation or purging of the solid material. The second section of the solid material remains without metal complex or without oxidizing gas, respective of the concluded process step, in particular with the end of availability of free gas or vapour. When the process step is oxidation, the decomposition time is preferably controlled. After the decomposition time, excess metal moiety can be removed e. g. by providing energy to overcome adsorption. Therefore no metal from metal complex, at least no metal from a first metal complex, is formed in the second section. The second section stays free of at least metal atoms or metal particles or metal oxide provided by decomposition of a first metal complex. A first metal complex is not decomposed in the second section, in particular due to absence of the first metal complex or due to absence of oxidizing gas or any decomposition condition suitable for decomposition of the first metal complex in the second section. The exposure time with oxidizing gas can also be named oxidation time or decomposition time. Control of time means by one aspect that a starting point in time and an end point in time is set. The starting point may be anteceded and the end point may be followed by a process step of the same kind, like a step of adsorption or a step of decomposition. An anteceding step or a following step may be a step of purging, e. g. by inert gas or by reducing gas like hydrogen. Steps can be used for a pre-defined number of times, interrupted by steps of a different kind. Preferably an initial step is a step of adsorption and a final step is a step of decomposition. By this token, a spatial dimension, like a thickness, of a shell comprising added metal can be controlled.

After oxidation of the metal complex, the metal can bind to a surface, preferably an inner surface of the solid material. Since a diameter of the metal complex and a diameter of the carrier gas species are smaller than the opening of the pore or cavity of the solid material, the first metal complex entering the pore or cavity is not blocking the entrance for additional metal complex. Decomposition products, like carbondioxide, can escape. A plurality of metal complex or metal organic compound molecules or particles can enter a pore or a cavity. A first metal atom can be bond to a first site in the pore and a second atom can be bond to a second site in the pore. The first site and the second site are located along the pore. At least a part of the surface, which confines the pore or the cavity, will be covered with metal. The metal can form a chemical bond, which prevents the metal from being released off the surface under room temperature or at the adsorption temperature. The metal remains on the surface, preferably attached to an adsorption site, especially at temperatures below 400 °C. Some of the structures of the solid material can be energetically preferred sites for binding metal. At least some of the surface structures bind metal, when the method for producing the catalyst is applied. These structures are delimiting the pore or the cavity. Since a plurality of surface structures is available, metal can be bound at a plurality of sites, preferably single adsorption sites for a metal complex, thus being dispersed. A surface site or surface structure can be a lattice configuration of a zeolite. Typically a monomeric species of metal, meaning a metal atom or a metal oxide molecule, is bonded with the surface. One surface structure can also bind two species of metal atoms or metal oxide forming a dimeric species of metal. The metal is often bond to the oxidizing gas; however some metals may also bind to the surface of the solid material as atoms. The monomeric species or dimeric species bonded to the surface site can also aggregate into oligomers or even larger clusters, which are named nano-particles of metal, e. g. by binding additional metal complexes and oxidation of these complexes, especially by interaction with oxygen. However, since oxidation is often exothermic, there is a good probability that the energy released by oxidation of a metal complex will overcome desorption energy of second metal complex molecules attached to the site e. g. by physisorption. The number of metal atoms at one specific site of the surface can scale down automatically and thus dispersion of metal is improved. The metal or metal oxide bonded to the solid surface is preferably forming a bi-functionalized catalyst surface. The metal bonded to the surface can also be used as precursor for formation of catalytically active structures, which can be activated in a subsequent process step by chemical reaction like reduction or oxidation.

The bi-functional catalyst comprises a Lewis acid, namely an electron pair acceptor and a Lewis base that is a donor of a pair of electrons. The Lewis base is capable of forming a Lewis adduct together with an added Lewis acid. Lewis bases are particularly useful to modify the activity and selectivity of metal, especially transition metal, catalysts.

The solid catalyst material is produced in an apparatus comprising a reactor, like a fluidized bed reactor, for solid particles. A special design of this reactor has been developed for production of solid catalyst materials comprising metal from volatile moieties, like metal complex. The reactor is suitable for solid particles. This can be achieved by taking into account the weight and/or the dimensions of the solid particles, and especially the likeness of movement of the solid particles during the process. The apparatus is particularly useful for producing catalyst materials with a large surface. The surface area is in particular larger than the surface area of a geometric body of the same size, at least by a factor of 1.5, due to pores or cavities in the solid material. The content of catalyst metal in a solid catalyst material can be improved by increasing the dispersion of the metal throughout the material.

Especially useful are solid particles that are metallic materials or materials with semiconductor properties. Solid particles can be materials which isolate electric current or materials which support electric current. There are non-metallic materials that may be used for forming the solid particles, additionally or alternatively to the metallic materials or the materials with semiconductor properties. The geometric form of the particles is in general maintained through the production process. The particles can be spherical or elongated particles with a cigar shape. The particles can be pellets or beads. They may also have a three dimensional structure by themselves, like a hollow structure, or a thin wall- or layer-structure. The particles can also resemble or be derived from basic geometric configurations like cylinder, cone, pyramid, cube, prism, torus, polyedric body, knot-type or entangled body or similarly shaped structures. Also a cavity can have such a shape. One preferred structure used is a geometric body derived from a hollow cylindric structure. The cross-section of the hollow structure can be elliptic, parabolic or hyperbolic, providing a volume that is accessible by gas. Another preferred structure is a particle having one of the described geometric outer forms or a form that is derived from an accumulation of such structures having interstices or interspaces, which are accessible by gas or vapour due to interconnections by gaps or channels between the solid components. Such an object can have a dimension of more than 1 mm or more than 10 cm. The objects are preferably formed before being fed into the reactor.

The reactor comprises at least one reactor vessel. A fluid can be passed through the reactor vessel so that the solid material in the reactor vessel is exposed to the fluid. Preferably, the fluid is a gaseous material. In those circumstances, the fluidized bed reactor can also be named a gas bed reactor. When the process is carried out in a fluidized bed reactor, the fluid may comprise a gas and droplets of a liquid or a vapour. In a fluidized bed, a solid particle or object is at least partially carried by a flow of a fluid against a force like gravity. Fluidization is used in order to improve exposure of the particles to the fluid. The dynamical behaviour of the particles within the reactor vessel is rather complex and still not completely understood. Particle movements by the flow of the fluid depend largely on the specific type of particles and properties like mass, density or shape. Fluidization can also be achieved or at least improved by applying centrifugal, electric or magnetic forces to the solid material.

An alternative is a through-flow reactor, which can be used within the apparatus for production of shell structured solid catalyst material, like a cross flow reactor. A cross flow reactor comprises at least one, preferably two reactor vessels. A cross flow reactor is by one aspect a through-flow reactor, through which a solid material can pass e. g. in a flow. Across the reactor vessel the solid material is exposed to a fluid, which can be a fluid, like a gas, comprising metal complex or a fluid, like an oxidizing gas, comprising oxidizing molecules or the like. In a preferred cross flow configuration, the flow of fluid through the reactor vessel has a different direction as compared to the flow of solid material. The directions are enclosing an angle. The angle can be 180°. In another configuration of the apparatus, the angle can be 90°. The concept of this invention also includes intermediate angles. Angles of flow directions are provided e. g. by a configuration of feeders providing a flow into the reactor vessel. The flow leaves the reactor vessel e. g. through an exit tube, which limits the angle of flow direction by one aspect. It can be said that in a cross flow reactor, the exposure time is specified by a length of the reactor vessel and a velocity of the solid material or a velocity of a cross-section of a fluid that passes over the solid material. By another aspect exposure time is the period of time for which solid material prevails within an environment of a fluid, like the time interval from the instant of time, when the fluid enters the reactor vessel, e. g. of a fluidized bed reactor, to the instant of time when the fluid has left the reactor vessel.

One feeder of the apparatus is a fluid feeder, like a gas feeder. A second feeder can be a solid particle feeder. A solid particle feeder can comprise a volume measuring device for entering a specified volume of solid particles into a reactor vessel. A solid particle feeder can be designed to pass a flow of solid particles through a reactor vessel. By one aspect, the apparatus can be configured such that it is usable for production of shell structured catalysts. The reactor vessel provides a reactor volume between a fluid feeder and at least one fluid exit conduit, which is preferably located flow-downward of the fluid feeder.

The apparatus comprises a process control unit. The process control unit comprises a timer, like a programmable clock, which signals the process control unit e. g. when a specified number of seconds, minutes or hours have passed. The process control unit can operate the apparatus e. g. such that the apparatus can control a process step of adsorption and a process step of decomposition of metal complex. The process control unit can also comprise a counter. By means of a counter, a pre-set number of process steps can be specified, and the process is ended automatically, when a process step has been repeated for the number of times specified e. g. through an input terminal of the process control unit. The input terminal allows adjustment of process parameters like the time for which a process step is run. The controller together with the counter can operate at least one valve, preferably two valves of the apparatus. Depending on respective process step, a first controller valve permits metal moiety into the reactor vessel; a second controller valve permits oxidizing fluid into the reactor vessel. A third controller valve can permit solid material particles into the reactor vessel. At least one valve can be a proportional valve. The two valves used for gas are preferably alternatively open towards the reactor in a production process. When one valve, like the first controller valve, is open towards the reactor, a second valve, like the second controller valve, can be shutting off towards the reactor. A controller valve is operated by a process control unit.

The solid particles can also be deposited into the reactor vessel through a port or a filler opening, which is preferably closable by a flange or a lid in order to retain the particles or the fluid inside the fluidized bed reactor. The lid can be operated by a process control unit like a controller valve. In other words, the lid, preferably comprising a sealing for gas, can be a controller valve. The flange or the lid may comprise openings allowing a gas flow into or out of the reactor. The flange can also be a gas distributor for directing gas flow into the reactor vessel.

The apparatus can comprise at least one fluid feeding filter. A first fluid feeding filter can be located on one end of the reactor vessel. The fluid feeding filter limits a first end of the reactor vessel by providing a border between an inner volume of the reactor vessel and an outer volume enclosed by a wall of the apparatus.

The reactor vessel may be connected to a fluid distribution system, like a mixing stage, by at least one conduit, which can also be named a fluid supply-line.

The apparatus comprises at least one through-flow fluid heat exchanger. The fluid supply-line passes through the through-flow heat exchanger. The through-flow heat exchanger adjusts the temperature of a fluid flowing through. A heat conductive connection to a sink of heat or a source of heat, which can be a Peletier element, is provided for a fluid supply line. The fluid supply line can pass a fluid from a source of the fluid, like a gas source or a metal complex vapour source, into the reactor. It can also be said that the fluid supply line is connectable by a control valve to at least one fluid feeder, which is open towards the inner volume of at least one reactor. A through-flow heat exchanger can be a through-flow heater in order to establish a fluid temperature above room temperature. A through-flow heat exchanger can be a through-flow cooler in order to establish a fluid temperature below room temperature. The through-flow heat exchanger can be operated by means of a controlled flow of a heating liquid. By another aspect, the through-flow heat exchanger can be operated through a controlled flow of a cooling liquid, like a low viscosity oil. In a preferred configuration of an apparatus, the fluid supply line for metal complex is in contact with a first through-flow fluid heat exchanger and the fluid supply line for oxidizing fluid is in contact with a second through-flow fluid heat exchanger, providing independent temperatures. The temperature of the fluid in the first fluid supply-line can be controlled independent from the temperature of the second fluid supply-line. The temperature of the fluid in the second fluid supply-line can be controlled independent from the temperature of the first fluid supply-line. This improved temperature control provides better control over distribution of catalyst metal in the shell of a shell structured metal catalyst. Control can be improved in a process step of adsorption. By another aspect control can be improved in a process step of decomposition of metal complex. It can also be said that the design of the reactor provides at least a two step control over the thickness of a shell in a shell structured solid catalyst material.

At least one fluid feeder is connectable to at least one fluid supply-line. At least one fluid feeder is connected to at least one reactor vessel of the apparatus. The connection is provided through a controller valve e. g. a first controller valve connecting a first supply line, like a supply line for metal complex, and a second controller valve connecting a second supply line, like a supply line for oxidizing fluid or gas. At least one controller valve is located in a fluid supply-line flow downward from a through-flow fluid heat exchanger. The controller valve is preferably a three port valve. One port of the controller valve is connected to the reactor vessel. A second port is connected to a fluid supply-line. A third port is connected to a conduit. The conduit can comprise a temperature sensor, especially for measuring the temperature of the conduit. The temperature sensor provides a temperature measurement, which is available in the process control unit. It can also be said that the third port of the first controller valve can be connected to the conduit connecting the first port, namely the metal complex supply-line. By another aspect, the third port of the second controller valve can be connected with the first port, namely the oxidizing fluid supply-line. Since the third port is connected to a conduit, which is not opening into the reactor vessel, which can be named a first reactor vessel, the flow of fluid through the third port by-passes the first reactor vessel. The flow of fluid from the first or the second controller valve can enter a second reactor vessel through a by-pass line. The by-pass lines for oxidizing fluid or gas and for metal complex fluid or gas can also be named thermalizing by-pass lines, respectively. A thermalizing by-pass line maintains a temperature of a fluid supply line by allowing a steady flow of fluid, like gas or vapour, through the respective supply line. The flow of fluid through the thermalizing by-pass line can be directed towards an exhaust or towards a scrubber for safety or for highest purity requirement, or towards a collecting vessel for recycling, e. g. through a pump supplying the feed-line. Preferably the flow is directed towards a second reactor vessel for better efficiency. The configuration of an apparatus with at least one supply line has the advantage that temperature of gas entering the reactor vessel, in particular the first reactor vessel, can be better controlled. Gas flowing through the first supply line can have a different temperature as compared to gas flowing through the second supply line. Without maintaining a flow of fluid, temperature along the supply line can approach room temperature. Without flow of fluid, the fluid temperature inside the supply line approaches room temperature, possibly with delay due to thermal isolation. When a first or a second control valve opens a respective flow of fluid into a reactor vessel, the fluid may have different temperature as compared to the temperature set for the through-flow fluid heat exchanger. It can be said that temperature of fluid inside the reactor vessel can depend on the heat capacity of conduit of the fluid supply line and on the opening time of the respective control valve directing gas flow towards the reactor vessel, which, by one aspect, can be named exposure time. Fluid temperature inside the reactor can reach a specified temperature within a fraction of the exposure time when the thermalizing by-pass line is used. Therefore one, especially two, thermalizing by-pass line(s) further improves control over adsorption step and control over decomposition step of a production process.

The controller valve is operable in at least one supply line. In a pre-set time interval set through the process control unit, the first controller valve permits flow of metal complex into the reactor vessel. This state of the apparatus can be named the adsorption state. In the same time, the second controller valve can permit flow of oxidizing fluid into a thermalizing by-pass line, like a second thermalizing by-pass line. Such a time interval is approximately the exposure time for metal complex. On the other hand, a time interval for exposure to oxidizing fluid can be pre-set in the process control unit. When the time of exposure to metal complex is completed, the apparatus can enter the decomposition state. The first controller valve can switch over the flow of metal complex into a thermalizing by-pass line like a second thermalizing by-pass line. In the same time, the second controller valve can switch the flow of oxidizing fluid from the fluid supply-line to the reactor vessel, which is the decomposition state of the apparatus. The respective fluid supply-line is therefore thermalized for the pre-set period of time. This time interval is controlled through a timer of the process control unit. The timer is set to control an exposure time for providing a fluid into the reactor vessel. The thermalization time-interval is started in coherence with the temporal initiation of the exposure time. In other words, a time delay between the beginning of the thermalization of the fluid supply line and the exposure time for fluid inside the reactor vessel is possible within temporal coherence, e. g. in order to optimize fluid consumption through thermalization. Having such adsorption state and decomposition state of an apparatus provides more constant flow conditions for flow into a reactor vessel and therefore improves production of shell structured catalysts by yet another aspect.

The process control unit has an advantageous design if at least several, preferably many, exposure times are saved in an, preferably internal, memory of the process control unit. An operator of the apparatus may pick from a recommendation of exposure times a suitable value in coherence with the solid particle, already placed or to be placed in the reactor.

Additional states, like a purging state for flow of inert gas, can be added at the end of each respective step of adsorption or decomposition. In purging state inert fluid, like a noble gas, or in passivation state a passivation fluid, like hydrogen gas or water vapour is supplied into the reactor vessel, e. g. through an inert gas supply-line or a passivation gas supply-line respectively, comprising an optional purging control valve. Decomposition of metal complex in unwanted areas can at least be partially suppressed due to purging. Adding a passivation state can suppress decomposition of metal complex in unwanted areas even further.

From decomposition state, the process control unit can switch the apparatus directly into adsorption state for a pre-set time interval. From a second adsorption state, the process control unit can switch the apparatus to a second decomposition state. The steps, also including purging and passivation, can be repeated for a number of times and each time for a pre-set time-interval. A concentration of metal can be built up in a programmed sequence of process steps for a production time. The concentration can be a function of penetration depth of fluid, like metal complex or oxidizing fluid thus forming a shell structured solid catalyst material.

In a reactor comprising a gas feeding filter, only one side of the gas feeding filter, the side facing the inner volume of the reactor, is exposed to solid material or solid catalyst particles.

A gas feeding filter is retaining the solid particles in the reactor vessel. Gas can penetrate the gas feeding filter from a first side, which is connected to a gas source, to a second side, which can support the solid particles. The apparatus can comprise a second gas feeding filter, which can be used for feeding a second gas into the reactor vessel. For producing well kept solid catalyst material, the gas comprises a metal complex and preferably an inert gas, which is also named carrier gas.

A fluid in the form of gas can be provided through at least one gas mixing stage connected to the fluid supply line of the apparatus. A very suitable place to locate the gas mixing stage is outside the reactor vessel. The gas mixing stage can dilute a first gas with a first partial pressure by a second gas with a second partial pressure. A gas mixing stage can also be used to accommodate vapour in a carrier gas. A method to generate vapour is by heating a liquid or a solid. Vapour can also be generated by expanding a liquid from a first space having a first pressure into a second space having a pressure that is lower than the pressure of the first space, especially in combination with a heating device. Vaporisation of liquid metal complex can at least be facilitated by a transition of a diameter of a conduit or a pore to a larger diameter. The gas mixing stage is operatively connected to at least one fluid supply line. A gas mixture can be provided to the gas feed from a gas mixing stage through a conduit or a tube and enter the reactor vessel. The controlled mixture of gas is fed into the reactor. The components of the gas are controlled in the gas mixing stage. The gas mixing stage can provide controlled mixture of a carrier gas with a metal complex. The gas mixing stage can also provide a controlled mixture of a metal complex. Furthermore, a gas mixing stage can provide a mixture of a carrier gas with another gas like an oxidizing gas, which can also be named the oxidizing gas. The carrier gas is typically an inert gas like a noble gas, nitrogen or carbon dioxide. A gas source for carrier gas is e. g. a gas cylinder with a regulator or a gas circulation system. Also oxidizing gas is provided from a gas source. The oxidizing gas can comprise air. Dried air can be used, if a reaction of metal complex with water may not occur. The oxidizing gas can comprise a first oxidizing gas and a second oxidizing gas like mixtures of halogen and oxygen. The gas mixture and/or the vapour mixture in carrier gas can enter the reactor, like a fluidized bed reactor, by being fed into the reactor vessel through a feeder.

Further advantages and benefits of the invention can be derived from the following explanations which may bare additional inventive ideas by themselves.

Adsorption and decomposition of metal complex can be repeated in a sequence, especially with a pre-set increment or a pre-set decrement of time for duration of each step. The increment of time can depend on the effect that metal coverage of solid material has on diffusion of metal complex, e. g. within a channel of the solid material. By this token, a diffusion distance can be kept constant. A thickness of a shell can be kept constant, while metal is accumulated. A repeated step of adsorption increases the amount of metal available in the first section of the solid material. The gradient of weight percentage of metal over a cross-section of a shell can be controlled. The process steps can be repeated for a pre-set number of times. A repeated process step can last for the same period of time as a previous process step, which can also be named a first process step. The duration of a repeated process step depends on a previous process step, which can be named an antecedent process step of adsorption type or an antecedent process step of decomposition type. The exposure time in a respective step can be set as provided for an antecedent step. The exposure time of a repeated step can be increased, e. g. by a given number of seconds, in order to increase a thickness of a shell. The exposure time of a second step can be shortened, e. g. by a given number of seconds, in order to control a distribution of metal within a thickness of a shell structure. The exposure time in additional process steps, especially of the same kind, like the adsorption steps, is preferably kept constant in order to achieve specified weight percentage of metal. In the case that oxidation of metal moiety occurs with a slow time constant, the step of oxidation can be carried out for a longer period of time by using e. g. a longer exposure time of solid material with oxidizing gas than with metal complex. It can also be said that the weight amount of metal attached to the surface in the first section of the solid material can be built up. An increase of metal is achievable through at least one additional process step, in particular with a controlled exposure time for applying a gas to a solid material. The process step preferably comprises adsorption of metal complex. The metal complex can comprise the same metal, like a first metal, or comprise a second metal or a combination thereof. A second process step can be decomposition of metal complex. Decomposition of metal complex can be achieved in a second step by different means, like application of light or heat, but preferably metal complex is decomposed by oxidation reaction with an oxidizing gas. Decomposition by oxidation is particularly energy and time efficient. Therefore exposure time in a second process step can have the same length of a time interval like a preceding step. The second metal used in a second adsorption step can be a promoter metal. In other words, a first process step can alternate with a second process step thus alternating impregnation with a first metal followed by a second metal, which can be repeated for a pre-defined number of times.

The first section of a solid catalyst material can be produced with a thickness that is an average diameter of the first section. The thickness can be controlled by the exposure time to a fluid, in particular a gas. The gas can be a gas comprising metal complex or a gas comprising the oxidizing gas. Furthermore, the thickness can be controlled by providing solid material having a pre-selected pore diameter or a pre-selected cavity diameter. By one aspect, the diameter is an average diameter. The diameter can be a bimodal diameter with a diameter distribution showing a maximum for the presence of a first diameter and a second maximum for the presence of a second diameter. The pore, cavity or channel with the first diameter can have a preferred direction in parallel compared to an outer surface of the solid material. The pore, cavity or channel with the second diameter can have a preferred direction, which is a normal direction in respect to the outer surface and therefore along the thickness of the shell. The diameter can be less than 1 micrometre. Preferably at least one of the diameters is less than 50 nanometres. Good catalysts can e. g. be obtained with an average pore diameter of less than 10 nanometres. Particularly large surface areas can be achieved with an average pore diameter between 1 nanometre and 2 nanometres.

The adsorption of metal complex on a solid material for formation of a solid catalyst material can be controlled in order to obtain a good shell structured catalyst. Control, like control of exposure time for applying a gas, can be carried out in a first process step or in a second process step for production of solid catalyst material. A time interval of providing a vapour flow can be used to build-up a specified amount of metal in a specified part of a cross-section of a solid material, like a composite material. The time interval limits the adsorption to a first section inside the solid material structure namely the shell section. The vapour flow can be a frequently interrupted flow, with intermediate time intervals used for processing of metal complex in steps e. g. by exposure to oxidizing gas. The duration of the time interval is preferably longer than the time needed for filling the reactor vessel with gas at a specified pressure. The duration of the time interval is shorter than the diffusion time of metal complex through a half diameter of the solid material. Different parameters can be adjusted or monitored in order to improve the adsorption condition in each step. A first parameter and a second parameter can be controlled simultaneously so that a good load of metal complex is adsorbed on the solid substrate surface. Adsorption is preferably achieved on inner surfaces of the solid material. Inner surfaces are surfaces which are at least partially enclosed by bulk matter of solid material. The ratio between inner surface and outer surface is preferably greater than 1. The outer surface is the surface that can at least partially be in contact with a second particle of solid material. One parameter that can be adjusted for control of adsorption is a concentration of a metal complex. The concentration is usually given as a partial pressure in a carrier gas. The concentration can also be adjusted by means of a vaporisation temperature or vapour pressure of the metal complex. Furthermore, a second metal complex can be mixed with the first metal complex. A second metal complex can be provided into a reactor simultaneously with the first metal complex, each metal complex with a predefined partial pressure. The ratio between the first metal complex and the second metal complex concentration can be adjusted. The second metal complex can also be provided with a second carrier gas. The first metal complex and the second metal complex can be mixed before entering the reactor vessel. The first metal complex and the second metal complex can also be mixed inside the reactor vessel, e. g. by sequential adsorption, at first of the first metal complex and afterwards the second metal complex in the pores or cavities of the solid material. By controlling the concentration of the metal complex, interaction between different metal complexes or interaction between different molecules of a metal complex can be minimized. Adsorption in pores and cavities is improved and possible formation of aggregates of metal complex can be impeded.

Adsorption can also be controlled by means of a gas flow preferably into a mixing stage, more preferably into a reactor vessel. Another method to provide metal complex is a flow of vapour, which can be controlled. The flow of gas or vapour can be adjusted by means of a valve or an orifice. The flow can also be adjusted by a source pressure for gas or vapour. Gas pressure inside the reactor vessel affects the rate of collisions of gas or vapour particles with solid material. Therefore, gas pressure can be increased in order to speed up adsorption. However, gas pressure may also adversely affect flow conditions of gas. Flow conditions for gas entering into pores or cavities of solid material or solid catalyst material can define an upper limit for gas pressure. Impeding the flow of gas or vapour through the solid material at high pressures, or blocking the access to the inner surfaces is preferably prevented. Vapour molecules of metal complex are typically larger than gas molecules or atoms and therefore particularly suited for control of flow conditions. The flow can be a pulsed flow or an oscillating flow. The flow can be used in order to improve mixing of solid particles in the floating bed of the reactor at a specified average flow of gas. For such purpose, a flow controller for gas can be used, preferably equipped with a pulsing device for pressure or flow of gas fed into the reactor and with an electronic counter for a number of gas pulses.

Furthermore, the temperature of a gas and/or a gas/vapour mixture can be controlled. By decreasing the temperature, the kinetic energy of particles, molecules or atoms impinging on solid material is reduced, thus increasing the sticking probability. Also the probability that molecules of metal complex are removed from the surface by momentum transfer from gas is reduced, e. g. by thermal equilibration between a carrier gas and a temperature controlled solid material. Controlling the temperature of the solid material may also improve adsorption of metal complex in pores or cavities. The temperature can be adjusted e. g. by heating the fluidized bed reactor. The temperature can also be adjusted by cooling the fluidized bed reactor. Heat from solid material inside the reactor vessel is transferred to the walls of the reactor vessel in a cooling process. Heat transfer can be radiative, conductive or both, especially prior to fluidization of the solid material. When the solid material is heated to a temperature, which is related to the vaporisation temperature of a liquid complex or the vaporisation temperature of a solid metal complex, adsorption on outer surfaces of solid material is reduced because the sticking probability of molecules to the surface is lowered. Therefore, molecules are less likely adsorbed on outer surfaces than on inner surfaces. Pores are less likely to be blocked on the outside so that adsorption on inner surfaces by metal complex diffusing into the pores is increased. The adsorption process can be stopped, when the vapour flow is interrupted. The flow of carrier gas may still continue in order to remove metal complex that is not adsorbed on surfaces of the solid material or in structures of solid material substrates and is still mobile for adsorption. The duration of the vapour flow starting from initialization of the flow of vapour and the flow of gas to the moment of interruption of the vapour flow can at least partially determine the amount of adsorbed metal complex at a location inside an open structure of a solid material. A reduced temperature shifts the adsorption equilibrium from a probability for desorption of a molecule to a probability for adsorption of a molecule on a surface. On the other hand, a higher temperature of a solid material or a metal complex, like a temperature of more than 40 °C, increases the diffusion rate and may support desorption of the metal complex from a surface. Small amount of metal complex is deposited at the entrance of a pore or cavity but less or even no metal complex is deposited at a distance of tens of microns from the entrance. Metal complex penetrates the solid material through structures, until a specified depth e. g. along the pore or cavity is reached, like a depth of 50 micrometre in a 300 micrometre diameter particle, leaving a core of 200 micrometre diameter without metal complex. Applying a temperature gradient starting with a higher temperature, like 40 °C or even more, especially for metal complex, and cooling the solid material can be useful to counterbalance the two processes of diffusion and adsorption in order to obtain a controlled diffusion depth of metal complex. Good control over the distribution of metal complex can be obtained throughout a shell-section structured with pores or cavities of solid material. By another aspect, control over metal in the first section is achieved with a cumulative duration of vapour flow. The cumulative duration is the sum over all time intervals, for which metal complex is provided in order to adsorb on solid material. In other words, the integral over the durations is the total time specified for a number of adsorption steps, which is cumulative for amassing an amount of metal through adsorption of metal complex.

Another step of the production process is a decomposition of metal complex by oxidation. The decomposition can be carried out in a second process step. By one aspect, the second process step can be preceded by a process step of the same type, namely exposure of a solid material to a gas, in particular to oxidizing gas. The process can be improved by controlling at least one parameter. Preferably a combination of parameters is controlled for a good turnover of the oxidation reaction. The oxidizing gas can be provided in a flow for a pre-set period of time of exposure. The time of exposure can be limited by duration of a flow. During the exposure to oxidizing gas, the oxidizing gas passes over adsorbed metal complex. Oxidizing gas can be adsorbed on metal complex or on the surface of the solid material. By another aspect, decomposition can be controlled by setting a time of exposure to oxidizing gas flow after a time of exposure to a metal complex flow. A time-delay between respective exposure times allows for an intermediate process step, e. g. for purging with an inert gas, for temperature control or for adsorption of a second metal complex or adsorption of a reaction promoter molecule. One parameter that affects aspects of metal complex decomposition is metal complex concentration in the solid material. Metal complex concentration can be adjusted by adsorption parameters. Furthermore, a concentration of oxidizing gas effects the reactive decomposition of metal complex. The concentration of oxidizing gas can be controlled e. g. by mixing a partial pressure of oxidizing gas with a partial pressure of inert gas. Preferably, less than 1 % of the gas used for decomposition is oxidizing gas. Development of heat by exothermal oxidation can be reduced even further by using less than 0.1 vol.-% of oxidizing gas mixed with 99 vol.-% inert gas thus forming 100 vol.-% decomposition gas. The oxidizing gas can comprise a first oxidizing gas and a second oxidizing gas thus forming a composition of gas, where the metal complex can be oxidized on one ligand by a first oxidizing gas and be oxidized on a second ligand by a second oxidizing gas. In this way, temperature released by the exothermic oxidation process can be better controlled. The rate of oxidation, another factor for generation of heat, can also be controlled with oxidizing gas flow. When the oxidizing gas flow is increased, the oxidation will proceed faster than with a lower gas flow, provided that there is still metal complex for oxidation. The oxidation rate can be diminished by diluting the oxidizing gas in a carrier gas. When the partial pressure of oxidizing gas in the carrier gas is lowered, less oxidizing gas is available for reaction with metal complex. Control over the oxidizing reaction can be obtained by another aspect when oxidizing gas is provided in a sequence of gas pulses, like a pulse train. A pre-set number of gas pulses can be fed over a solid material, in particular a solid material comprising metal complex in a shell-like section of the material. The pulse train can be offset or phase shifted by the duration of at least one pulse as compared to a pulse train of metal complex provided into the reactor vessel. Therefore, reaction may take more time but less heat is produced within a period of time.

Oxidation can also be controlled by adjusting a temperature. The oxidizing gas can be preheated to a specified gas temperature before entering the reactor vessel. Applying heat can speed-up diffusion of oxidizing gas inside pores or cavities. Oxidation can be controlled by regulating the solid catalyst material temperature before oxidation and/or during the oxidation step. When the solid catalyst material is cooled to a lower temperature, heat produced by oxidation can dissipate better. Heat from the oxidation reaction is preferably not transformed into desorption of metal complex and diffusion of metal complex out of pores and cavities. In a cooled solid material comprising metal complex, e. g. in an outer shell, metal complex will stick better to the surfaces. The thickness of the shell structure predetermined through the adsorption step is better preserved, when further diffusion is inhibited, in particular by temperature control, e. g. by keeping the solid material below room temperature, preferably below 0 °C, especially during each step of adsorption, preferably also during each step of decomposition and especially during each step of purging. Cooling the solid material can maintain metal complex below decomposition temperature. The reaction path of oxidation for decomposition of metal complex is controlled and no other metal compounds are formed. The temperature of the solid material should remain at least within 90 % of the mass of the solid material below decomposition temperature of the metal complex. Furthermore, a cumulative duration of the oxidizing gas flow, meaning the time for which oxidizing gas flow is provided over all decomposition steps, can limit oxidation reaction. Preferably the total duration of decomposition steps is long enough that no further diffusion and adsorption of metal complex inside the solid material occurs after the end of one, especially the last, decomposition step.

By measuring gaseous oxidation products, a degree of transformation of metal complex can be followed and oxidation can be terminated by stopping the gas flow after a predetermined period of time for a step of decomposition. Oxidizing gas flow can also be terminated after a predetermined amount of a reaction product gas, like carbon monoxide, is produced in one step of decomposition. Formation of the reaction product gas can be monitored quantitatively by a sensor, like a mass-spectrometer. After termination the flow of a first oxidizing gas, a second oxidizing gas flow can be fed into the reactor vessel. The second oxidizing gas flow can be fed for a pre-determined period of time. In other words, the second oxidizing gas can be provided for an exposure time. In a pre-set period of time, metal complex and solid material can be exposed to a second oxidizing gas. A second oxidizing gas flow can be used for an additional functionalization of the metal introduced with an adsorbed metal complex. Also, an additional functionalization of the solid catalyst material or the solid material in a section, which is free of metal, like a core structure, can be made using a second oxidizing gas. A second oxidizing gas could e. g. be used to widen cavities, pores or channels of a solid material in order to improve through-flow of reaction products from catalysed reactions in non-metallized sections of the solid catalyst material.

The metal complex provided into the reactor or fed into the reactor can be a metal carbonyl. The complex can comprise a transition metal like iron. Iron (Fe), nickel (Ni), cobalt (Co), copper (Cu), zinc (Zn) can be transition metals or first transition metals provided with a metal complex. The metal complex can also comprise a second metal of the same element or of a different element. A metal complex used for metallization of a section of solid material surfaces can be a metal like a precious metal, in particular platinum (Pt) or palladium (Pd). Precious or noble metals are particularly useful as catalysts, because they are less susceptible for chemical deactivation. Shell structured catalysts comprising Co, Fe, Ni, Ru or any combination thereof were found to be particularly efficient for Fischer Tropsch synthesis. A MoS₂/Al₂O₃ catalyst, which can be produced by oxidation decomposition of Mo(CO)₆ even in an outer section of an eggshell, is particularly useful for catalysis of hydrodesulfurization reactions, e. g. of liquid gasoline from fluid catalytic cracking. Through spatial limitation of catalyst within an eggshell, diffusion effects for catalysed reactions can be suppressed. Eggshell catalysts comprising noble metals, like Rh, Pt, Ru, Pd and Ir, are particularly effective also for partial oxidation of methane forming a syngas. By another aspect, e. g. Pd/Al₂O₃ shell structured catalyst is effective for catalysis of selective hydration. Another advantageous aspect of catalysis by a shell structured catalyst is the fact that temperature for specific reaction condition can be provided more accurately within a well defined thickness of shell structure. Temperature gradients due to conductance of heat into bulk particles, which may divert reaction paths, are less problematic.

An impregnation of the solid material with metal complex in a shell range and decomposition by oxidation is carried out for a specified quantity of solid material. The specified quantity can be less than 1 kg, when rare catalysts, in particular catalysts with rare metals are produced. The specified quantity is also named a batch of solid material. A batch of solid material can be less than 100 kg, in particular when catalysts for the production of basic materials like solvents, oil or plastics are produced. The solid material used has preferably gas conveying pores and/or cavities. At least a plurality of pores or cavities can guide gas through a volume element of the solid material. Gas can enter the solid material on a first side and leave the solid material on a second side. The impregnation or any other chemical processing step e. g. for pre-treatment of the solid material or for after-treatment of the solid catalyst material is performed preferably on structures of solid material. Such structures are especially along a section of the pores or cavities, like a shell. Structures in the surface of the pores, cavities and the solid material can be modified by attachment of metal. The temperature of the batch can be controlled during impregnation. Over all, the temperature is preferably kept in a room temperature range between 15 °C and 25 °C. The overall temperature, meaning the average temperature over time and space during impregnation, namely during adsorption step, can be controlled at a pre-set value of temperature or by means of a heating or cooling rate. The temperature can also be controlled during decomposition of metal complex by oxidation. The temperature can be kept below 20 °C room temperature, especially in order to improve adsorption. Desorption processes can largely be suppressed by keeping the overall temperature below 0 °C. More preferably, the temperature is kept overall below -20 °C, which may already slow down oxidation of metal complex and therefore be useful for control of heat generation. When the temperature is kept below -60 °C, the diffusion of metal complex on the solid material surface can be suppressed almost completely. By another aspect, the overall temperature can be kept above condensation temperature. Preferably, the metal complex is used under conditions above the condensation point maintaining the metal complex in gas phase. Under such conditions, gas phase diffusion is still efficient, so that pores or cavities of the solid materials can be reached by metal complex and penetrated up to a controllable depth. Adsorption of metal complex on solid material can occur in a shell-like region of the solid material. Temperature control is preferably carried out all over the cumulative duration of the production process of solid shell structured catalyst material.

In a production process like a batch production process or a continuous production process metal complex is fed in a continuous flow using e. g. the carrier gas argon. The flow of gas and especially the flow of gas comprising a metal complex enters the reactor vessel continuously at least for a pre-defined period of time, like a time of less than 1 hour. In continuous production, the time interval is preferably longer than 8 hours. The flow is preferably steady, so that no interruptions occur. The quantity of metal complex fed through a reactor can be 100 mg (milligram) per minute and per gram solid material. The flow of carrier gas can also continuously flush 30 mg metal complex per minute and per gram solid material into the reactor vessel. The solid material as basis for reference is measured or determined within the reactor vessel. When a low concentration of metal is required, the metal complex steadily fed into the reactor can be less than 30 mg per minute and per gram solid material. In particular when the catalyst metal is used as a promoter of the catalyst, 10 mg per minute and per gram solid material can be sufficient. The catalyst is e. g. a transition metal doped zeolite or a zeolite having a deposit of a catalyst metal on molecular sieve structures or on structures formed by introducing a vapour into inter-crystalline spaces of the solid material. It is also possible to up-scale the production process to quantities of more than 100 mg per minute and per gram solid material in the case of mass production of solid catalyst material, especially in a continuous production process. The continuous flow of metal complex and of solid material is preferably spatially limited by a respective flow cross-section. A crossing region of flow provides a pre-defined exposure time, like in a cross-flow. In a cross-flow configuration, a first flow, like a flow of metal complex, has a direction that has an angle with a direction of a second flow, like a flow of solid material particles. The angle can be 90°, which is a perpendicular flow. The exposure time can be of the order of one minute or less, like 10 seconds. A continuous cross-flow of metal complex and solid material can provide adsorbate in a shell section of a solid material or solid material particle. The thickness of the shell can be controlled at least to some extend by the flow velocity and the spatial intersection of flowing matter. Also oxidizing gas can be provided in a cross-flow configuration, namely by crossing a flow of oxidizing gas and a flow of solid material comprising a shell of metal complex adsorbed on inner surfaces of the solid material. In a cross-flow oxidation, metal from adsorbed metal complex can be bonded to solid material for formation of a shell-structured solid catalyst material. The flow, in particular the flow of metal complex, can also be provided continuously within an interval of time. Another variation of cross-flow can be provided by a flow of solid material particles passing through two chambers, like an adsorption chamber or a decomposition chamber. The chambers are respectively filled with metal complex vapour or metal complex gas, or, when used for a different process step, filled with an oxidizing gas for decomposition. Also a series of chambers, comprising an alternation of adsorption chamber for metal complex flow and decomposition chamber for oxidizing gas flow in sequence, like a series of 10 respective chambers, can be used, such that a flow of solid material particles passes through all chambers in sequence. By this configuration, the metal content in a shell structure can be increased step by step in the course of continuous production of solid catalyst material.

Within the reactor, the solid material is exposed to a flow of gas or vapour from at least one direction. Therefore a second direction can exist that is shadowed from the flow of metal complex. Particles in the shadow of the flow of the metal complex are not exposed to metal complex. Therefore, adsorption of metal complex can turn out to be inhomogeneous. Alternatively, adsorption is at least slowed down significantly. This is especially the case in a bed reactor or when solid material is used with a single particle size of more than 1 mm. When solid material with a particle size of less than 1 mm is used, some of the pores or cavities of a solid material particle can be blocked by a second solid material particle. In this case, exposure of internal surfaces or inter-crystalline spaces to metal complex is hindered and adsorption is impeded. When the solid material is moved, the geometric configuration and interdistance between two particles of the solid material changes. The solid material or the solid material particles should change position at least once, which can be achieved by means of turbulence. Also the orientation of the solid material with respect to the flow of metal complex direction is changed. Therefore, parts of solid material which have been in the shadow of the flow of metal complex can be exposed to metal complex. By these means, adsorption quantity on the surface of solid material is increased.

The solid material often consists of particles, which are prepared before the production process is carried out. No cleaving of activated particles after impregnation with metal is necessary. The solid material can also comprise at least one particle. In such a case, the solid material can be a component of a reactor, like a pipe or a coil, which is ready for installation after impregnation with metal. A cross-section can be attributed to a particle of the solid material. An outer diameter can delimit the solid material in one direction. An inner diameter can delimit the solid material in a second direction, like an inner direction or a core direction. The inner diameter can delimit a solid material free area. By another aspect, the inner diameter can delimit a solid material area that is free of metal provided by metal complex. In other words, the solid catalyst material can be localized between an inner diameter and an outer diameter. An inner diameter can describe a border between solid material and solid catalyst material impregnated with metal. It can be said that a first section of a pore or cavity is located outside of an inner diameter and a second section of a pore or a cavity is located inside, that is within, an inner diameter. The diameter of at least 1 of the particles can be less than 50 µm in at least a first direction, so that particles can be better handled with transport facilities or filling facilities like a feeder for powder. A feeder for powder can provide a flow of solid material particles e. g in a direction collinear to a force of gravity through a reactor vessel, when a through-flow reactor for solid material with cross-flow configuration is used. The particle can have a diameter of less than 1 µm in at least one direction. The particle can be atomically flat in a second direction or comprise of multiple layers in the second direction. Asymmetric particles, which are smaller in one direction than in another direction can easily turn over in a flow of metal complex or oxidizing gas. Particles which have a structure of a flake or a nano-flake can easily flow within a fluidized bed reactor. Such particles are particularly well suited for impregnation under a weak gas flow of less than 1 ccm (cubic-centimetre) of vapour per minute and per gram of a thin layer of solid material.

The solid material can be fixed to a support framework, like a substrate surface, in a preprocessing step. The framework provides a pre-fabricated structure, like a prototype form, a skeleton, a lattice or a template. At least one particle of the solid material can be immobilized on the surface of the support framework. The solid material can also form a film on the support framework, like a zeolite film that is deposited on the support framework in liquid phase prior to the production of the solid catalyst material. The support framework can be a sieve structure or a pipe e. g. for gaseous or liquid reactants. The support framework can also be a honeycomb structure like a catalyst structure mounted in the exhaust for fumes from a combustion engine or a plant reactor. Also, natural substrates like cordierit can be used as a support framework. Other materials which can provide a large surface area for catalyst production are metallic foams, in particular metallic foams covered by a film of zeolite material, thus providing cavities and micropores in one sample.

The adsorption of metal complex can be further improved, when the solid material is prepared with an activation step prior to impregnation of the solid material. Before impregnation, the process step for solid catalyst material production can activate the surface of the solid material. The activation can be carried out by drawing vacuum on the solid material, especially on a vessel containing the solid material. The activation can be enhanced through exposure to an activation gas such as hydrogen on aluminium oxide. Activation can be further improved by heating the solid material thus accelerating the evaporation of crystalline water or surface adsorbed water from the solid material. The solid material can be heated to a temperature of 80 °C to improve evaporation of water. When the solid material is heated to a temperature above 100 °C, also impurities with low vapour pressure, like solvents, can be removed and adsorption of metal complex in the activated solid material is further improved. As an alternative, also a passivation step can be implemented in the process. The passivation step includes exposure of the solid material or of the solid catalyst material preferably to a passivation gas either before or after the impregnation. A passivation gas, like water vapour, renders a surface section immune for adsorption of metal complex or immune in respect of catalytic activity. Therefore a passivation step can be applied in order to limit a thickness of a shell-structure. Gases for activation or passivation are preferably applied for a pre-determined period of time.

As an alternative or in addition, at least one gas flow thermalizing step can be carried out. A gas flow thermalizing step that is a metal complex flow thermalizing step can be useful before an adsorption step. A temperature of metal complex is stabilized. A metal complex flow thermalizing step can also be repeated before each step of adsorption. The gas flow thermalizing step can be performed, in the same time, when fluid or gas is provided for adsorption or for decomposition steps but for the respective other fluid or gas that is to be used in a following step of e. g. decomposition or adsorption. In other words, a decomposition gas flow thermalizing step can be carried out during the process step of adsorption. In a gas flow thermalizing step, a fluid supply-line, like a feed line, is brought to a temperature used for feeding a fluid, like a gas. Therefore, the fluid that is applied in a process step can not change temperature by interaction with a conduit of the fluid supply-line. The fluid supply-line is almost exactly at the process temperature pre-set for the fluid in respective step of adsorption or decomposition. The fluid supply-line, like a gas supply-line, is thermalized by a gas flow. Also mixed gases are thermalized in a gas flow. Therefore almost no temperature gradient is present in the gas flow. In the gas flow thermalizing step, the gas flow is preferably directed through a reactor-vessel-by-pass line. By this measure, control over temperature for production of egg-shells is even more accurate, either below or above room temperature, and diffusion, especially of the metal complex, can be kept within limits.

One way to impregnate solid material continuously is by circulation of an input of solid material, especially solid material in the form of particles or pellets. The particles or pellets are impregnated with metal from a metal complex for an exposure time. The ratio of the flow of solid material and the flow of metal complex is adjustable. By controlling adsorption and desorption of metal complex the density of metal in a section of the solid catalyst material can be controlled to some extent. Also the ratio of the flow of oxidizing gas and the flow of solid material can be adjusted. The generation of heat that could affect the impregnation process e. g. by desorption of metal complex, can be limited. Heat generation is preferably kept below the temperature for activation of surface diffusion of metal complex or of metal on solid catalyst material. The flow of metal complex, the flow of oxidizing gas, the flow of inert gas and the flow of solid material can be controlled independent from each other for optimization of production efficiency. After at least two production steps, circulation of the solid material can start and production steps are repeated, especially under the same conditions, over again, for a controllable number of circles. The number of circles used, can affect a ratio of species of metal in a section, especially the first section, of the shell structured solid catalyst material.

Even more sophisticated catalyst materials can be produced by combining the first metal and the second metal, especially transition metals, on a solid catalyst material surface. The first and the second metal can form a single particle like an alloy. The first and second metal can also be bonded to different sites of the solid surface. This technique of bonding to different sites forms a multifunctional solid catalyst material. The first metal is introduced in pores or cavities of the solid catalyst material by carrying out a first impregnation cycle. The second metal can be introduced by carrying out a second impregnation cycle. An impregnation cycle comprises steps of adsorption of metal complex and steps of exposure of the adsorbed metal complex to oxidizing gas. When a larger concentration of dimeric or trimeric metal is required, a first impregnation cycle with the first metal can be followed by a second impregnation cycle with the first metal. Preferably a second impregnation cycle is carried out with a metal complex providing a second metal.

The solid catalyst material is particularly useful for heterogeneous catalysis. The catalyst can be used for selective catalytic reduction (SCR). For example, nitrogen oxides, also referred to as NOₓ can be disposed of with the aid of the solid catalyst material. The NOₓ is transformed to diatomic nitrogen, N₂, and water, H₂O, using ammonia and a solid catalyst material. The shell structured solid catalyst material produced, contains a high degree of highly active metal species, like iron, especially for selective catalytic reduction of NOₓ, obtained at lower temperatures as compared to other catalyst materials, which involve combinations of liquid phase and gas phase processing for catalyst material production. This catalysis process is useful in industrial boilers or solid waste boilers, diesel engines or gas turbines. A solid catalyst material is preferably settled in an elongated honeycombed filter structure. The solid catalyst particles can be the filler of a catalyst cube, through which the reactants like nitrogen oxide are guided for decomposition or transformation. The structure of the filter would look like a tube. At the same time, the structure can be comparable with stacked honeycombs, sponges or coils. The solid catalyst material can also be a catalyst for chemical synthesis. One example, where solid catalyst materials are particularly useful is a synthesis of hydrocarbons. The synthesis process can be similar to a Fischer-Tropsch process. Typical reactants for such a synthesis are carbonmonoxide and hydrogen, which are obtained e. g. from coal gasification, natural gas, bio mass or bio gas. Products can be alcohol, wax type materials or gaseous or liquid fuels. Having a shell structure with a pre-determined shell thickness allows better control over the size or length of chains e. g. of hydrocarbons synthesized under catalysis.

The solid catalyst material is preferably produced under thermal conditions, which require no additional supply of thermal energy, namely near at or exactly at room temperature (around 20 °C). The oxidizing gas can be heated e. g. to a temperature of 200 °C in order to activate the oxidation reaction, which by itself is exothermal. Since monomeric species can readily be produced under such moderate conditions, the catalysts can be further functionalized e. g. by organocatalytic molecules without any intermediate heating steps, e. g. for calcination of the catalyst. Temperatures of 600 °C and higher are known to decompose most organic molecules. The process according to this invention can be implemented or combined with a process for production of an organocatalyst, thus providing e. g. a multifunctional catalyst based on zeolite solid material.

With the process of this invention, a sample temperature of a zeolite catalyst can especially be kept below a Tammann temperature for a metal chosen for deposition in a shell section. At the Tammann temperature, interatomic bonds can be activated for dissociation or for sintering, which is at about 50 % to 75 % of the solid metal oxide melting temperature, therefore typically at more than 470 K. Deposition of monomeric metal on a solid material that has a thermal instability at above the Taman temperature e. g. in respect of structural or compositional properties is possible by the process of this invention. During oxidation, due to exposure to the oxidizing gas, a temperature of the solid material is kept below the appropriate Tammann temperature of the metal complex. It is advantageous that Tammann temperature is not exceeded during the oxidation of the moiety, i. e. at any time during the oxidation. The appropriate Tammann temperature depends on the specific value for the metal or metal oxide, e. g. for MoO₃ the Tammann temperature is around 534 K.

Heating of solid catalyst material in an additional heating step for calcination in the production of a catalyst is preferably avoided since it would spoil the cumulative energy balance for providing the catalyst. Also liquid metal moiety is preferably used for providing metal complex, which generally requires less energy for being transferred into vapour phase. Vaporisation of liquid moiety can be supported by means of a spray mechanism. By such token, also the process of adsorption can be energetically optimized. Moieties with decomposition temperature above vaporisation temperature can be used in the process.

The catalyst can be particularly efficient with a plurality of monomeric species forming catalytically active sites compared to nano-particles of metal or nano-particles of metal oxide. All monomeric species, in particular single atomic, ionic or respective oxide species, e. g. having a first or a second type of coordination, can exceed all oligomeric species by number in a section of a solid catalyst material, like a shell. Oligomeric species can be cluster, comprising metal or metal oxide. Oligomeric species can have a size and in particular a mass distribution due to variation of number of atoms bonded together. Oligomeric species can also be nano-particles, when they are larger than 1 nm (nanometre) in at least one dimension. By estimation or counting numbers of monomeric species and numbers of oligomeric species can be determined. The number (more precisely, the numbers) refers to species attributed to monomeric or oligomeric species, which can be found within a specified surface area unit of e. g. the first section of the solid catalyst material. Of course, statistical significance of the method to determine such numbers needs to be ascertained. The content of monomeric species and oligomeric species can be analysed with UV-vis optical spectroscopy, in particular by using the diffuse reflectance method. The sub-bands attributed to monomeric species in the UV-vis spectra are often located at shorter wavelengths than the sub-bands attributed to oligomeric species, cluster or nano-particles. Preferably at least 50 %, more preferable at least 60 % of the measured species are monomeric. The number of species is proportional to the strength or also the intensity of the sub-bands measured in the UV-vis spectra, preferably using the method of diffuse reflectance spectroscopy. Also other spectroscopic methods or microscopic methods like scanning probe techniques can be applied for measurement of numbers of monomeric species and numbers of oligomeric species on a solid catalyst material for comparison. A gradient of an average particle size along a channel can be produced. By another aspect, a surface density of metal along a channel, especially along a surface of a channel, can be provided, which may terminate at a specific region along the channel. The end region of metal deposit can comprise monomeric species of metal, which exceed all particles of oligomeric species by number. Further along the channel, no metal is deposited. The solid material may be cleaved, e. g with a blade, so that measurements of metal species can be made for different sections of a solid catalyst material.

By one perspective, it could be said that an apparatus for production of the solid catalyst material, which can be used for the production process described before, can comprise a fluidized bed reactor for solid particles. By another aspect the reactor vessel can be a cross flow reactor. The rector can comprise a gas feeding filter, limiting a first end of the reactor vessel, and a gas exit filter, limiting a second end of the reactor vessel, wherein the filters are perforated with pores, which are smaller than a particle diameter of the solid particles. The apparatus can further comprise at least one gas mixing stage being operatively connected to the gas feeding filter, for controlling a mixture of a carrier gas, like an inert gas from a gas source, either with a metal complex vapour from a metal complex source or with an oxidizing gas, the mixture being feedable into the reactor vessel. With the control unit of the apparatus, also a flow velocity of solid material particles, e. g. provided by a transportation system, can be controlled or measured.

In one embodiment, the reactor comprises an adsorption chamber and dissociation chamber so that adsorption and dissociation by oxidation e. g. of metal carbonyl takes place in separate fluidized reactor vessels. In another embodiment, the adsorption chamber and the dissociation chamber are located within the same reactor vessel, preferably having at least partially overlapping volumes. Separation of both chambers, of the adsorption chamber and the dissociation chamber, are useful for quasi-continuous production of solid catalyst material. If size and volume of the apparatus is limited, both processes, the process of adsorption and the process of dissociation, shall be conducted in the same chamber. An apparatus for production of solid catalyst material is particularly efficient, when it comprises at least one auxiliary unit or one additional component. A feeding device can be an auxiliary unit. The feeding device preferably comprises an activation system, in which solid material is chemically or physically pre-treated, e. g. to enhance adsorption of a first and/or a second metal complex. The activation system can comprise a heater or a vacuum pump that produces pressure below atmospheric pressure of 1000 hPa (hectopascal), preferably below 10 hPa. The activation system can also comprise a wet chemical stage for preparation of a surface or a surface layer like a zeolite layer of the solid material. Another auxiliary unit can be a cooler connected with a reactive vessel. With the help of the cooler, the temperature from exothermic reactions going on inside the reactor vessel can be limited. An additional unit can be a heater connected with a reactor vessel. A heater may be useful to overcome activation energy for an exothermic oxidation process with oxidizing gases of poor reactivity or low reaction rate.

Another auxiliary unit can be a gas flow meter for keeping control over the flow of at least one gas into at least one chamber of the reactor vessel. Manual valve adjustments can be made based on meter readings. An additional unit could be a gas flow controller that is adjusting the flow of gas automatically, that is through a process control unit. The gas can be a carrier gas, a metal complex vapour or an oxidizing gas. A gas flow controller preferably comprises a timer, which can set the time for adsorption process and/or the time for oxidation process of the metal complex. The timer can also set intervals for fluidization, when solid material particles are to be moved within the reactor. The gas flow meter or the gas flow controller can be operatively connected with the mixing stage.

Another auxiliary unit of an apparatus could be a waste material processing system that is connected with the reactor vessel. The waste material processing system removes possibly poisonous metal complex from the carrier gas flow. Especially near saturation of the solid material with metal complex, a considerable amount of metal complex remains in the gas flow. The waste material processing system can be a second stage of a fluidized bed reactor using solid material for filtering the carrier gas, especially gas coming through a thermalizing by-pass line. The waste material processing system can also be a gas washer operatively connected with a gas exit filter. A gas washer can remove metal complex and products from oxidative decomposition of metal complex from gas flow, especially from gas leaving the reactor vessel through the gas exit filter or through a by-pass line. Also a vacuum pump operatively connected with a gas exit filter or connected with a gas feeding filter can be an additional unit of the fluidized bed reactor, which will help to speed up removal of excess metal complex before the reactor vessel is filled with oxidizing gas.

Furthermore, an agitator operatively connected with the reactor vessel can be an auxiliary device or an additional unit. A steering device with a rotor inside the reactor vessel or a conveying screw can be an agitator. Also a shaking device, e. g. a device that is changing the position of the reactor vessel or of the entire fluidized bed reactor can be an agitator. Other possible examples of agitators are a mechanical vibrator or an ultrasonic system that is coupling mechanical or acoustic energy into a reactor vessel. The agitator may rotate the reactor vessel, thus improve contact between solid material, solid catalyst material, and a fluid or a gaseous atmosphere.

The apparatus can be equipped with a fluid circulation system, especially for a gas or a vapour, like a gas circulation system, as an auxiliary unit. The fluid circulation system comprises a circulation conduit. The circulation conduit can be connected with the fluid feeder or the feeding filter and with the fluid exit conduit or the exit filter by means of at least one, preferably two, control valve(s), namely the circulation control valve. One may say, the circulation system leads from one end of the reactor to the other end of the reactor. Gases and vapours may be conducted well by tubes and the like. The metal complex or the oxidising gas can be recycled. The amount of the material that needs to be treated as waste is reduced by recycling. In batch production, a predetermined amount of metal complex can be circulated through the reactor vessel until it is almost completely adsorbed in the solid material. The fluid circulation system may comprise a heater to prevent condensation of metal complex on inner walls of the circulation system. The fluid circulation system can comprise a cooler. By one aspect, the heater or the cooler of the circulation system are used to stabilize the temperature of the fluid that is circulated through the reactor vessel. Also a pre-defined mass of oxidizing gas can be circulated by the fluid circulation system until the oxidizing gas is consumed by oxidation reactions. In one example of an apparatus, a first circulation system is provided, which can be used for circulation of metal complex, which can be named a metal complex circulation system. In another example of an apparatus a second circulation system is provided for circulation of an oxidizing gas, which can be named an oxidizing fluid circulation system. A metal complex circulation system and an oxidizing fluid circulation system can be connected with the same reactor vessel or, as an alternative, be configured for separate reactor vessels, like a series of reactor vessels of a production facility for shell structured solid catalyst material. The respective circulation system comprises a circulation pump capable of generating pressure, like a gas pressure used for feeding oxidizing gas, metal complex vapour and carrier gas or mixtures thereof. The circulation pump can comprise a gas flow controller and especially at least one sensor, like a temperature sensor, a pressure sensor or a partial pressure sensor. By one aspect, the circulation pump can be used to evacuate the fluid from the reactor vessel into a vessel or a conduit of the circulation system. The circulation system can comprise at least one thermalizing reactor-vessel-by-pass line. For the controlled interval of time, in which the first circulation system is circulating metal complex fluid through the reactor vessel, the second circulation system can be circulating oxidizing gas through a thermalizing reactor-vessel-by-pass line. For the controlled interval of time, in which the second circulation system is circulating oxidizing fluid through the reactor vessel, the first circulation system can be circulating metal complex through, especially a second, thermalizing reactor-vessel-by-pass line. Respective interval of time is preferably ended by evacuation of the reactor vessel from fluid. The thermalizing reactor-vessel-by-pass line can be in contact with a through-flow heat exchanger, like a cooler or a heater. Fluid consumed inside the reactor vessel is replenishable. The circulation system can be connected to a respective fluid supply-line. The circulating fluid in the fluid circulation system can be refilled from a fluid supply line through a replenishment control valve, especially during fluid circulation through the thermalizing reactor-vessel-by-pass line. A circulation system comprising a replenishment system can be used e. g. to maintain a pressure of the fluid, in particular for keeping a pre-defined partial pressure of metal complex in a carrier gas, or for keeping a pre-defined partial pressure of an oxidizing gas in an inert gas within the circulating system. A thermalizing by-pass line in a circulating system combines advantages of particularly fast switching between adsorption step and decomposition step, especially switching between fluid temperatures applied in respective step, and efficient use of fluid. Production of shell structured solid catalyst material is carried out with pre-defined fluid circulation times, like a time of less than one minute. The fluid circulation time can be controlled separately in a process step of adsorption and in a process step of decomposition. In any system, through-flow or circulation system, switching of steps is carried out by means of control valves through the process control unit. By one aspect, the fluid circulation time can also be named exposure time.

Especially when the apparatus is a continuous production system for a solid catalyst material, the apparatus can comprise a transportation system, operatively connected with a reactor vessel. The transport system is preferably used for transporting impregnated solid catalyst materials through and away from the reactor vessel, thus maintaining a continuous flow of solid material. The transport system can operate together with a feeding system for solid material, especially synchronized by the process control unit. The solid catalyst material can be transported to a processing stage. The solid catalyst material can be transformed to a final product in the processing stage. An additional layer of material e. g. for promoting a reactive process can be added to the solid catalyst material in a flow-through reactor located downstream of the solid catalyst material. When the processing stage is a deposition device, solid catalyst material can be filled in a container or deposited or immobilized on a component of an engine or a gas purification system or the like. This can be done for further use e. g. in a catalytic reactor or catalytic purification system for liquids or for gases.

The apparatus can further comprise a separation stage for solid catalyst particles. The separation stage is operatively connected to the reactor vessel. The separation stage, like a cyclonic separator and/or a filter for separation of particle mass, or other material properties, like magnetic strength of shell structured solid catalyst material particles, particle size or particle diameter can be used for production of different grades of solid catalyst particles. The different grades can also be produced in batches. Solid catalyst particles can be separated by identifying at least one difference in at least one parameter. Solid catalyst particles can have a different mass, a different size, a different volume or a different catalytic activity, which can be measured by a detection unit in the separation stage. A separation unit like a beam of compressed air can direct the solid catalyst particles from batch production or from continuous production into different collection units or containers or on different transportation systems or processing stages. In this way a most efficient production and efficient use of solid catalyst material can be achieved.

By a yet another perspective, the apparatus can comprise at least one of the following, namely a feeding device, preferably comprising an activation system, for solid material, a cooler connected with the reactor vessel, a heater connected with the reactor vessel, a gas flow meter, a gas flow controller, preferably comprising a timer, whereas the gas flow meter or the gas flow controller are operatively connected with the mixing stage, a waste material processing system connected with the reactor vessel, like a gas washer operatively connected with the gas exit filter, a vacuum pump operatively connected with the gas exit filter, an agitator, like a stirring device, a shaking device, a mechanical vibrator, or rotator or an ultrasonic system, whereas the agitator is operatively connected with the reactor vessel, a fluid circulation system operatively connected with the gas feeding filter and the gas exit filter, a transportation system operatively connected with the reactor vessel, especially for transporting impregnated solid catalyst material to a processing stage, like a flow through reactor or a deposition device, a second reactor for solid particles, especially a fluidized bed reactor, preferably being used as a gas absorption chamber, a separation stage operatively connected to the reactor vessel, for separation of solid catalyst particles by a difference in at least one parameter like a mass, a size, a volume or a metal contend, especially within a shell structure.

### Brief description of figures

The understanding for present invention can be enhanced by referring to the following figures which may show additional inventive aspects by themselves, wherein
fig. 1 shows a schematic flow chart of a batch process for production of solid catalyst material,
fig. 2 shows a schematic flow chart for a continuous production process of solid catalyst material,
fig. 3 shows a schematic flow chart of a continuous process with a counter flow option,
fig. 4 shows a schematic flow chart for a continuous production process comprising a second production line,
fig. 5 shows an apparatus in schematic presentation for the production of solid catalyst material,
fig. 6 shows another example of an apparatus in schematic presentation for continuous production of solid catalyst material,
fig. 7 shows schematically the control over thickness of a shell structure and the control over metal content within the shell structure, and
fig. 8 shows photos of cross-sections of different shell structured solid catalyst materials comprising iron in figure 8a, figure 8b and figure 8c, which respectively are produced under controlled conditions,
fig. 9 shows photos of different shell structured solid catalyst materials comprising cobalt,
fig. 10 shows measurements of adsorption of iron carbonyl on zeolite as a function of adsorption time and flow of iron carbonyl,
fig. 11 shows measurements of iron content by EDX for different amounts of iron carbonyl adsorption on zeolite,
fig. 12 shows optical UV-vis measurements of iron zeolites catalysts having two different Fe/AI-ratios,
fig. 13 shows the Kubelka-Munk-transformation of optical UV-vis measurements of iron zeolite catalyst having 5.43 weight % iron,
fig. 14 shows the Kubelka-Munk-transformation of optical UV-vis measurements of iron zeolite catalyst having 1.61 weight % iron,
fig. 15 shows the ratio of monomeric iron from all iron species on zeolite for different production conditions,
fig. 16 shows measurements of iron content by EDX for different amounts of cobalt tricarbonyl nitrosyl adsorption on zeolite,
fig. 17 shows the Kubelka-Munk-transformation of optical UV-vis measurements of cobalt zeolite catalyst having 1.2 weight % cobalt,
fig. 18 shows the Kubelka-Munk-transformation of optical UV-vis measurements of cobalt zeolite catalyst having 3.4 weight % cobalt,
fig. 19 shows the Kubelka-Munk-transformation of optical UV-vis measurements of cobalt zeolite catalyst having 4.4 weight % cobalt,
fig 20 shows the Kubelka-Munk-transformation of optical UV-vis measurements of cobalt zeolite catalyst having 5.1 weight % cobalt, and
fig. 21 shows the ratio of monomeric cobalt from all cobalt species on zeolite for different production conditions.

### Description of figures

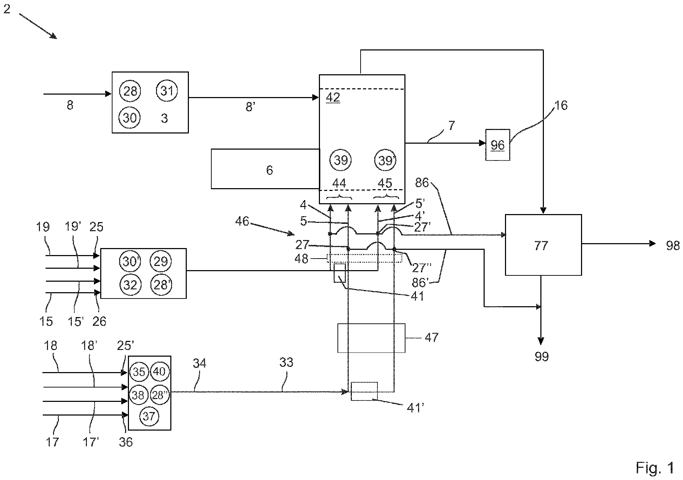

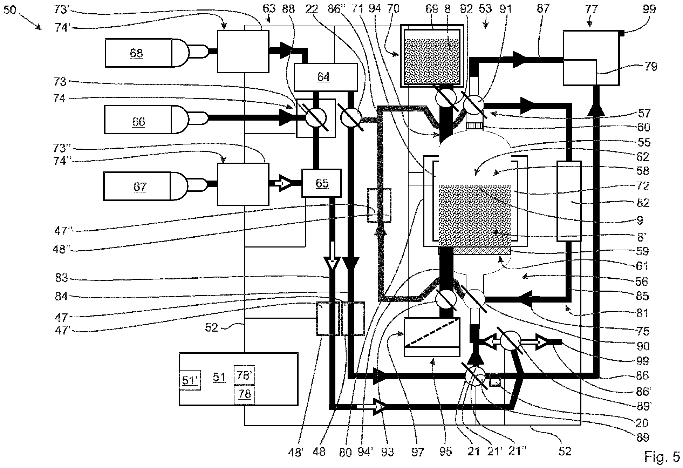

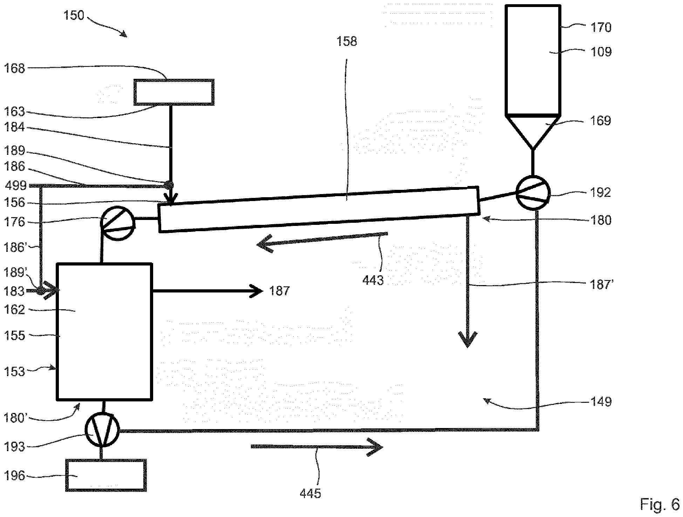

Several variations of production methods for shell structured solid catalyst materials based on this invention are shown in figures 1 to 4. The figures have many aspects of processes in common, which may not be described for each flow chart repeatedly. Therefore figures 1 to 4 should be considered, looking at all four figures while studying the documentation. Each flow chart shows functional features and behavioural features, which can be realized by an apparatus in accordance with figure 5 or an apparatus in accordance with figure 6. A combination of the aspects from one flow chart and from another flow chart out of the flow charts of figure 1 to 4 may be possible as well.

The production process 2 of figure 1 has been designed for the production of pre-defined mass of solid material 8 like zeolite particles. In the beginning, the solid material 8 undergoes an activation step 3, in which at a given gas pressure 28, like the pressure of less than 14 torr, the solid material 8 is degassed, typically at a temperature 30 of 180 °C. The duration of the activation 31 can be about 18 hours. The activated solid material 8' is filled as a batch 42 into a reactor. After the activation step 3 the adsorption step 4 is carried out. Metal complex 15 is provided as a flow 26 into a mixing procedure, where the temperature 30' of the metal complex is stabilised above vaporisation temperature and below decomposition temperature of metal carbonyl. The expression "metal carbonyl" is an abbreviation for a specific stoichiometric molecular composition like the term "iron pentacarbonyl". The vapour from metal complex 15 is mixed with a carrier gas 19, that is provided with a gas flow 25 in order to establish a constant partial pressure 29 of a metal complex 15 within a total gas pressure 28'. The metal complex thus diluted in the carrier gas 19 is fed into the reactor in order to expose the solid material 8 for the adsorption step 4 within a pre-defined period of time of e. g. 30 seconds. In this process, the temperature 39 of the solid material 8' is kept constant. For the production of shell structured solid catalyst material 7 in the first impregnation cycle 44 the decomposition step 5 has to be carried out after the adsorption step 4. When the vapour flow 32 is ended, the adsorption time is basically over. For the decomposition step 5, the decomposition gas 33 will be fed into the reactor in order to expose the batch of solid material 42 to an oxidizing gas concentration 34. The oxidizing gas concentration 34 was prepared by mixing air as the oxidizing gas 17 with nitrogen as a first carrier gas 18. The gas flow 25' of the first carrier gas 18 is combined with the oxidizing gas flow 36 of air at a pre-set gas pressure 28". Thus, decomposition rate provided by the oxidizing gas composition 35 is adjusted and the partial pressure 37 of oxygen from air is further reduced. Furthermore, the temperature 38 of the oxidizing gas is controlled in order to make sure that the temperature of the solid material 39 in the reactor will stay below thermal decomposition temperature, when the batch 42 is exposed to decomposition gas 33. A typical value for the oxygen (O₂) concentration 34 is 0.15 vol.-% O₂, which is provided for decomposition of e. g. iron pentacarbonyl in two litres of nitrogen (N₂) per minute. The decomposition gas 33 is blown over the solid material 8 for the adsorption step 4 for a pre-set period of time of e. g. 1 minute. In some samples performed by the applicant, a concentration of oxygen as oxidizing gas 34 of 20 vol.-% O₂ in 80 vol.-% N₂ was used and the oxidizing gas flow 36 was held at 3.833 litres per minute. For a first example, the duration of the oxidizing gas flow 40 was 18 hours. In the second example, the duration of the oxidizing gas flow 40 was 2 hours. In both examples, the temperature of the oxidizing gas 38 was stabilized at 20 °C (room temperature) but no significant increase of metal content was found when the same adsorption conditions were applied.

A list of production conditions for a number of batch production process examples is given in table 1. In table 1, control of iron content in the catalyst material is shown. Activated zeolite of similar quality is used for all samples. The carbonyl flow in milligram per minute was varied. Furthermore, the time for adsorption was varied on the scale of minutes. The adsorption can be monitored by measuring the weight gain in milligram of the material. Furthermore, the iron content can be monitored by EDX measurements after the adsorbed iron carbonyl has been decomposed by oxidation. The EDX method is a method well known in the art. EDX is the abbreviation for energy dispersive X-ray spectroscopy. The iron content is given in weight %. Samples produced with the homogenisation step 6 that can optionally be included in the production process of the shell structured solid catalyst material 7 shows that shaking the solid material 8' can significantly improve adsorption of iron carbonyl and thus reduce process time.

**Table 1. Solid catalyst material produced using iron-pentacarbonyl and zeolite**

| Sample ID | Amount of activated zeolite^{a} [g] | Carbonyl flow [mg/min] | flow [l/min] | Argon Shaking device | Adsorption time [min] | Weight gain [mg] | EDX Fe content after oxidation^{b} [wt%] |
|---|---|---|---|---|---|---|---|
| Imp/ZeoS-01 | 1.85 | 60 | 2 | No | 30 | 496 | 4.8 |
| Imp/ZeoS-05 | 1.95 | 60 | 2 | No | 10 | 362 | 3.73 |
| Imp/ZeoS-06 | 1.98 | 60 | 2 | No | 5 | 252 | 3.5 |
| Imp/ZeoS-07 | 1.99 | 60 | 2 | No | 2.5 | 97 | 1.13 |
| Imp/ZeoS-10 | 1.86 | 60 | 2 | Yes | 13 | 506 | 5.55 |
| Imp/ZeoS-11 | 1.87 | 60 | 2 | Yes | 13 | 540 | 5.78 |
| Imp/ZeoS-12 | 1.85 | 60 | 2 | Yes | 6 | 364 | 4.65 |
| Imp/ZeoS-13 | 1.89 | 120 | 2 | Yes | 8 | 572 | 5.79 |
| Imp/ZeoS-14 | 1.93 | 180 | 2 | Yes | 7 | 552 | 4.91 |
| Imp/ZeoS-15 | 1.93 | 60 | 2 | Yes | 5 | 333 | 4.64 |
| Imp/ZeoS-16 | 1.85 | 60 | 2 | Yes | 4 | 277 | 3.55 |

| | | | | | | | |
|---|---|---|---|---|---|---|---|
| a Activation was performed under vacuum at 180 °C for 18 h b Oxidation procedure: 1.) At RT, 0.15 vol.-% O₂ in 2 l/min of N₂ for 18 h; 2.) At RT, 20 vol.-% O₂ in N₂ at a combined flow of 0.833 l/min for 2 h | | | | | | | |

Table 1 shows a list of production examples of solid catalyst material using iron carbonyl and zeolite.

According to table 1, iron content (in wt%) can be controlled well through production conditions for solid catalyst material.

The production process 2 can simply be modified for using a second metal complex 15' with a second carrier gas 19' as an option. Another modification of process 2 that is easily achieved is feeding a second oxidizing gas 17' mixed with another carrier gas 18' into the reactor. The metal complexes 15, 15' and the oxidizing gas 17, 17' can be used for production of a shell structured solid catalyst material like the solid catalyst material 7 in a sequence. A preferred procedure is the sequence, in which adsorption step 4 is followed by decomposition step 5 followed by adsorption step 4', which is followed by decomposition step 5' for production of the solid shell structured catalyst material 7, where each production step 4, 4', 5, 5' lasts about one minute. The first production steps 4, 5 produce a shell structure with iron in an outer shell (not shown). The second production steps 4', 5' enrich the shell structure with more metal, which can be noticed by using optical inspection of a material cross-section. The first carrier gas 18, 18' can be identical with a second carrier gas 19, 19', whereas first and second refer to the use as carrier gas for metal complex 15, 15' or for oxidizing gas 17, 17', respectively. The adsorption step 4' and decomposition step 5' are also named second impregnation cycle 45. The second impregnation cycle 45 can be carried out at a temperature of the shell structured solid catalyst material 39', which is higher or lower or identical with the temperature 39 of the shell structured solid catalyst material from the first impregnation cycle 44. The shell structured solid catalyst material 7 produced by the first impregnation cycle 44 and optionally the second impregnation cycle 45 is transferred to a deposition device 96 and immobilized on a support 16. Since the first impregnation cycle 44 and the second impregnation cycle 45 are flow-through procedures, the gas after exposure to the batch 42 is treated with a washing procedure 77 for separation of a gaseous component for the exhaust 99 and a liquid component 98 for waste disposal.

A gas flow thermalizing step 46 can be carried out during the first impregnation cycle 44 and during the second impregnation cycle 45. The thermalizing step 46 involves operation of the through-flow fluid heat exchanger 48. The control of delayed process step alternation 41 determines the duration of the adsorption step 4, which ends at the first temporal switch point 27. At the first temporal switch-point, the gas flow 25 and vapour flow 26 are directed through the first thermalizing reactor-vessel-by-pass 86 to the washing of gas 77 in the waste material processing system. Therefore the vapour flow 32 through the through-flow gas heat exchanger 47 is maintained while the decomposition step 5 is carried out with the gas flow 25' comprising flow of oxidizing gas 36. Gas flow 25' is guided through a through-flow gas heat exchanger 47 for temperature stabilization, which is carried on even when the decomposition step 5 is ended by the control through the delayed process step alternation 41'. In this situation, the gas flows 25', 36 are directed through the second thermalizing reactor-vessel-by-pass 86' to the exhaust 99. At the second temporal switch-point 27', the delayed process step alternation 41' starts a second adsorption step 4', adds a digit to the counter 41' and thus begins the second impregnation cycle 45. The flow 25, 26 through the first thermalizing by-pass 86 is switched over to the batch of solid material 42. Through the continuation of the flow 25, 26, the temperature of the gas 30' remains constant. The temperature of the gas 30' can, as an alternative, be adjusted to a desired level through the through-flow gas heat exchanger. By this token, the adsorption steps 4, 4' can be controlled with high accuracy. Exposure time of less than one minute can be set for a single adsorption step 4, 4' and adsorption steps 4, 4' can be run repeatedly with different metal complex 15, 15', like cobalt metal complex and iron metal complex. Adsorption steps 4, 4' can be run repeatedly, e. g. with the same metal complex 15 or 15', and by using intermittent decomposition steps 5, 5' in order to built up metal content in a shell structure of the particles of the batch of solid material 42. Thus, metal content is increased step by step of impregnation 44, 45. Since the flow of oxidizing gas 25', 36 is maintained during adsorption step 4', it is also possible to control the oxidizing gas temperature 38 with good accuracy, before the third temporal switch-point 27" is reached. At third temporal switch-point 27", the second adsorption step 4' is ended and the flow of oxidizing gas 25', 36 through the second thermalizing reactor-vessel-by-pass 86' is directed over the batch of solid material 42 for decomposition of e. g. a second metal complex 15', 15. The second metal complex 15', 15 may require adjusted temperature 38 for achieving efficient decomposition in decomposition step 5'. Examples of batches of shell structured solid catalyst material 7 produced with a sequence of impregnation steps 44, 45 are shown in table 2.

**Table 2. Shell structured solid catalyst material produced using iron-pentacarbonyl and Al₂O₃**

| Sample ID | Mass of Al₂O₃ pellet batch^{a} [g] | Number of steps adsorption/ oxidation^{d} | Time of adsorption^{b} /oxidation^{c} [min/min] | Mass gain [mg/g Al₂O₃]^{e} | ICP Fe content [wt%] | Shell thickness [µm] |
|---|---|---|---|---|---|---|
| Fe-AlO2-02 | 1.767 | 4/4 | 10/5 | 249 | -- | 570 |
| Fe-AlO2-07 | 1.71 | 15/14 | 1/1 | 131 | 6.23 | 380 |
| Fe-AlO2-08 | 1.775 | 15/14 | 0.5/1 | 77 | 2.86 | 250 |
| Fe-AlO2-09 | 1.778 | 8/7 | 1/1 | 62 | 2.78 | 370 |

| | | | | | | |
|---|---|---|---|---|---|---|
| a Activation of the Al₂O₃ pellets was carried out by heating the pellets to 300 °C and drawing a vacuum for 2 hours prior to production of shell structured catalyst. b For adsorption, flow of iron-pentacarbonyl vapour was 60 mg/minute, which was mixed with a flow of argon carrier gas of 2 litres/minute. c The flow of oxidizing gas of 7 vol% oxygen in nitrogen was 2.8 litres/minute d After the last step of oxidation, further oxidation was performed for a significantly longer period (from 30 min to >24h) using 7 vol% to 20 vol% of oxygen to assure complete oxidation decomposition of the carbonyl. e Mass gain was determined after the final oxidation step. | | | | | | |

The Al₂O₃ pellet material used was commercially available. A typical diameter of the pellets used was 3 mm with median pore diameter of 9.8 nanometres (nm) and some pores of about 4 nm size up to about 600 nm size as specified based on intrusion measurements. The surface area was 231 m²/g or 257 m²/g (square metres per gram) of pellet material with an apparent porosity of 66.9 or 75.3 %, an apparent specific gravity of 2.3 or 3.2, and a particle density of 0.61 or 0.8 g/cm³, depending on the shipped sample. The structures provided a total pore volume, of 0.93 cm³/g or 0.98 cm³/g (cubic-centimetres per gram, by using Hg) of respective pellet material sample. In Table 2, the same sample material was used. An adsorption time of 0.5 minute, as compared to an adsorption time of one minute, gives a significantly lower shell thickness, namely a shell thickness of 250 micrometre (µm) for sample "Fe-AlO2-08", as compared to 380 µm for sample "Fe-AlO2-07". The samples were produced under similar conditions. The comparison of sample "Fe-AlO2-09" with sample "Fe-AlO2-07" shows that the shell thickness of about 370 to 380 µm can be preserved, while steps of adsorption and decomposition by oxidation of metal complex are repeated for a larger number of times. But the weight percentage (wt %) of iron within the shell structure is increased by the number of steps. By doubling the number of steps of impregnation that is the alternation of eight adsorption steps and seven decomposition steps by oxidation, to fifteen and fourteen respective steps, the weight percentage of iron in the shell structure of the solid catalyst material can be approximately doubled. The weight percentage was measured with the ICP (inductive coupled plasma) method, which is an alternative to the EDX method for analysis of relative content of elements. Good control of the shell structure was achieved with the production process according to this invention.

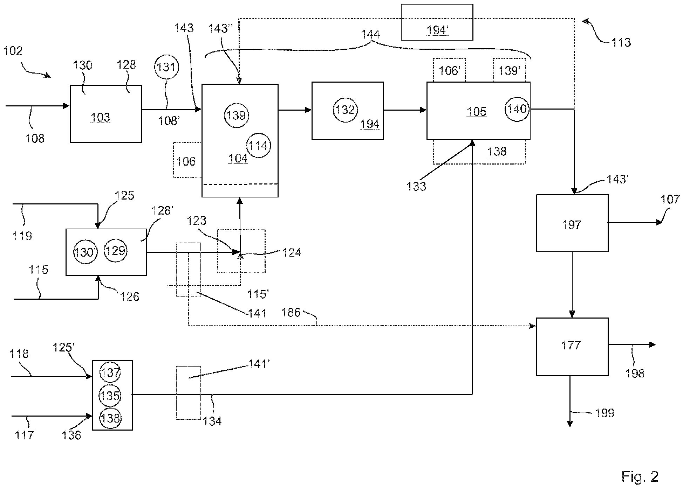

Figure 2 shows the flow chart of a continuous production process 102, which comprises some elements of a batch production process 2 in figure 1. In figure 2 the adsorption step 104 and the decomposition step 105 are carried out in separate reactor vessels at a distance from each other. A flow of solid material 143 from an activation step 103 through the impregnation cycle 144 is maintained, so that basically with the same flow, solid material 143, 143' is fed into a cyclonic separation 197 and is filtered to obtain the solid catalyst material 107. The activation step 103 is carried out for an activation time 131. Before feeding the cyclonic separation 197 that is after the decomposition time 140, the flow of solid material 143' can be treated with additional or repeated process steps 113, in particular by diverting the flow 143" back to adsorption step 104 and interrupting the flow of solid material 143. After a pre-set number of steps 104, 105, like ten steps, for accumulating metal in an outer section (not shown) of the solid material 108, the flow of solid material 143" will be directed as flow 143' to the cyclonic separation 197 of the shell structured solid catalyst material 107.

The activated solid material 108', like zeolite, Al₂O₃, SiO₂, MgO, CaO, rare earth metal oxides or carbon, is prepared continuously and the activation step 103 from solid material 108 takes place under controlled temperature 130 and gas pressure 128. The iron carbonyl metal complex 115 with a flow 126 is continuously evaporated under controlled temperature 130', which is also the temperature of the second carrier gas 119 of argon, that is mixed with the gas flow 125 to form a partial pressure of metal complex 129 at a total gas pressure 128'. Thus, a feeding concentration 123 of a first metal complex for the adsorption step 104 under the temperature of a solid catalyst material 139 is achieved.

As an option also another metal complex 115' can be fed with a concentration 124 of a second metal complex in the adsorption step 104. Thermal equilibration of the flow of the other, second metal complex 115', before providing it in the adsorption step 104, in particular for a recycled flow of solid catalyst material 143" after preparation of a first shell with the first metal complex 115, improves formation of a shell structure. For this measure, the counter and control for delayed process step alternation 141 can pre-establish a stabilized flow through a thermalizing reactor-vessel-by-pass 186 into the waste material processing system 177. When the second metal complex 115', like a cobalt carbonyl, is used in the adsorption step, the flow of the first metal complex 115 can be maintained through the thermalizing reactor-vessel-by-pass 186. By this feature, among other flow conditions, also the temperature of the gas 130 can be stabilized or preserved for the first metal complex 115 for the time when the apparatus switches back to the adsorption step 104.

Another option of the production process 102 is the homogenisation step 106 that can be carried out during the adsorption step 104.

Since concentrations of metal complex 123, 124 are provided continuously, the duration of the vapour flow 132 over the activated solid material 108' in the adsorption step 104 is determined by the transportation system 194 delivering the solid material 108' through the adsorption step 104 and into the decomposition step 105 in a cross-flow configuration. Also the decomposition time 114 is determined by the transportation system 194 while there is continuous flow of decomposition gas 133. The concentration 134 of the oxidizing gas in the decomposition gas 133 is controlled by the flow 136 of the oxidizing gas 117 and the flow 125' of the carrier gas 118 that is nitrogen. In this way the oxidizing gas composition 135 and the oxidizing gas partial pressure 137 can be controlled. Duration of oxidizing gas flow is indicated by reference number 140.

The decomposition step 105 can be further improved with the option of control of temperature 138 of the decomposition gas 133. Through counter and control for delayed process step alternation 141', the flow 136, 125' and in particular the temperature 138 can be adapted. Best oxidation decomposition for massing metal from a first metal complex 115 and from a second metal complex 115' deposited in a shell structure, can be established. Flow 136, 125' and temperature can be tuned for respective metal complex 115, 115' in sequence and in synchronisation with flow, of solid material 143" provided by transportation system 194, 194'.

Furthermore the temperature of the solid material 139' can be controlled in the decomposition step 105. The quality of the shell structured solid catalyst material 107 can be further improved by carrying out a homogenization step 106' in combination with the decomposition step 105, wherein the orientation of solid material 108' with absorbed metal complex 115, 115' is changed at least once before the flow of solid material 143' leaves the decomposition step 105.

Gases coming from the adsorption step 104 and the decomposition step 105 are led to a gas washing 177 for separation of exhaust gas 199 and liquid waste 198 for disposal.

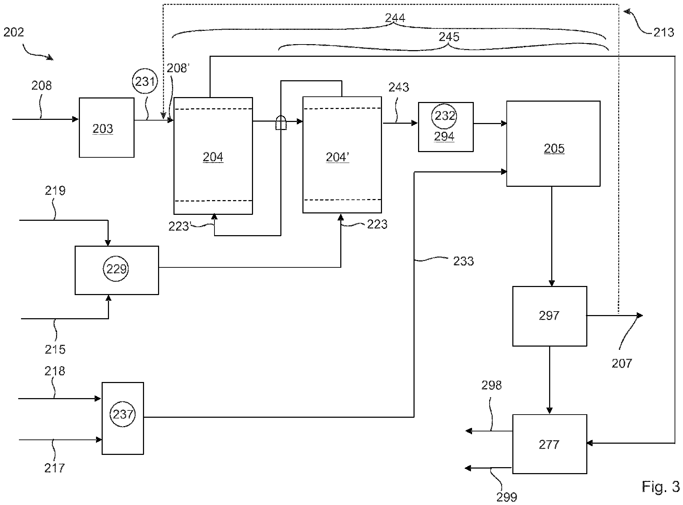

The continuous process 102 of figure 2 can be made even more efficient with a modification that is shown with the continuous process 202 of figure 3. The production process 202 comprises a first impregnation cycle 244 comprising the adsorption step 204 and the decomposition step 205. The production process 202 also comprises a second impregnation cycle 245 comprising the adsorption step 204', which can also be named a second adsorption step, and the decomposition step 205.

A continuous flow of the solid material 208 zeolite, transformed by activation step 203 with a duration of activation 231 into the solid material 208', is maintained through the impregnation cycle 244, 245, so that the continuous flow 243 reaches a cyclonic operation 297. Before shell structured solid catalyst material 207 of desired quality is finally obtained, the first impregnation cycle 244 and the second impregnation cycle 245 are carried out again as repeated process steps 213 for a pre-set number of times, like twenty times. Each repeated 213 cycle 244, 245 adding a small amount of metal to the shell structure, whereby especially control over species of metal particles can be achieved. The decomposition step 205 resembles the decomposition step 105 of figure 2, wherein adsorbed metal complex 215 of figure 3 is exposed to decomposition gas 233 within an oxidizing gas partial pressure 237 due to a mixture of the oxidizing gas 217 air with the first carrier gas 218 nitrogen. As described before, duration of the vapour flow 232 from the adsorption steps 204, 204' is determined by the transportation system 294 delivering the solid material 208 through the adsorption steps 204, 204' and into the decomposition step 205.

One advantage of the production process 202 is an efficient use of metal complex 215, so that the amount of liquid waste 298 for disposal that is obtained by waste material processing system 277 with a scrubber from gases of the impregnation cycle 244 is significantly reduced. Gases released through exhaust 299 are non-hazardous. This is achieved by feeding the metal complex 215 with a carrier gas 219 having a partial pressure 229 of metal complex vapour and therefore a controlled concentration 223 of metal complex first into the second impregnation cycle 245 where the second adsorption step 204' takes place. The second adsorption step 204' is carried out with a solid material 208', namely zeolite that has already absorbed some metal complex 215. Adsorption is due to the first adsorption step 204, in which activated solid material 208' is exposed to metal complex 215 and a carrier gas 219. However, the concentration 223' of the metal complex 215 is already lowered by the fact that the metal complex 215 with a concentration 223 has already passed the second adsorption step 204'. Therefore the first adsorption step 204 will remove almost all metal complex 215 from the carrier gas 219.

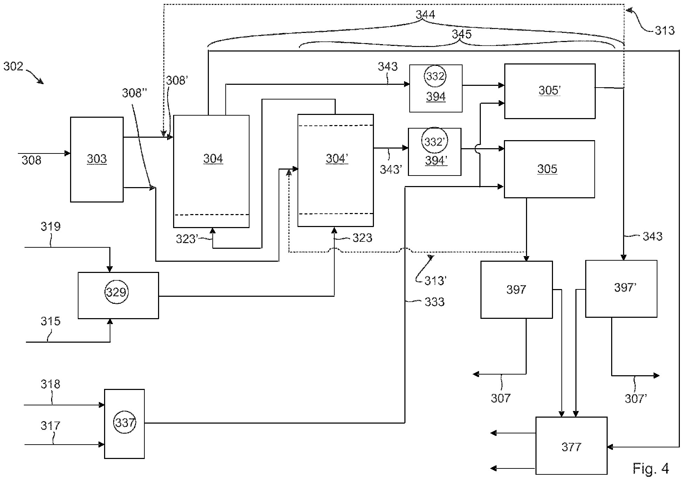

As shown in figure 4, the production process 302 for continuous production of shell structured solid catalyst material 307, 307' can be made even more versatile by implementing a second production line in the production process 302.

The production process 302 comprises an activation step 303 for solid material 308, especially zeolites or Al₂O₃, and a step for preparation of partial pressure 329 of a metal complex 315 in a carrier gas 319 and a step of preparation of partial pressure 337 of an oxidizing gas 317 in a carrier gas 318. In the activation step 303 the temperature of the zeolite is controlled. Furthermore, the time of temperature exposure of zeolite can be controlled. Also the pressure and the gas composition, under which the zeolite is kept, can be controlled in the activation step 303.

The first line of production for shell structured solid catalyst material 307 starts with activated solid material 308' that is used in the first impregnation cycle 344 with a flow of solid material 343, that enters the separation stage 397, resulting in the separated shell structured solid catalyst material 307. As in the embodiments described before, waste material is processed in a waste material processing system 377.

In the present process line the adsorption step 304 is carried out with a - in comparison to the concentration 323 of metal complex 315 - lower concentration 323' of metal complex 315 resulting from the optional step 304' of the second impregnation cycle 345 similar to production process 202 of figure 3 with a difference that in the production process 302 of figure 4, the first adsorption step 304 and the second adsorption step 304' are carried out on activated solid material 308', 308".

The adsorption time 332 of the first impregnation cycle 344 is controlled with a flow of solid material 343 by means of a first transportation system 394. The adsorption time 332' within the second impregnation cycle 345 is controlled with a flow of solid material 343' by means of a second transportation system 394'. The second impregnation cycle 345 is part of the second production line leading through a second decomposition step 305' to a second separation step 397' yielding a second shell structured solid catalyst material 307'. In each decomposition step 305, 305' the temperature of the respective solid catalyst material can be separately controlled. In each decomposition step 305, 305' the dwell time of the respective solid catalyst material can be controlled independent from each other. The gases from the adsorption steps 304, 304' and from the decomposition steps 305, 305' are fed into a gas washer for treatment of waste material.

In the decomposition step 305, 305' adsorbed metal complex 315 of figure 3 is exposed to decomposition gas 333 within an oxidizing gas partial pressure 337 due to a mixture of an oxidizing gas 317, e. g. air, with a first carrier gas 318, e. g. nitrogen. The versatility of the process of figure 4 shows even more pathways. The flow of solid material 343 comprising particles with a first shell structure can be redirected into a repeating process step cycle 313. Similarly, the flow of solid material 343' can be redirected into a repeating process step cycle 313'. In this way metal content in a shell structure of solid catalyst particles can be increased stepwise. By yet another option, which is not drawn in figure 4, the repeating process step cycles can cross each other thus forming a link between the two production lines in respect of flow 343, 343' or in respect of transport of solid material.

Figure 5 shows an example of an apparatus 50 that can be used for the production of shell structured solid catalyst material. The apparatus 50 comprises a fluidized bed reactor 53 and a gas mixing stage 63. The apparatus 50 comprises also a process control unit 51, which by means of a control line 52 can monitor and control a variety of parameters and functions of the fluidized bed reactor 53 and the gas mixing stage 63. Furthermore, the process control unit 51 can control the separation stage 97, the activation system 70 and the circulation system 81. Also, the waste material processing system 77 with a vacuum pump 79 can be switched by the process control unit 51. Very accurate temporal control is achieved through a quartz timer 78, which is available in the process control unit 51. The quartz timer 78 can trigger a switch point. At a switch-point (see figure 1), a valve, like the first control valve 89, can change a flow path, e. g. through ports 21, 21', 21", and especially interrupt, or open a passage of a flow of a fluid. The quartz timer can end a process or a process step after a time interval that is a number of seconds, a number of minutes or a number of hours or fractions thereof, which has run out. The time interval can be programmed through a terminal (not shown) via an electronic communication interface 51'. For repeating steps, the process control unit 51 comprises a counter 78'. However, a sequence of steps can also be carried out by the process control unit 51 based on individually programmed commands for each process step, like adsorption step or decomposition step, or of a number of additional process steps.

The gas mixing stage 63 provides the gas for the metal complex fluid supply line 84 and the gas for the oxidizing fluid supply line 83, which are leading to the fluidized bed reactor 53. Even though the mixing stage 63 is described here for operation with gas, it can also be used with fluid. Gas flow from the carrier gas source 66, which is measured by a flow meter 73 and controlled by a gas flow controller 74, can be fed into the metal complex fluid supply line 84 or into the oxidizing fluid supply line 83 depending on the setting of the mixing valve 88. For the metal complex fluid supply line 84, the carrier gas 66 drains the metal complex from metal complex source 68 within the vaporizer-mixer 64 comprising a source of heat. The flow of metal complex from the source 68 is monitored with a flow meter 73' and controlled with a flow controller 74'.

The gas flow controller 74 and the flow controller 74' together with a temperature generated in the vaporizer-mixer 64 determine the partial pressure of the metal complex under control of the process control unit 51. For pressures higher than vapour pressure of metal complex, such pressure can be adjusted by means of pressure from the first gas source 66 of carrier gas. The metal complex from the source 68 is guided through the first control valve 89, which is also named feed valve for metal complex, and the third control valve 90, which is also named circulation control valve, to the first end 56 of the reactor vessel 55 that is a core element of the fluidized bed reactor 53. The first end 56 forms the fluid feeder of the reactor vessel 55.

The first control valve 89 of apparatus 50 can interrupt the flow through the metal complex supply line 84 or direct the flow from the metal complex supply line 84 into the first thermalizing reactor-vessel-by-pass line 86 leading to the sucking pump 79 or into the waste material processing system 77, where carrier gas 66 and metal complex 68 are separated and carrier gas 66 is released through the exhaust 99. In one state of the apparatus 50, which can be named thermalizing state, the first control valve 89 is set to connect first port 21 with third port 21". The metal complex running through the metal complex supply line 84 passes through the through-flow fluid heat exchanger 47, 48, which stabilizes the temperature of the metal complex supply line 84, e. g. by heat exchange with the metal complex fluid, under control of the process control unit 51. The temperature sensor 20 is located flow downward from the first control valve 89. The sensor 20 measures the temperature of the first thermalizing reactor-vessel-by-pass line 86 adjacent to the third port 21". When the process control unit 51 reads a specific temperature from the sensor 20, the first process control valve 89 will be triggered to switch the third port 21" with the second port 21' so that metal complex of the controlled temperature can flow to the reactor vessel 55. At the same time, the second control valve 89' will be closed. The third control valve 90, which is the circulation control valve, is open for the metal complex flow from the supply line 84.

The gas for the oxidizing fluid line 83 is mixed in a thermostat-mixer 65. For this effect the mixing valve 88 can open the gas line from the carrier gas source 66 to the vaporizer-mixer 64 and to the thermostat-mixer 65. The flow of carrier gas is again adjusted by the flow controller 74 and monitored by the gas flow meter 73. Also, the pressure of the first gas source 66 of carrier gas can be adjusted. Furthermore, oxidizing gas from a second gas source 67 is fed into the thermostat-mixer 65 with a flow controlled by a gas flow controller 74" and monitored with a flow meter 73" and a pressure from the second gas source 67 which is also adjusted by means of the process control unit 51. The partial pressure of carrier gas 66 and oxidizing gas 67 is adjustable by means of pressures and flow into the thermostat-mixer 65. The thermostat-mixer 65 improves homogeneity of the gas mixture at a specified temperature level, like room temperature, for the oxidizing fluid supply line 83. The oxidizing fluid supply line 83 is connected to the second control valve 89'. The second control valve 89' can be opened for the oxidizing gas to enter the reactor vessel 55 through the third control valve 90, provided that the adsorption step in the production process has been terminated by means of the first control valve 89. The second control valve 89' can also be used for a second thermalizing state of the apparatus 50. In this state, the second control valve 89' connects the oxidizing fluid supply line 83 with the second thermalizing reactor-vessel-by-pass line 86'. The oxidizing fluid supply line 83 leads the fluid through the through-flow fluid heat exchanger 47', 48'. By means of the through-flow cooler 48' fluid temperatures of e. g. 0 °C or below can be achieved in the oxidizing fluid supply line 83. By means of a through-flow heater 47', fluid, like gas, can be provided with a temperature below the decomposition temperature of metal complex through the oxidizing fluid supply line 83. The through-flow fluid heat exchanger 47', 48' can operate also in the adsorption step through the second thermalizing reactor-vessel-by-pass line 86', which connects to the exhaust 99.

At the first end 56 of the reactor vessel 55 is the gas feeding filter 59, which has a plurality of pores so that gas coming through the third control valve 90 can enter the gas adsorption chamber 58 or the decomposition chamber 62. Either metal complex from the metal complex source 68 or oxidizing gas from the oxidizing gas source 67 is fed through the gas feeding filter 59 into the reactor vessel 55. Thus the reactor vessel 55 is used in sequence as gas adsorption chamber 58 or as decomposition chamber 62, respectively. First metal complex 68 flows through activated solid material 8' inside the reactor vessel 55 for adsorption. Then, the flow of metal complex 68 is interrupted by the first control valve 89. Flow of oxidizing gas 67 is brought into contact with metal complex 68 adsorbed on the activated solid material 8'. The cooler 71 or a heater 72 disposed around the reactor vessel 55 can be used to stabilize the temperature of the activated solid material 8' inside the reactor vessel 55. An agitator 80, which is also disposed on the reactor vessel, can be used to shake the reactor vessel 55 and thus change the position of particles 9 of solid material 8'. An alternative form of agitation that can be applied to the solid material 8' is a pulse of gas pressure from the first gas source 66.

Particles 9 of solid material 8' that are lifted up inside the reactor vessel 55 are held back by the gas exit filter 60 at the second end 57 of the reactor vessel 55. Gas is flowing through the gas adsorption chamber 58 and through the decomposition chamber 62 from the gas feeding filter 59 to the gas exit filter 60, which comprises pores, through which the gas can reach the fourth control valve 91, also named gas exit and circulation valve. From the fourth valve 91 the gas can enter the gas exit line 87 and continue into the waste material processing system 77 also extracted by the pump 79.

The efficiency of the apparatus 50 is further underlined by the fact that the flow coming from a gas exit filter 60 can also be directed into the fluid circulation system 81 by switching the fourth control valve 91. In addition, the third control valve 90 locks the conduit to the first control valve 89 and opens the flow of fluid in the circulation line 85 with a flow direction 75 from the fourth control valve 91 to the third control valve 90 and back into the reactor vessel 55 through the gas feeding filter 59. The pores 61 of the gas feeding filter 59 are so small that solid material 8' is held back inside the reactor vessel 55.

The fluid circulation system 81 comprises a circulation pump 82, which controls the flow and the pressure of fluid at the first end 56 of the reactor vessel 55. The fluid circulation system 81 can be used for gas provided through the metal complex supply line 84 or for gas provided through the oxidizing fluid supply line 83. In this way especially rare and expensive metal complex can be recycled and used up most efficiently. Less waste material from the waste material processing system 77 is obtained. In such a configuration also the gas from the exhaust 99 could be recycled as carrier gas for the carrier gas source 66.

In a circulation state of the apparatus 50, the fluid or gas can be guided in a cyclic flow. In a first circulation state, a first part of the flow can be inside the fluidized bed reactor 53 and a second part of the flow, in an opposite direction to the first part of the flow path, can be outside the fluidized bed reactor 53. In a second circulation state, the first and the second part of the flow path are outside of the fluidized bed reactor 53.

In a circulation state, the gas exit and circulation control valve 91 allows to block the exit line 87 from the reactor vessel 55. The supply lines 83, 84 can be blocked from the reactor vessel 55 by the third control valve 90, which, in addition can close any through-flow, especially flow of fluid into the reactor vessel 55. In this state, the pump 82 can evacuate the reactor vessel 55 from metal complex, which is not adsorbed on solid material 8'. The circulation system 81 comprises a third thermalizing reactor-vessel-by-pass line 86". The third thermalizing reactor-vessel-by-pass line 86" connects the third control valve 90 and the fourth control valve 91. Metal complex can be circulated by the pump 82 through the circulation line 85 and the third thermalizing reactor-vessel-by-pass line 86" outside the reactor vessel 55. The third thermalizing reactor-vessel-by-pass line 86" leads fluid through the through-flow fluid heat-exchanger 47", 48", which can also be named a circulation heat exchanger 47", 48". The through-flow fluid heat-exchanger 47", 48" stabilizes the temperature of the metal complex to a temperature value above room temperature, like 50 °C, or below room temperature, like 0 °C, but preferably above vaporisation temperature of the metal complex 68. In one preferred example of an apparatus, the through-flow fluid heat-exchanger 47", 48", the pump 82 and a reservoir vessel (not shown) form a circulation buffer unit, which is particularly compact and helps to stabilize gas or fluid concentration. A replenishment control valve 22 can connect the third thermalizing reactor-vessel-by-pass line 86" with the vaporizer-mixer 64. Through the replenishment control valve 22, metal complex 68 can be added in the fluid circulation system 81 in order to refill metal complex used up by adsorption. A specified concentration of metal complex in carrier gas can be maintained. The circulation system 81 is particularly useful for rare and expensive metal complex material, which can be kept circulating. Temperature is controlled in order to establish a pre-set value.

For initiation of an adsorption step in a circulation state with reactor vessel 55, the reactor vessel 55 can be evacuated through the fourth valve 91 by the pump 79. The fourth valve 91 can close the exit line 87 and the third thermalizing reactor-vessel-by-pass line 86". In joined operation of the fourth control valve 91 and the third control valve 90, the circulation line 85 is opened for circulation of metal complex through the reactor vessel 55. By this type of apparatus 50 with fluid circulation system 81, exposure time of less than 1 minute, especially less than 30 seconds can be achieved. Control over the temperature of the fluid and the amount of metal complex used is particularly good. After a first adsorption step, a purging step or a second adsorption step can follow. In a second adsorption step, a second metal complex (not shown), especially after purging of the vaporizer-mixer 64 from first metal complex through the first thermalizing reactor-vessel-by-pass line 86, can follow. After the first absorption step and especially after the second absorption step a decomposition step is carried out by feeding oxidizing gas 67 through the reactor vessel 55. It should be noted that, as an alternative, the circulation system 81 can be used for oxidizing gas with equivalent operation of control valves as compared to operation for circulation of metal complex. Another particularly efficient apparatus configuration comprises a circulation system for metal complex and a separate circulation system for oxidizing fluid, like the circulation system 81.

After impregnation with metal, the solid material 8' leaves the fluidized bed reactor 53 and the reactor vessel 55 through a transportation system comprising a sixth control valve 93, also named solid catalyst feed valve. The solid catalyst material is delivered by the transportation system 94' to the separation stage 97 comprising a cyclonic separator and a filter and further on to processing stage 95 for production of a final product comprising a solid catalyst material.

By using a second transportation system 94 the activated solid material 8' enters the reactor vessel 55 and the flow of the solid material 8' can be controlled by the fifth control valve 92, also named solid material feed valve, and the feeding device 69. The feeding device 69 is connected with an activation system 70, in which solid material 8 is treated under a flow of gas or a vacuum by a temperature of typically more than 100 °C. Activation is achieved e. g. by removing water from solid material 8. Other activation steps can be carried out e. g. steps for formation of a zeolite layer on a mezzo-porous carrier material.

Examples for useful types of zeolites are zeolites with a BEA framework structure having cavity diameters of around 0.668 nm and pore diameters of around 0.595 nm. A typical water loss (LOI) at 1000 °C is 1.1 wt% (short for weight %). The surface area according to BET theory is 660 m²/g (square metre per gram). The average particle size can be on a micrometre-scale with a particle size distribution having 50 % of the particles within 9.5 µm, and 90 % of the particles within 19.4 µm. Melting point is above 400 °C and density is 2.2 g/cm³ (gram per cubic centimetre).

Figure 6 shows a schematic of an apparatus 150, which is particularly useful for continuous metal carbonyl impregnation of particles 109 like particles of 100 to 200 µm size or ceramic pellets, which are spherical of 3 mm diameter, or beads, which have 8 mm length and 3 mm diameter. The design of the apparatus 150 provides a capacity in the range of 15 to 25 kg or 7 to 12 litre. The activation system 170 prepares the particles 109 for use and a feeding device 169 in connection with a solid material feed valve 192 delivers the particles 109 into the gas adsorption chamber 158. A typical residence time in the rotary gas adsorption chamber 158, which can also function as a kiln or a cooler, is 10 seconds to 10 minutes. The length of the gas adsorption chamber 158 can be in the 5 meter range to provide a sufficiently large surface area available for the metal carbonyl impregnation, so that 150 kg per hour or 1000 tons per year of impregnated solid material particles can be produced. A metal carbonyl gas generator 168 is used as a source for the metal complex. A gas mixing stage 163 prepares the feed gas for adsorption, which enters the gas adsorption chamber 158 by the feeder 156 and through the metal complex fluid supply line 184. Carrier gas mixed with excess metal complex is disposed of through exit line 187', e. g. by means of a pump unit and a washer (not shown). The solid material particles inside the rotary gas adsorption chamber 158 are transported by an agitator 180, comprising a rotator and a screw (not shown), thus forming a flow of solid material 443. The flow of metal complex over the transported solid material particles (not shown) forms, by one aspect, a cross-flow configuration 149. Especially for changing the metal complex, a first thermalizing reactor-vessel-by-pass line 186 can be used in order to lead the metal complex to the exhaust 499. Alternatively, metal complex is fed into the gas adsorption chamber 158 through the first control valve 189. The flow through the first thermalizing reactor-vessel-by-pass line 186 stabilizes composition of metal complex gas and especially the temperature of the metal complex fluid supply line, so that the metal complex gas can enter the gas adsorption chamber with a specified temperature. The flow of solid material 443 is guided through a feed control valve 176 into a reactor vessel 155 where the metal carbonyl, which is adsorbed to the particles 109, is instantly oxidized. The process is carried out in a reactor 153, which can be named a cross-flow reactor. Oxidizing gas is fed into the reactor 153 through the oxidizing fluid supply line 183. Unused oxidizing gas is pumped away through the exit line 187. The agitator 180' supports the reaction inside the decomposition chamber 162. The flow of shell structured solid catalyst material (not shown) is then controlled with the shell structured solid catalyst feed valve 193. The catalyst, like a Fischer-Tropsch catalyst, is collected in the deposition device 196. The valves 176, 192, 193 comprise baffles, like pressurized intermediate chambers, which block passage of gas, like oxidizing gas or metal complex, especially between the adsorption chamber 158 and the reactor 153, and preferably also towards the activation system 170. With the second control valve 189', the flow through the oxidizing fluid supply line 183 can be led through the second thermalizing reactor-vessel-by-pass-line 186' into the exhaust 499, for stabilization of a changed temperature or composition of oxidizing gas before the oxidizing gas is fed through the reactor 153.

As a further option, the shell structured solid catalyst material received through the shell structured solid catalyst feed valve 193 can be transported with a transportation system (not shown) to the solid material feed valve 192 and enter again the gas adsorption chamber 158 for a second impregnation cycle 445. Continuous, cyclic impregnation steps can be established until the shell structured catalyst material is released into the deposition device 196 and fresh activated particles 109 can enter the gas adsorption chamber for e. g. a pre-specified number of impregnation cycles. Each impregnation cycle increases the weight amount of metal within an outer shell of the solid metal particles 109.

A Fischer Tropsch catalyst based on cobalt and a respective cobalt carbonyl produced with an apparatus based on the scheme of figure 6 would suit a facility with an output of 20,000 bbl (barrel) of liquid hydrocarbon per day. The spherical alumina pellet of 3 mm can contain 15 % cobalt in a thin radial section of 0.2 mm. In this case, only 20 % of the pellet would be impregnated with cobalt. With a package density of the pellets of about 64 % of the total volume, the cobalt content is approximately 0.05 kg per 1 kg of solid catalyst material. The production capacity of the reactor can be up-scaled or downscaled. A high degree of catalytically active metal, like Co or Fe, can be produced within a shell. The shell can have a thickness of less that 300 µm. Based on e. g. porous Al₂O₃ pellet material, an efficient Fischer Tropsch catalyst can be produced. Control of transport restrictions in shell structures can improve removal of reactive olefins for best C₅₊, selectivity and energy efficiency. On the other hand, catalytically active sites in the shell structure are quickly accessible for reactants by diffusion. A very useful range of hydrocarbons, like paraffinic oils, between C₁₀ and C₂₀ can be catalyzed. Especially interconnection of chains can be limited.

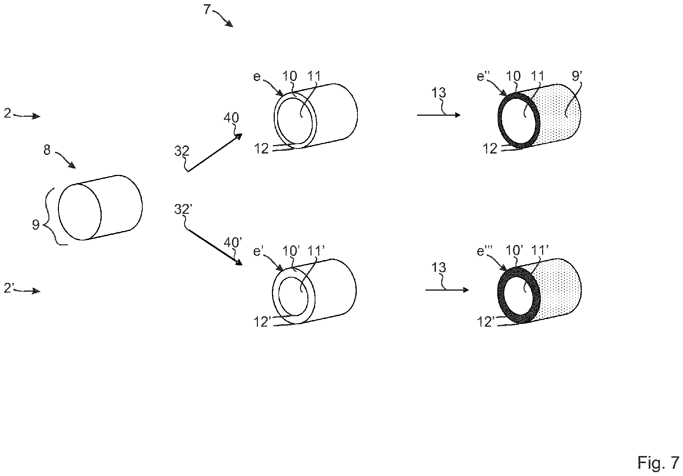

Figure 7 is a schematic illustration of production processes 2, 2' for shell structured catalyst material 7. Starting out from solid material particles, like the solid material particle 8 with the particle diameter 9, production process 2 applies an adsorption time 32 and a decomposition time 40, which lead to a content of metal species e within a first section 10. The first section 10 has a thickness 12, which can be described as a ratio of 17.5 % of the particle diameter 9. With repeated process steps 13, e. g. 8 times repetition, the first section 10 is enriched with metal, therefore includes in the pores, like pore 9', the metal species e". The second section 11, which is enclosed by the first section, remains without metal. Therefore after repeated steps 13, the shell structure, still comprises the shell section 10 with the thickness 12 and the inner section 11. In the production process 2', which is applied to the same pristine solid material particles, like the solid material particle 8 with the particle diameter 9, the shell structured catalyst material 7 is produced. The process applies adsorption time 32', which is the double of adsorption time 32, and decomposition time 40', which is the same duration like decomposition time 40. The first section 10' with the thickness 12' and the inner section 11' are formed. The thickness 12' is larger than the thickness 12. Expressed in terms of percentage of the particle diameter 9, however, it is less than 30 %. Due to longer adsorption time 32', the first section differs also in respect of metal species e'. After repeating production steps 13, the first section still has the diameter 12', though the metal species have changed to e'". Measurements for identification of species can e. g. be carried out by spectroscopy using synchrotron radiation. Further increase of the number of repeated production steps, starting out from repeated process steps 13, may even provide closed metallic film in the first section 10, 10' of the pores 9'.

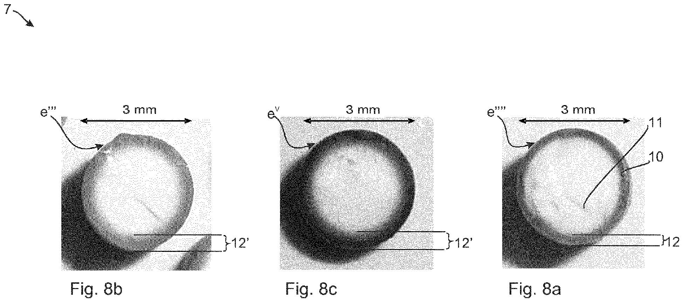

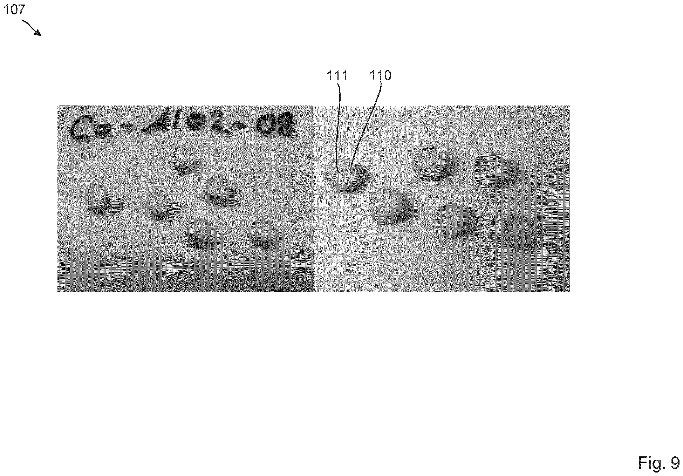

In figure 8 and figure 9, photos of different examples of shell structured solid catalyst material particles produced by using this invention are shown. The grey scale photos are optical microscopy images of cross-sections of cleaved pellets with a particle diameter of 3 mm.

The samples of figures 8a, 8b and 8c, are shell structured solid catalyst materials 7 produced from Al₂O₃ pellets, which can also be named extrudates, by using iron-pentacarbonyl. The iron-pentacarbonyl has a boiling temperature of 105 °C and a decomposition temperature of more than 130 °C. Decomposition temperature was never exceeded in the process. For the sample of figure 8a the process 2 of figure 7 has been used. The first section 10 with the thickness 12 and metal species e'''' and metal free inner section 11 are obtained by applying process steps for 15 times. One step of adsorption lasted 30 seconds. One step of oxidation lasted 60 seconds. The iron content measured with the ICP method was 2.86 wt% in a thickness of the shell structure of 250 µm. The samples of figures 8b and 8c have been produced according to process 2' of figure 7. The duration of one adsorption step was 60 seconds. The duration of one decomposition step was 60 seconds. Therefore the thickness of the first section 12' with metal species e'" and e^{V} is enlarged to 370 µm and 380 µm, respectively, which is approximately the same thickness. The process steps of the combination of adsorption and decomposition were applied for 8 times in Figure 8b giving an ICP iron content of 2.78 wt%, which is similar to the iron content obtained for the sample of figure 8a due to approximately the same cumulative adsorption time. After repeating steps with process 2' for 15 times, the sample of figure 8c was obtained, which has the same thickness of the first section 12' but with different metal species content e^{V}, which is visible as darker rim of the particle as compared to the metal e'" of figure 8b. The ICP measurement showed an iron content of 6.23 wt%, which again seems to be proportional to the cumulative adsorption time as compared to figures 8a and 8b. The rim resembles a ring in the cross-section by a geometric aspect. In one example of a shell structured solid catalyst material (not shown), iron content of 12.36 wt%, 2.43 wt%, 1.75 wt% and 1.25 wt% was measured within the shell structure by probing sections of approximately 100 nm diameter at distances from the outer surface of 0 µm, 200 µm, 500 µm and 700 µm, respectively, in a spatial sequence of measurements over a cross-section of a split solid catalyst material particle. The shell structure has an apparent thickness of about 900 µm. The metal distribution appears to decay exponentially as a function of diffusion distance, therefore metal is mainly concentrated in an outer shell of thickness 100 µm. Further measurements have shown that the metal is mainly inside the pores.

Figure 9 shows optical microscopy images obtained from shell structured solid catalyst material particles 107 produced using the same sort of Al₂O₃ pellets, as for figure 8, but with adsorption of cobalt tricarbonyl nitrosyl (Co(CO)₃NO). The cobalt tricarbonyl nitrosyl has a boiling temperature of 50 °C, a decomposition temperature slightly above 66 °C and a vapour pressure of 133,3 hPa at 25 °C. The shell structure 110 around the inner section 111 comprises cobalt. The number of different, arbitrarily selected, cleaved pellets shown confirms that shell structures for a sample of pellets can be produced homogeneously over a batch of pellets in a production process using an apparatus based on the concept of figure 5. Different production parameters were tried, a selection is shown in table 3.

**Table 3. Parameters for production of Co/Al₂O₃ Samples**

| Sample ID | Mass of Al₂O₃ pellet^{a} batch [g] | Number of steps adsorpt.^{b}/oxidation* | Time of adsorpt./oxidation [min/min] | O₂ conc. [vol%] | O₂/N₂ flow^{d} [l/min] | Mass gain [mg/g Al₂O₃]^{e} | ICP metal cont. [wt%] | Shell thickness^{f} [µm] |
|---|---|---|---|---|---|---|---|---|
| Co-AlO2-01 | 1.827 | 15/14 | 1/1 | 7 | 2.8 | 49 | 0.93 | -- |
| Co-AlO2-03 | 1.764 | 15/14 | 1/1 | 7 | 0.833 | 31 | 0.26 | -- |
| Co-AlO2-04 | 1.763 | 30/29 | 1/2 | 20 | 0.833 | 53 | 0.61 | -- |
| Co-AlO2-05 | 1.770 | 30/29 | 0.5/2 | 100 | 3 | 40 | 1.31 | -- |
| Co-AlO2-06 | 1.75 | 30/29 | 0.17/2 | 100 | 3 | 23 | 0.69 | grad. |
| Co-AlO2-08^{c} | 1.78 | 30/29 | 0.17/2 | 100 | 7 | 23 | 0.70 | 1000 |
| Co-AlO2-09 | 1.76 | 30/29 | 1/2 | 100 | 1 | 62.5 | 1.98 | -- |

| | | | | | | | | |
|---|---|---|---|---|---|---|---|---|
| a Activation of the Al₂O₃ pellets was carried out by heating the pellets to 300 °C and drawing a vacuum for 2 hours prior to production of the catalyst. b For adsorption, cobalt tricarbonyl nitrosyl vapour flow of 60mg/minute mixed with an argon carrier gas flow of 2 liters per minute was used in each step. c The oxidation gas for this sample was heated to 30 °C. After each oxidation step, the sample was purged with cold nitrogen for 3 min at 10 l/min flow to assure RT for the next impregnation. d After the last step of oxidation, further oxidation was performed for a significantly longer period (25 minutes to at least 24 hours) using O₂ concentration of at least 7 vol% to assure complete oxidation decomposition of the carbonyl. e Mass gain was determined after the final oxidation step. f No shell could be observed for samples marked with "--" for the solid catalyst material (pellets) of 3 mm diameter used; the term "grad" denotes that inspection of solid catalyst material produced showed a gradual decrease of metal content towards the centre of the solid material. Therefore the shell structures, which can be obtained under respective conditions, would have a thickness of at least 1.5 mm. | | | | | | | | |

Measurements obtained from sample "Co-AlO2-08" showed a shell structure with a shell thickness of 1000 µm comprising cobalt. Sample "Co-AlO2-06" was produced under the same adsorption conditions, but using a reduced flow of oxidizing gas, which results in a larger thickness of the shell structure. Therefore the oxidation time can be further controlled by flow and especially by concentration condition. More detailed investigation of production conditions has indicated that oxidation temperature may vary depending on seasonal fluctuations of room temperature. Oxidation carried out at temperature between 29 °C and 45 °C can affect speed of the reaction and also significantly affect diffusion of fluid in pores of the solid material. Therefore, by another aspect, oxidation time can also be combined with control of temperature of oxidizing gas.

When comparing the rate of reaction between cobalt tricarbonyl nitrosyl (Co(CO)₃NO) and iron-pentacarbonyl, one may state that iron-pentacarbonyl is more reactive than cobalt tricarbonyl nitrosyl. It may be said that cobalt tricarbonyl nitrosyl is sluggish in reaction.

In general, if impregnation by a reaction partner is desired, which is thought to be sluggish in reaction, control of temperature may be influential to the benefit or to the form of the shell-structure. To control the structure of the shell of the solid catalyst material, in dependency of the reactivity of the carbonyls temperature within the reactor, especially in the reactor vessel may be controlled.

In certain circumstances or due to chosen metal complex or chosen carbonyl, it may be advisable to reduce the temperature in the reactor vessel a decimal multiple from the boiling temperature of the metal complex or the carbonyl. For example, for cobalt tricarbonyl nitrosyl (CO(CO)₃NO) it may be advisable to reduce the temperature within the reactor close to or even below 0 °C. The adsorption process may be carried out while the overall temperature, especially next to the wall of the reactor vessel is around 0 °C. When stepped into the oxidation process, the temperature may be augmented instantaneously. An increase in temperature at the beginning of oxidation several times a value of ten degrees like x times 10 °C (where x is an integer) may be helpful. The yield of the process may be even enhanced by using a high rate of flow of oxidation. Looking at table 3, some flow rate of more than 7 I/min for a pellet batch of 1,7 gramms (or even more) may be considered a high flow rate. The high flow rate will contribute to the effect of removing carbonyls not used during adsorption. An exact control of time of each process step will further improve the structure and uniformity of the shell structured solid catalyst material. A process based on time intervals of seconds for adsorption and/or decomposition (instead of entire minutes for each step) may contribute to a high quality of product.

By yet another aspect, the exothermal oxidation reaction can set a start temperature of the solid material for a subsequent adsorption step. Diffusion was kept under control by using a thermalizing reactor-vessel-by-pass line in combination with a cooler for the fluid. The time interval for purging steps, which are applied for removal of e. g. metal carbonyl, and which can to some extent stretch diffusion, could be set particularly short, especially shorter than the adsorption time. The time interval for purging, on the other hand, may to some extent depend on the time required for establishing a temperature in the solid material through a temperature of the purging fluid in preparation for a following process step.

By yet another aspect, the diffusion depth of the metal complex or the carbonyls in the solid material may be controlled by the time regime.

Further, from the presented data it is seen that the time interval for purging can be reduced due to an improved control over temperature of the fluid used for the adsorption step and temperature of fluid used for the oxidation step. By keeping good control over diffusion, a pre-specified thickness of the shell structure can be produced.

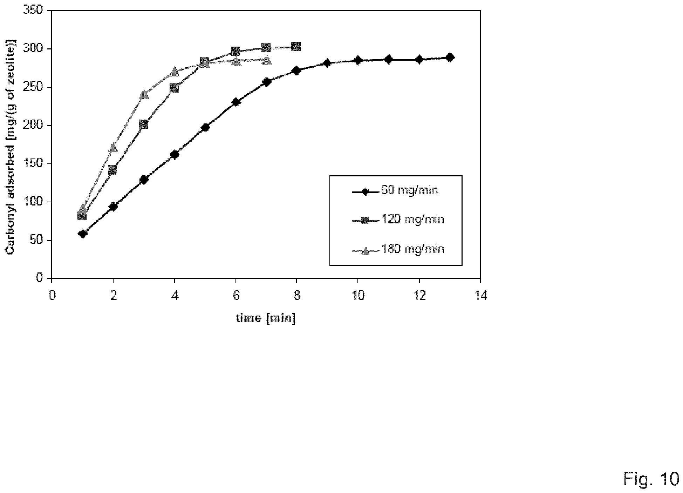

Further studies provide additional evidence of control over shell structured solid catalyst material production through selected parameters of production conditions. Figure 10 shows three curves for three different flow conditions of iron carbonyl over a zeolite sample. The diamond symbol indicates measurements with a flow of 60 mg per minute, the square symbol indicates a flow of 120 mg per minute and the triangle symbol indicates a flow of 180 mg per minute. The measurements are shown as a function of exposure time on a scale of up to 14 minutes. For the concentration of 60 mg per minute, there is a linear increase in the amount of carbonyl adsorbed after a given time up to a time of about 7 minutes. For longer time the amount of adsorbed carbonyl remains constant. A similar behaviour was obtained for the flow of 120 mg per minute, where the saturation effect of adsorption is reached already after less than 5 minutes. With 180 mg per minute, the saturation in iron carbonyl absorption occurs after about 3 minutes. Within the linear increase of adsorption, the amount of iron carbonyl adsorbed in the zeolite sample can be well controlled therefore providing an exact means for depositing a pre-defined amount of iron within a shell structure on the inner surface of a solid material like zeolite. Therefore it is possible to adhere to an upper limit for a cumulative adsorption time that is the sum over all adsorption steps, e. g. up to saturation adsorption within a shell structure.

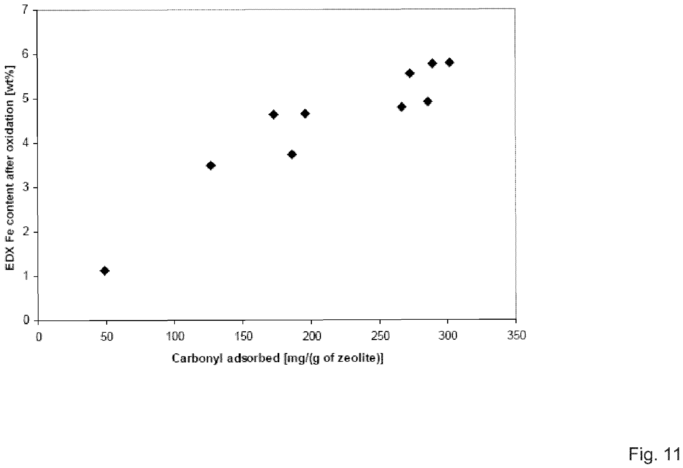

Figure 11 gives some additional evidence for the good control over solid catalyst materials produced with the production method and the reliability of the apparatus for control of production parameters. Measurements from a number of different samples produced are compared. Adsorption conditions of iron carbonyl were changed in order to control the amount of adsorbed metal carbonyl on the surface of the zeolite particles. The amount of adsorbed iron carbonyl was measured with a balance. The iron content after the decomposition step with oxidizing gas was measured with the EDX method, namely the energy dispersion of X-rays generated by electron impact. When the amount of iron carbonyl adsorbed to the zeolite is doubled also the iron content produced by oxidative decomposition of the iron carbonyl is doubled, which means that desorption of iron carbonyl in the decomposition step is negligible.

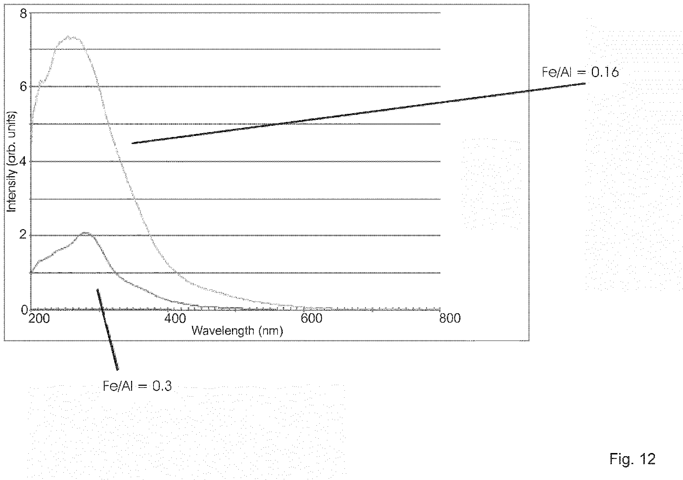

Another aspect of the good quality of the solid catalyst material produced is illustrated in figure 12. UV-vis adsorption spectra were measured for three samples. First the pristine activated zeolite was measured giving a baseline signal. The spectrum measured for a ratio of iron (Fe) / aluminium (Al) of 0.16, which is a low content of iron, has a maximum at around 260 nm wavelength and a rather steep decline towards longer wavelengths. The spectrum can be attributed to a presence of a high density of monomeric and dimeric species of metal in the solid catalyst material. Another optical spectrum measured for a sample of solid catalyst material using the same type of zeolite but a double content of iron with a ratio of Fe/AI of 0.3. The spectrum shows several differences compared with the lower iron content. The maximum adsorption in the spectrum appears to be slightly shifted towards longer wavelengths by about 10 nm. A shoulder between wavelengths of 330 nm and 450 nm can be identified in the spectrum. These spectral differences can be attributed to the presence of oligomer particles of iron, which is due to the higher content of iron. The conclusions are based on simulations of optical spectra.

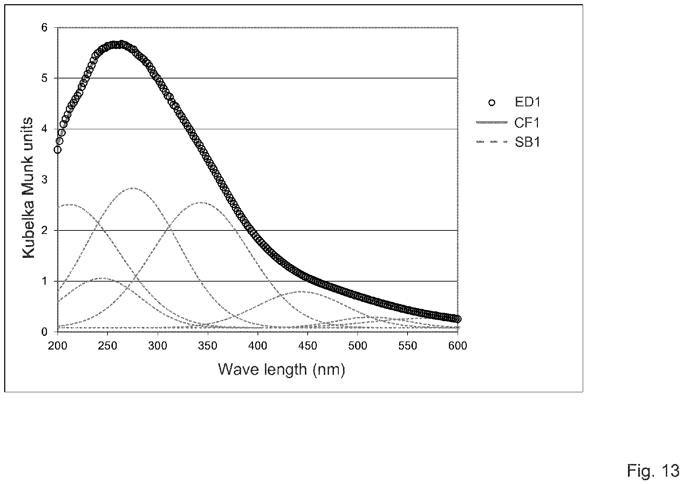

Figure 13 shows experimental data from diffuse reflectance spectroscopy (DRS) of a zeolite based catalyst. The data ED1 are presented in standard Kubelka Munk transformation, based on approximations due to the Kubelka Munk theory. Solid catalyst material produced using this invention, having 5.43 % iron on zeolite as compared to 100 % of the total weight of the solid catalyst material, was used for the measurement. The dotted lines show sub-bands SB1 related to optical transitions of iron containing species, which contribute to the spectroscopic signal. The peaks were optimised in order to obtain a best cumulative fit CF1 curve following the experimental data points. The different sub-bands SB1 are located at 212 nm, 244 nm, 275 nm, 343 nm, 444 nm 514 nm and 568 nm. Sub-bands below a wavelength of 280 nm in the spectrum are typically attributed to monomeric Fe³⁺ ionic species of single iron. Sub-bands in the wavelength region between 280 nm and 400 nm are typically assigned to a mixture of Feₓ³⁺O_{y} oligomers, whereas the values of Kubelka Munk intensity at wavelengths higher than 400 nm are caused by Fe₂O₃ cluster particles. The evaluation of the peak area gave a distribution of 63 % monomeric Fe³⁺, 26 % oligomers and only 11 % cluster particles of a total of 100 % particles measured with UV-vis diffuse reflectance spectroscopy.

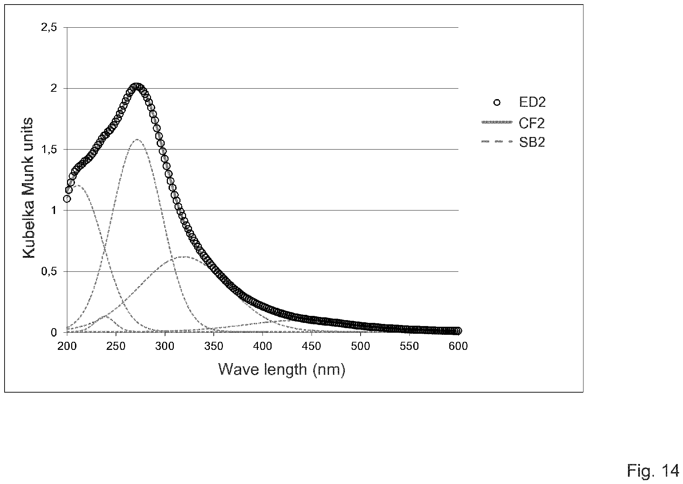

Another example of diffuse reflectance spectroscopy is shown in figure 14. The 100 weight % solid catalyst material had only 1.61 weight % iron on zeolite. This material was produced with a similar method compared to the sample measured in figure 13. Figure 14 shows Kubelka Munk transformed experimental data ED2 as circles, the best cumulative fit CF2 curve as solid line and the different sub-bands SB2 in broken lines. The peaks of the sub-bands are located at 211 nm, 239 nm, 272 nm, 319 nm and 438 nm, respectively. The evaluation of the peak area gave a distribution of 69 % monomeric Fe³⁺, 26 % oligomers and only 5 % cluster particles of a total of 100 % particles measured with UV-vis diffuse reflectance spectroscopy.

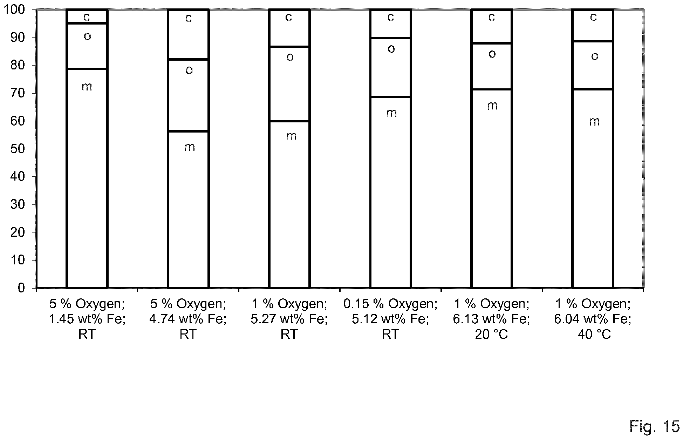

The effect of selected process parameters for oxidation of iron-pentacarbonyl impregnated zeolite is further analyzed with examples of samples specified in particular by production conditions in table 4 and respective results of monomeric species summarized in figure 15. The samples show that good control over oxidation conditions is available and thus production of tailored catalyst material can be facilitated. For all samples of table 4, Iron-pentacarbonyl was evaporated at 90 °C. The vapour was mixed with carrier gas argon in an evaporation device, combined with a mixing device. A controller for evaporation temperature and for gas flow was used to provide stable conditions for moiety flow. As listed in table 4, all measured samples showed that all monomeric species of iron exceed the oligomeric species of iron on the zeolite. These results are obtained using the analytic method described in the context of figure 13, namely based on diffuse reflectance spectroscopy (DRS) of the zeolite based catalyst material and algorithmic fit of subbands for different iron species to the spectra. A set of samples (Imp/ZeoS-26, Imp/ZeoS-31, Imp/ZeoS-19) was prepared with a Fe-carbonyl (abbreviation for iron-pentacarbonyl) flow of mainly 180 mg per minute and an impregnation time of at least 7 minutes, to allow for saturation of the zeolite with the moiety. These samples, prepared under comparable conditions for adsorption, were oxidized with different concentration of 5%, 1 % and 0.15 % oxygen in nitrogen. According to EDX analysis, the Fe content of the samples after oxidation was approximately about 5 weight % (see table 4 for exact values). Results given in table 4 and in figure 15 show that using 5 % oxygen in nitrogen produces a significantly lower relative amount of monomeric iron m than using lower concentrations, e. g. 0.15 % oxygen in nitrogen. Therefore the mixture of the oxidizing gas can be used, as shown in figure 15, in order to control the amount of monomeric species m produced on zeolite relative to small oligomeric species o and small clusters c. Small oligomeric species and small clusters can be summarized under the term oligomeric species. Experiments were also carried out with a set of three samples (Imp/ZeoS-27, Imp/ZeoS-32, Imp/ZeoS-18) using a Fe-carbonyl (i. e. iron-pentacarbonyl) flow of 60 mg/min with impregnation time of about 1.5 minutes (see table 4 for exact values). The results show that oxidation carried out at the same conditions like aforementioned samples, namely with respective concentration of 5 %, 1 % and 0.15 % oxygen in nitrogen, is not significantly affecting the relative amount of monomeric species compared to all oligomeric species, presumably due to lower surface density of iron-pentacarbonyl present on the zeolite after the step of adsorption. Only about 1.4 weight % of iron (see table 4 for exact values) was measured for these samples with the EDX analysis. In addition, the samples with about 1.4 weight % of iron show a tendency for a ratio with more monomeric species as compared to the ratios of the samples with approximately 5 weight % of iron. The samples Imp/ZeoS-45 and Imp/ZeoS-46 of table 4 indicate good reproducibility of experimental data. The samples were different from the previously described sets of samples in terms of batch of commercial zeolite used. The temperatures of 20 °C and 40 °C for respective samples Imp/ZeoS-45 and Imp/ZeoS-46 were measured inside the reactor during oxidation. The temperature difference has apparently no measureable effect on the presence of monomeric species. Nevertheless it could be expected under an aspect of mobility that the higher the temperature the more pronounced is a depletion of monomeric species. On the other hand, for high temperatures, especially temperatures above the Tammann temperature, breaking up of oligomeric species could occur.

**Table 4. Solid catalyst material produced for different oxygen concentrations and different temperatures using iron-pentacarbonyl and zeolite**

| Sample ID^{f} | Amount of activated zeolite^{a} [g] | Fe-carbonyl flow^{b} [mg/min] | Impregnation time [min] | Adsorbed Carbonyl [mg/(g of zeolite)] | O₂ for oxidation [% in N₂] | Weight gain [mg] | EDX Fe content after oxidation^{b} [wt%] | Monomeric species [% of all Fe species] |
|---|---|---|---|---|---|---|---|---|
| Imp/ZeoS-26 | 1.85 | 180 | 7 | 339 | 5^{c} | 627.2 | 4.74 | 56 |
| Imp/ZeoS-27 | 1.89 | 60 | 1.5 | 71 | 5^{c} | 133 | 1.45 | 78 |
| Imp/ZeoS-31 | 1.84 | 180 | 14 | 324 | 1^{c} | 595 | 5.27 | 60 |
| Imp/ZeoS-32 | 1.85 | 60 | 1.5 | 72 | 1^{c} | 133.5 | 1.39 | 80 |
| Imp/ZeoS-19 | 1.85 | 60 | 7 | 222 | 0.15^{c} | 410.6 | 5.12 | 68 |
| Imp/ZeoS-18 | 1.87 | 60 | 2 | 62 | 0.15^{c} | 115.3 | 1.32 | >72 |
| Imp/ZeoS-45 | 1.79 | 180 | 8 | 275 | 1^{d} | 575 | 6.04 | 72 |
| Imp/ZeoS-46 | 1.79 | 180 | 8 | 275 | 1^{e} | 575 | 6.13 | 71 |

| | | | | | | | | |
|---|---|---|---|---|---|---|---|---|
| a Activation of BEA-zeolite was carried out by keeping the zeolite under vacuum at 180 °C for 18 h. Before starting impregnation and oxidation, the zeolite samples were kept in a flow of 2 to 3 l/min nitrogen for at least two minutes of purging. b Argon flow (carrier gas) for feeding the carbonyl of 2 l/min. c Oxidation carried out at room temperature with a flow of oxidizing gas, oxygen in nitrogen, of 0.833 l/min. d Oxidation carried out at 20 °C with gas flow specified in "^{c}", and with oxidizing gas cooled through a metallic coil in ice water. e Oxidation carried out at 40 °C with gas flow specified in "^{c}" and with oxidizing gas heated through a metallic coil in temperature controlled thermo-oil. f All samples were prepared using a reactor of 100 ml internal volume with an operating shaking device. | | | | | | | | |

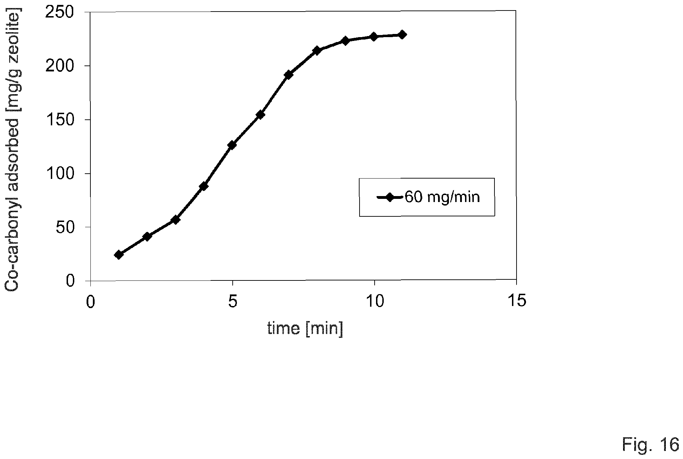

In another set of experiments, impregnation of BEA-zeolite, the same zeolite that was used with iron-pentacarbonyl, was carried out with the moiety cobalt tricarbonyl nitrosyl. A temperature of 52 °C was used for evaporation. Figure 16 shows the adsorbed amount of "Co-carbonyl", short for cobalt tricarbonyl nitrosyl. The adsorbed mass of cobalt on zeolite was measured using a balance similar to the data shown in figure 10. The flow of the moiety was kept constant at 60 mg/minute during the time of exposure of zeolite. The adsorption was studied over a time of about 11 minutes. In about the first eight minutes, the relative adsorbed amount of cobalt tricarbonyl nitrosyl on zeolite increases linearly up to 220 mg/g zeolite. This phase of the process of adsorption can also be named the phase of coverage increase. For longer exposure time than eight minutes, the adsorbed carbonyl remains almost constant. The process of adsorption is in a phase of saturation. By not entering the phase of saturation, e. g. by using a shorter time than eight minutes or by using a lower flow of moiety than 60 mg/minute, the process of adsorption can be carried out more efficiently. Also fine tuning of the amount of cobalt moiety adsorbed on zeolite can be carried out. Fine tuning is particularly useful when impregnation is carried out in a sequence of process steps, comprising a sequence of adsorption step and oxidation step, which can be repeated. By repeating an adsorption step, adsorption time intervals add up to a total adsorption time. Control of dosing ratios or deposition ratios, also of two or more different metals, is possible with good accuracy in the range of the linearly increasing dependence of adsorbed moiety on adsorption time in the early phase of adsorption.

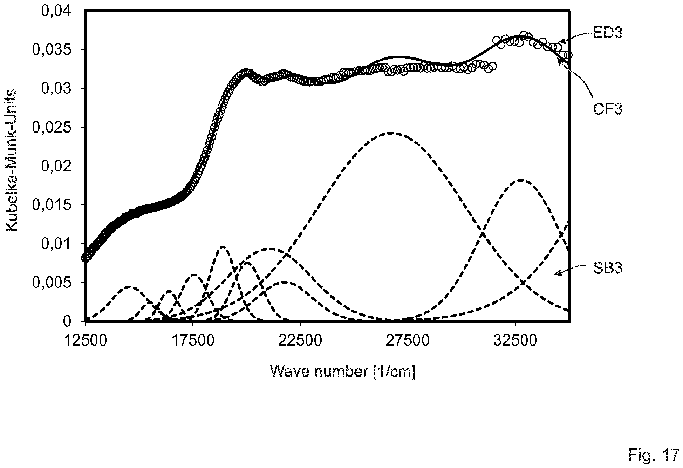

Furthermore, the effect of different process parameters for oxidation of cobalt tricarbonyl nitrosyl impregnated zeolite was analyzed. Evidence is given by examples of table 5 and results from figures 17 to 21 that good control over oxidation conditions facilitates production of tailored catalyst material based on cobalt. The process can also be applied for preparation of shell structured zeolite and for deposition of other metals like nickel, and combinations of different metals, when some minor adjustments are taken care of.

**Table 5. Solid catalyst material produced using cobalt tricarbonyl nitrosyl and zeolite for different oxidation conditions.**

| Sample ID^{e} | Amount of activated zeolite^{a} [g] | Impregnation time^{b} [min] | Oxidation temp. [°C] | Oxygen/Nitrogen ratio [%/%] | Oxidation flow [l/min] | Weight gain [mg] | EDX Co-content after oxidation^{b} [wt%] | Monomer species [% of all Co species] |
|---|---|---|---|---|---|---|---|---|
| Co-Zeo1-01 | 1.84 | 19 | 20^{d} | 20/80 | 0.833 | 419 | 1.2 | >59 |
| Co-Zeo1-02 | 1.74 | 15 | 20^{d} | 50/50 | 1.873 | 394 | 3.4 | >45 |
| Co-Zeo1-08 | 1.8 | 15 | ⁻45^{c} | 100/0 | 3 | 460 | 4.4 | >34 |
| Co-Zeo1-10 | 1.81 | 15 | ∼35^{c} | 100/0 | 1 | 500 | 5.1 | >34 |

| | | | | | | | | |
|---|---|---|---|---|---|---|---|---|
| a Activation of BEA-zeolite was carried out by keeping the zeolite under vacuum at 180 °C for 18 h. Before starting impregnation and oxidation, the zeolite samples were kept in a flow of 2 to 3 l/min nitrogen for purging for at least two minutes. b A flow of 60 [mg/min] Co-carbonyl was used in a carrier gas flow of 2 [l/min] argon at room temperature. c Temperatures are final temperatures measured by thermocouple in the reactor after 10 minutes of oxidation. The oxidizing gas was heated by a heating tube at 160°C for Co-Zeo1-08 and 200 °C for Co-Zeo1-10. d Room temperature, no additional temperature control. e The reactor was the same as the reactor for measurements of table II with shaking device in operation. | | | | | | | | |

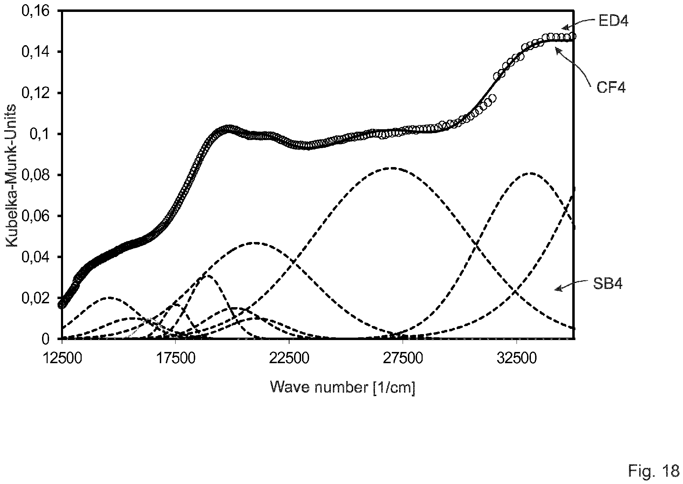

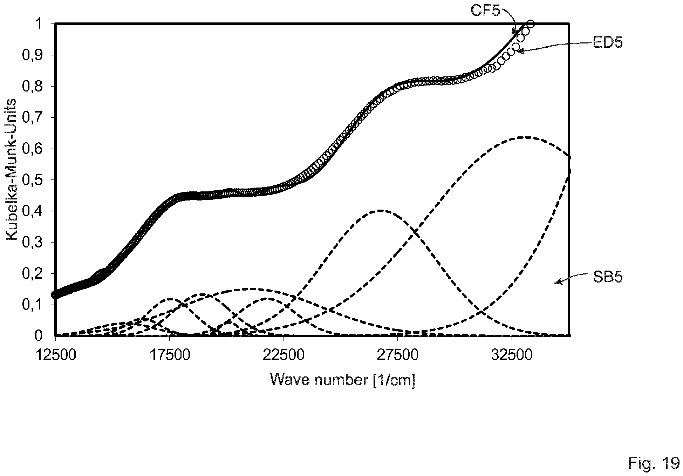

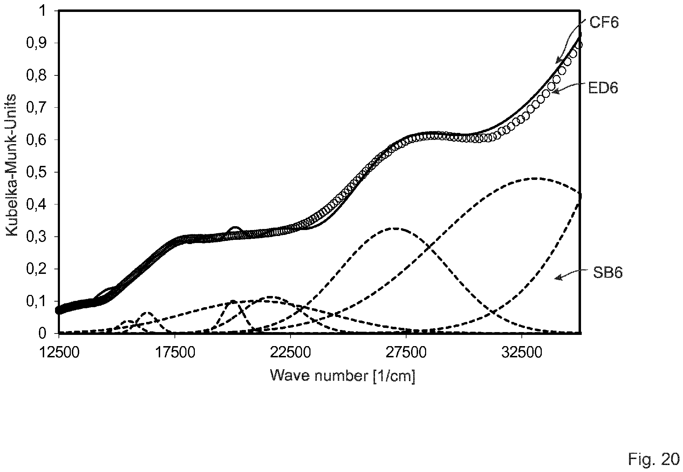

Figures 17 to 20, which are discussed together, show examples of diffuse reflectance spectroscopy for cobalt zeolite. The spectra of figures 17, 18, 19 and 20 are Kubelka Munk transformed experimental data on an energy scale represented by wavenumbers. The spectra give proof of the presence of monomeric species based on known, published spectroscopic information. By means of curve fits to the spectra an analysis for an estimate of the ratio of monomeric and oligomeric cobalt species can be carried out. The sample in figure 17 has 1.2 weight % cobalt, in figure 18 3.4 weight % cobalt, in figure 19 4.4 weight % cobalt and in figure 20 5.1 weight % cobalt, according to EDX measurement, in relation to the total weight of the respective zeolite based material. The respective samples were produced according to specifications of table 5. The materials are produced with a similar method compared to the samples measured for figure 16. In detail of figures 17 to 20, experimental data ED3, ED4, ED5, ED6 are shown as circles, the best cumulative fit CF3, CF4, CF5, CF6 curve is shown as solid line and the different sub-bands SB3, SB4, SB5, SB6 are shown as broken lines. According to J. Dědeček et al., Journal of Catalysis 211, p. 198 to p. 207 (2002) the peaks of the sub-bands for d-d transitions are energetically located for α - site Co at 14600 cm⁻¹, for β - site Co at 15500, 16300, 17570 and 21700 cm⁻¹ , γ - site Co at 18900 and 20100 cm⁻¹, where α, β, and γ sites bind a zeolite-coordinated bare Co(II) ion, and for charge transfer (CT) transitions, at 27000 cm⁻¹ (for the oxygen-Co(III) transition), 21000, 31000 to 33100 cm⁻¹ (for Co-O2-Co complexes), and 39000 to 42000 cm⁻¹ (for oxygen-Co(II) transitions). The oxygen bridged Co-O₂-Co complex and the charge transfer species are interpreted as "oligomeric" species. Species named monomeric are monomeric in respect of bonds to other metal monomers, even though such monomeric species can still bind oxygen or a different type of metal. The spectral contribution in the energetic range of charge transfer bands in figures 17, 18, 19, and 20 are on the high wavenumber side of the spectra at more than 22000 cm⁻¹. These spectral contributions can be attributed to oligomeric species and appear to be quite significant, and relatively stronger in figures 19 and 20 than in figures 17 and 18, as compared to spectral intensity in the wavenumber region below about 20000 cm⁻¹, which are attributed to monomeric species. It is therefore important to note that the extinction coefficient for the charge transfer transition bands is typically at least 10 to 1000 times higher than respective coefficients for d-d bands of the monomeric species in the visible region. Therefore such species appear with an overweight in the spectra of figures 17 to 20 at the low energy side, as represented by large wavenumbers.

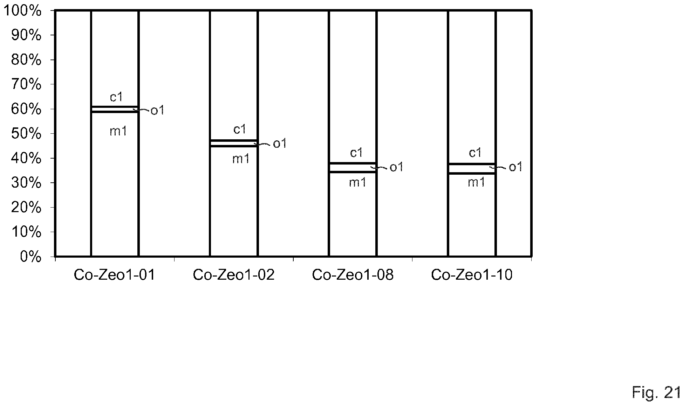

In figure 21, results from figures 17 to 20 are summarized. The samples are characterized in table 5, which shows respective production conditions for each sample. The estimate for the relative amount of monomeric and oligomeric species shown in figure 21 is based on information on extinction coefficients in the article of J. Dědeček et al., Journal of Catalysis 211, p. 198 to p. 207 (2002) using the highest extinction coefficient which could be attributed to charge transfer species based on an average extinction coefficient for monomeric species. Therefore, the contribution of oligomeric species in the spectra is presumably still overestimated by the evaluation shown in figure 21. Nevertheless, even with this conservative approach, which can be refined with more accurately measured extinction coefficients, the evaluation of figure 17, for the sample Co-Zeo1-01 proofs that by 59 % more monomers m1 than oligomers o1, c1 are produced on the zeolite by the process of this invention. With the assumption of a higher extinction coefficient for oligomeric charge transfer species c1, e. g. an extinction coefficient of the size of the oxygen bridged dimeric species Co-O-Co o1, the contribution of monomeric species m1 for the other samples than Co-Zeo1-01 of figure 21 could actually be well over 50 %. Still, it is noteworthy that the sample Co-Zeo1-02, which was produced with moiety adsorption under similar conditions like sample Co-Zeo1-01, leads to a higher EDX content of metal after oxidation, as shown in table 5, and a lower relative amount of monomeric species. This effect is due to different oxidation condition, namely a higher percentage of oxygen in the oxidizing gas and a higher flow of oxidizing gas. In other words, a flow controller or also a gas mixing stage can be applied to tune the relative amount of monomeric species over oligomeric species of metal on zeolite. In addition, results from sample Co-Zeo1-08 and sample Co-Zeo1-10 indicate that small variations of temperature on the scale of a few tens of °C for the oxidizing gas have only little effect on the presence of monomeric cobalt. The temperature was controlled by pre-heating the oxidizing gas. The relative amount of Co-O-Co o1 compared to the monomeric species m1 for sample Co-Zeo1-08 and also for sample Co-Zeo1-10 is higher than for samples Co-Zeo1-01 or Co-Zeo1-02 which can be attributed to the use of pure oxygen as oxidizing gas.

Further samples have been produced on basis of vanadium, molybdenum, chromium and platinum. Similar conditions like for samples presented in tables 1 to 5 can be applied. Proof of exact ratios of monomeric species versus all other oligomeric species is more difficult, in particular in terms of exact numbers and extinction coefficients.

Further preliminary tests have shown, that monomeric metal species can also be obtained by impregnation of Y- zeolite based solid material, like M₅₆Y, M being H, Li, Na, K, Rb or Cs of the periodic table of elements, by W(CO)₆ (tungsten carbonyl) or Mo(CO)₆. The carbonyl species are transformed into intrazeolite metal oxides by oxidation in an O₂ atmosphere. For Na and smaller M-species, presence of monomeric metal in the zeolite pores depends on the degree of impregnation. Also zeolite-supported Re material could be produced, using different zeolites like H-ZSM-5, H-Beta, H-USY and H-Mordenite, each zeolite impregnated with the organometallic compound methyl trioxorhenium, which is decomposed and transformed into monomeric metal species by oxidation. Monomeric species of metal on zeolite material can also be generated from TiCl₄ moiety, which was used for impregnation of H-ZSM-5 zeolite and treated with oxygen containing gas in the presence of water vapour at an elevated temperature between 500°C and 600°C. By this process, monomeric species of titanium, TiO₄, can be obtained on the zeolite surface.

**Reference signs**

| Reference Numeral | Significance |
|---|---|
| 2, 2', 102, 202, 302 | Production process, especially for shell structured solid catalyst material |
| 3, 103, 203, 303 | Activation step |
| 4, 4', 104, 204, 204', 304, 304' | Adsorption step |
| 5, 5', 105, 205, 305, 305' | Decomposition step |
| 6, 106, 106' | Homogenisation step |
| 7, 107, 207, 307, 307' | Shell structured solid catalyst material, especially shell structured solid catalyst particle |
| 8, 8', 108, 108', 208, 208', 308, 308', 308" | Solid material, especially zeolite |
| 9, 109 | Particle, especially particle diameter |
| 9' | Pore |
| 10, 10', 110 | First section, especially shell section |
| 11, 11', 111 | Second section, especially inner section |
| 12, 12' | Thickness of the first section |
| 13, 113, 213, 313, 313' | Additional process step, especially repeated process step |
| 114 | Decomposition time |
| 15, 15', 115, 115', 215, 315 | Metal complex |
| 16 | Support |
| 17, 17', 117, 217, 317 | Oxidizing gas |
| 18, 18', 118, 218, 318 | First carrier gas |
| 19, 19', 119, 219, 319 | Second carrier gas |
| 20 | Sensor, especially temperature sensor |
| 21 | First port |
| 21' | Second port |
| 21" | Third port |
| 22 | Replenishment control valve |
| 123, 223, 223', 323, 323' | Concentration of a first metal complex |
| 124 | Concentration of a second metal complex |
| 25, 25', 125, 125' | Gas flow, especially flow of a carrier gas |
| 26, 126 | Vapour flow, especially flow of metal complex |
| 27 | First temporal switchpoint |
| 27' | Second temporal switchpoint |
| 27" | Third temporal switchpoint |
| 28, 28', 28", 128, 128' | Gas pressure |
| 29, 129, 229, 329 | Vapour partial pressure, especially partial pressure of metal complex |
| 30, 30', 130, 130' | Temperature of a gas |
| 31, 131,231 | Duration of activation, especially activation time |
| 32, 32', 132, 232, 332, 332' | Duration of vapour flow, especially adsorption time |
| 33, 133, 233, 333 | Decomposition gas |
| 34, 134 | Oxidizing gas concentration |
| 35, 135 | Oxidizing gas composition |
| 36, 136 | Oxidizing gas flow |
| 37, 137, 237, 337 | Oxidizing gas partial pressure |
| 38, 138 | Temperature of the oxidizing gas |
| 39, 39', 139, 139' | Temperature of the shell structured solid catalyst material, especially Temperature of the solid material |
| 40, 40',140 | Duration of the oxidizing gas flow, especially decomposition time |
| 41, 41', 141, 141' | Counter and control for delayed process step alternation |
| 42 | Batch of solid material |
| 143, 143', 143 ", 243, 343, 343', 443 | Flow of solid material |
| 44, 144, 244, 344 | First impregnation cycle |
| 45, 245, 345, 445 | Second impregnation cycle |
| 46 | Gas flow thermalizing step |
| 47, 47', 47" | Through-flow fluid heat exchanger, especially through-flow heater |
| 48, 48', 48" | Through-flow fluid heat exchanger, especially through-flow cooler |
| 149 | Cross-flow configuration |
| 50, 150 | Apparatus |
| 51 | Process control unit |
| 51' | Electronic communication interface |
| 52 | Control line |
| 53, 153 | Reactor |
| 55, 155 | Reactor vessel |
| 56, 156 | First end, especially fluid feeder |
| 57 | Second end |
| 58, 158 | Gas adsorption chamber, especially vessel |
| 59 | Gas feeding filter |
| 60 | Gas exit filter |
| 61 | Pores of the filter |
| 62, 162 | Decomposition chamber |
| 63, 163 | Gas mixing stage |
| 64 | Vaporizer-mixer |
| 65 | Thermostat oxidizing gas mixer, especially through-flow gas heater |
| 66 | First gas source, especially carrier gas |
| 67 | Second gas source, especially oxidizing gas |
| 68, 168 | Metal complex source, especially carbonyl gas generator |
| 69, 169 | Feeding device |
| 70, 170 | Activation system |
| 71 | Cooler |
| 72 | Heater |
| 73, 73', 73" | Flow meter, especially gas flow meter |
| 74, 74', 74" | Flow controller, especially gas flow controller |
| 75 | Gas flow direction |
| 176 | Feed control valve |
| 77, 177, 277, 377 | Waste material processing system, especially washing of gas |
| 78 | timer |
| 78' | counter |
| 79 | Vacuum pump |
| 80, 180, 180' | Agitator |
| 81 | Gas circulation system |
| 82 | Gas pump |
| 83, 183 | Oxidizing gas supply-line |
| 84, 184 | Metal complex gas supply-line |
| 85 | Circulation line |
| 86, 186 | First thermalizing reactor-vessel-by-pass line |
| 86', 186' | Second thermalizing reactor-vessel-by-pass line |
| 86" | Third thermalizing reactor-vessel-by-pass line |
| 87, 187, 187' | Exit line |
| 88 | Mixing valve |
| 89, 189 | First control valve, especially feed valve for metal complex |
| 89', 189' | Second control valve, especially oxidation fluid feed valve |
| 90 | Third control valve, especially circulation control valve |
| 91 | Fourth control valve, especially exit and circulation control valve |
| 92, 192 | Fifth control valve, especially solid material feed valve |
| 93, 193 | Sixth control valve, especially shell structured solid catalyst feed valve |
| 94, 94', 194, 194', 294, 394, 394' | Transportation system, especially transport of shell structured solid catalyst material |
| 95 | Processing stage |
| 96, 196 | Deposition device, especially deposition |
| 97, 197, 297, 397, 397' | Separation stage, especially cyclonic separation |
| 98, 198,298 | Liquid waste disposal |
| 99, 199, 299, 499 | Exhaust |
| | |
| ED1, ED2, ED3, ED4, ED5, ED6 | Transformed experimental data |
| CF1, CF2, CF3, CF4, CF5, CF6 | Cumulative fit to experiment |
| SB1, SB2, SB3, SB4, SB5, SB6 | Sub-bands |
| e, e', e", e''', e'''', e^{V} | Metal species |
| m, m1 | Monomer metal species |
| o | Small oligomer metal species |
| c | Large oligomer metal species, especially cluster |
| o1 | Oxygen bridged metal species |
| c1 | Oligomeric species, especially charge transfer species |

## Claims

1. Production process (2, 102, 202, 302) of a shell structured solid catalyst material (7, 107,207,307,307')
using a solid material (8, 8', 108, 108', 208, 208', 308, 308', 308"),
having at least one pore (9') or at least one cavity,
like a mesoporous silica based material, a zeolite, a metallic foam, an alumina or titania based material, an activated carbon or a structured surface area carbon material such as expanded graphite, nano graphite, graphene or a graphene layer structure,
which is exposed to a metal complex (15, 15', 115, 115', 215, 315) provided in a gaseous phase or a vapour phase, like metal carbonyl molecules or metal organic compounds, entering the pore (9') or cavity,
wherein the solid material (8, 8', 108, 108', 208, 208', 308, 308', 308") is impregnated with metal by production process steps of the following kind:
- adsorption of the metal complex (15, 15', 115, 115', 215, 315) in the pore (9') or in the cavity of the solid material (8, 8', 108, 108', 208, 208', 308, 308', 308"), and
- decomposition of the metal complex (15, 15', 115, 115', 215, 315),
**characterized in that**
adsorption of the metal complex (15, 15', 115, 115', 215, 315) is controlled by an adsorption time (32, 32', 132, 232, 332, 332') of metal complex (15, 15', 115, 115', 215, 315) exposed to the solid material (8, 8', 108, 108', 208, 208', 308, 308', 308") such that metal complex (15, 15', 115, 115', 215, 315) is bond to a surface of the solid material (8, 8', 108, 108', 208, 208', 308, 308', 308") in a first section (10, 10', 110) along the pore (9') or the cavity, and
the first section is continued by a second section (11, 11', 111), along the pore (9') or the cavity, and
decomposition is carried out by means of oxidation due to exposure of metal complex (15, 15', 115, 115', 215, 315) to oxidizing gas (17, 17', 117, 217, 317), like air, oxygen or a halogen, entering the pore (9') or cavity,
whereby metal from the metal complex (15, 15', 115, 115', 215, 315) is attached to the surface of the solid material (8, 8', 108, 108', 208, 208', 308, 308', 308") in the first section (10, 10', 110) and the second section (11, 11', 111) stays free of metal from metal complex (15, 15', 115, 115', 215, 315).

2. Production process (2, 102, 202, 302) of a shell structured solid catalyst material (7, 107, 207, 307, 307') in accordance with claim 1, further **characterized in that** a weight amount of metal in the first section (10, 10', 110) of the solid catalyst material (7, 107, 207, 307, 307') is increased through at least one additional process step comprising adsorption of the metal complex (15, 15', 115, 115', 215, 315).

3. Production process (2, 102, 202, 302) of a shell structured solid catalyst material (7, 107, 207, 307, 307') in accordance with claim 1 or claim 2, further **characterized in that**
a thickness (12, 12') of the first section (10, 10', 110) is controlled by the adsorption time (32, 32', 132, 232, 332, 332').

4. Production process (2, 102, 202, 302) of a shell structured solid catalyst material (7, 107, 207, 307, 307') in accordance with any one of the preceding claims, further
**characterized in that**
adsorption of the metal complex (15, 15', 115, 115', 215, 315) is controlled by a time interval of a flow (32, 132, 232, 332, 332') of the metal complex (15, 15', 115, 115', 215, 315).

5. Production process (2, 102, 202, 302) of a shell structured solid catalyst material (7, 107, 207, 307, 307') in accordance with any one of the preceding claims, further
**characterized in that**
decomposition of metal complex (15, 15', 115, 115', 215, 315) is controlled by a time interval of exposure to an oxidizing gas flow (40, 140).

6. Production process (2, 102, 202, 302) of a shell structured solid catalyst material (7, 107, 207, 307, 307') in accordance with any one of the preceding claims, further
**characterized in that**
the metal complex (15, 15', 115, 115', 215, 315) comprises a transition metal like iron, nickel, cobalt, molybdenum, or a precious metal like rhodium, platinum, ruthenium, palladium, or iridium or any combination thereof.

7. Production process (2, 102, 202, 302) of a shell structured solid catalyst material (7, 107, 207, 307, 307') in accordance with any one of the preceding claims, further
**characterized in that**
an overall temperature of the solid material (8, 8', 108, 108', 208, 208', 308, 308', 308") is kept in or below a room temperature range but still above a condensation temperature range of the metal complex (15, 15', 115, 115', 215, 315) during at least one step of adsorption.

8. Production process (2, 102, 202, 302) of a shell structured solid catalyst material (7, 107, 207, 307, 307') in accordance with any one of the preceding claims, further
**characterized in that**
the metal complex (15, 15', 115, 115', 215, 315) is fed in a steady and continuous flow of argon in a cross-flow configuration.

9. Production process (2, 102, 202, 302) of a shell structured solid catalyst material (7, 107, 207, 307, 307') in accordance with any one of the preceding claims, further
**characterized in that**
at least one particle of the solid material (8, 8', 108, 108', 208, 208', 308, 308', 308") is fixed to a support framework, like a pipe, a honeycomb structure, a cordierite, or a metallic foam.

10. Production process (2, 102, 202, 302) of a shell structured solid catalyst material (7, 107, 207, 307, 307') in accordance with any one of the preceding claims, further
**characterized in that**
the adsorption step of the metal complex (15, 15', 115, 115', 215, 315) in the solid material (8, 8', 108, 108', 208, 208', 308, 308', 308") is preceded by a process step of surface activation or a process step of surface passivation of the solid material (8, 8', 108, 108', 208, 208', 308, 308', 308").

11. Production process (2, 102, 202, 302) of a shell structured solid catalyst material (7, 107, 207, 307, 307') in accordance with any one of the preceding claims, further
**characterized in that**
impregnation of the solid material (8, 8', 108, 108', 208, 208', 308, 308', 308") with metal is carried out in circulation of the solid material (8, 8', 108, 108', 208, 208', 308, 308', 308").

12. Production process (2, 102, 202, 302) of a shell structured solid catalyst material (7, 107, 207, 307, 307') in accordance with any one of the preceding claims, further
**characterized in that**
the solid catalyst material (7, 107, 207, 307, 307') for heterogeneous catalysis is a catalyst for selective catalytic reduction, which catalyses decomposition of nitrogen oxide molecules, or a catalyst for chemical synthesis.

13. Production process (2, 102, 202, 302) of a shell structured solid catalyst material (7, 107, 207, 307, 307') in accordance with any one of the preceding claims, further
**characterized in that**
during oxidation due to exposure to oxidizing gas, a temperature of the solid material (8, 8', 108, 108', 208, 208', 308, 308', 308") is kept below a Tammann temperature of the metal complex (15, 15', 115, 115', 215, 315).

14. Production process (2, 102, 202, 302) of a shell structured solid catalyst material (7, 107, 207, 307, 307') in accordance with any one of the preceding claims, further
**characterized in that**
at least some of the structures enclosing the pore (9') or the cavity bind metal dispersed as monomeric species (m, m1) or dimeric species (o1) of metal or metal bound to the oxidizing gas (17, 17', 117, 217, 317).

15. Use of an apparatus (50, 150) for production of shell structured solid catalyst material (7, 107, 207, 307, 307'),
the apparatus (50, 150) comprising at least one fluid supply-line (83, 84, 183, 184), a process control unit (51) and a reactor (53, 153) for solid particles, like a fluidized bed reactor (53) or a cross flow reactor (153),
comprising at least one reactor vessel (55, 155, 158),
whereas the at least one fluid supply-line (83, 84, 183, 184) being connectable to at least one fluid feeder (56, 156) fluidly in communication with the at least one reactor vessel (55, 155, 158),
**characterized in that**
the apparatus (50, 150) comprises at least one through-flow fluid heat exchanger (47, 47', 47", 48, 48', 48"), like a through-flow heater (47, 47', 47") or a through-flow cooler (48, 48', 48"), and a thermalizing reactor-vessel-by-pass line (86, 86', 86", 186, 186'), like a first thermalizing by-pass line (86, 186) for an oxidizing fluid (17, 17', 117, 217, 317, 33, 133, 233, 333) and a second thermalizing by-pass line (86, 186) for a metal complex fluid (15, 15', 115, 115', 215, 315), and
the process control unit (51) comprises a timer (78), and
operates at least one valve (22, 88, 89, 89', 90, 91, 92, 93, 189, 189', 192, 193), like a control valve (89, 89', 90, 189, 189'), the reactor-vessel-by-pass line (86, 86', 86", 186, 186') being connectable by the at least one valve (89, 89', 90, 189, 189') to the at least one fluid supply-line (83, 84, 183, 184).

## Patentansprüche

1. Herstellungsverfahren (2, 102, 202, 302) eines schalenstrukturierten, festen Katalysatormaterials (7, 107, 207, 307, 307')
unter Verwendung eines festen Materials (8, 8', 108, 108', 208, 208', 308, 308', 308"), das mindestens eine Pore (9') oder mindestens eine Kavität aufweist, wie ein mesoporiges siliziumdioxidbasiertes Material, ein Zeolith, ein Metallschaum, ein aluminiumoxid- oder titanoxid-basiertes Material, ein aktiviertes Kohlenstoffmaterial oder ein Kohlenstoffmaterial mit einer strukturierten Oberfläche, wie expandierter Graphit, Nanographit, Graphen oder eine Struktur aus Graphenschichten, die einem Metallkomplex (15, 15', 115, 115', 215, 315) ausgesetzt ist, der in einer Gasphase oder einer Dampfphase, wie Metallcarbonylmoleküle oder metallorganische Verbindungen, bereitgestellt wird, der in die Pore (9') oder die Kavität gelangt, wobei das feste Material (8, 8', 108, 108', 208, 208', 308, 308', 308") durch Herstellungsverfahrensschritte der folgenden Art mit Metall imprägniert wird:
- Adsorption des Metallkomplexes (15, 15', 115, 115', 215, 315) in der Pore (9') oder in der Kavität des festen Materials (8, 8', 108, 108', 208, 208', 308, 308', 308") und
- Zersetzung des Metallkomplexes (15, 15', 115, 115', 215, 315),
**dadurch gekennzeichnet, dass**
die Adsorption des Metallkomplexes (15, 15', 115, 115', 215, 315) durch eine Adsorptionszeit (32, 32', 132, 232, 332, 332') des Metallkomplexes (15, 15', 115, 115', 215, 315), dem das feste Material (8, 8', 108, 108', 208, 208', 308, 308', 308") ausgesetzt ist, reguliert ist, so dass der Metallkomplex (15, 15', 115, 115', 215, 315) an eine Oberfläche des festen Materials (8, 8', 108, 108', 208, 208', 308, 308', 308") in einem ersten Bereich (10, 10', 110) entlang der Pore (9') oder der Kavität gebunden wird, und der erste Bereich fortgesetzt ist durch einen zweiten Bereich (11, 11', 111), entlang der Pore (9') oder der Kavität, und
die Zersetzung mittels Oxidation aufgrund der Exponierung des Metallkomplexes (15, 15', 115, 115', 215, 315) in oxidierendem Gas (17, 17', 117, 217, 317), wie Luft, Sauerstoff oder einem Halogen erfolgt, das in die Pore (9') oder Kavität gelangt, wobei Metall von dem Metallkomplex (15, 15', 115, 115', 215, 315) an der Oberfläche des festen Materials (8, 8', 108, 108', 208, 208', 308, 308', 308") in dem ersten Bereich (10, 10', 110) angesetzt ist und der zweite Bereich (11, 11', 111) frei von Metall aus dem Metallkomplex (15, 15', 115, 115', 215, 315) bleibt.

2. Herstellungsverfahren (2, 102, 202, 302) eines schalenstrukturierten, festen Katalysatormaterials (7, 107, 207, 307, 307') nach Anspruch 1, weiter **dadurch gekennzeichnet, dass** eine Gewichtsquantität von Metall in dem ersten Bereich (10, 10', 110) des festen Katalysatormaterials (7, 107, 207, 307, 307') durch mindestens einen zusätzlichen Verfahrensschritt, der Adsorption von dem Metallkomplex (15, 15', 115, 115', 215, 315) umfasst, erhöht wird.

3. Herstellungsverfahren (2, 102, 202, 302) eines schalenstrukturierten, festen Katalysatormaterials (7, 107, 207, 307, 307') nach Anspruch 1 oder Anspruch 2, weiter **dadurch gekennzeichnet, dass**
eine Schicht (12, 12') des ersten Bereichs (10, 10', 110) durch die Adsorptionszeit (32, 32', 132, 232, 332, 332') reguliert wird.

4. Herstellungsverfahren (2, 102, 202, 302) eines schalenstrukturierten, festen Katalysatormaterials (7, 107, 207, 307, 307') nach einem der vorhergehenden Ansprüche, weiter **dadurch gekennzeichnet, dass**
Adsorption des Metallkomplexes (15, 15', 115, 115', 215, 315) durch ein Zeitintervall für einen Fluss (32, 132, 232, 332, 332') des Metallkomplexes (15, 15', 115, 115', 215, 315) reguliert wird.

5. Herstellungsverfahren (2, 102, 202, 302) eines schalenstrukturierten, festen Katalysatormaterials (7, 107, 207, 307, 307') nach einem der vorhergehenden Ansprüche, weiter **dadurch gekennzeichnet, dass**
Zersetzung des Metallkomplexes (15, 15', 115, 115', 215, 315) durch ein Zeitintervall der Einwirkung eines Flusses eines oxidierenden Gases (40, 140) reguliert wird.

6. Herstellungsverfahren (2, 102, 202, 302) eines schalenstrukturierten, festen Katalysatormaterials (7, 107, 207, 307, 307') nach einem der vorhergehenden Ansprüche, weiter **dadurch gekennzeichnet, dass**
der Metallkomplex (15, 15', 115, 115', 215, 315) ein Übergangsmetall wie Eisen, Nickel, Kobalt, Molybdän oder ein Edelmetall wie Rhodium, Platin, Ruthenium, Palladium oder Iridium oder eine Kombination davon umfasst.

7. Herstellungsverfahren (2, 102, 202, 302) eines schalenstrukturierten, festen Katalysatormaterials (7, 107, 207, 307, 307') nach einem der vorhergehenden Ansprüche, weiter **dadurch gekennzeichnet, dass**
eine Gesamttemperatur des festen Materials (8, 8', 108, 108', 208, 208', 308, 308', 308") in oder unter einem Raumtemperaturbereich gehalten wird, aber noch oberhalb eines Kondensationstemperaturbereichs des Metallkomplexes (15, 15', 115, 115', 215, 315) während mindestens eines Schritts der Adsorption.

8. Herstellungsverfahren (2, 102, 202, 302) eines schalenstrukturierten, festen Katalysatormaterials (7, 107, 207, 307, 307') nach einem der vorhergehenden Ansprüche, weiter **dadurch gekennzeichnet, dass**
der Metallkomplex (15, 15', 115, 115', 215, 315) in einem gleichmäßigen und kontinuierlichen Fluss von Argon in einer Querströmungskonfiguration, zugeführt wird.

9. Herstellungsverfahren (2, 102, 202, 302) eines schalenstrukturierten, festen Katalysatormaterials (7, 107, 207, 307, 307') nach einem der vorhergehenden Ansprüche, weiter **dadurch gekennzeichnet, dass**
mindestens ein Partikel des festen Materials (8, 8', 108, 108', 208, 208', 308, 308', 308") an einem Stützgerüst, wie ein Rohr, eine Wabenstruktur, einem Cordierit oder einem Metallschaum, fixiert ist.

10. Herstellungsverfahren (2, 102, 202, 302) eines schalenstrukturierten, festen Katalysatormaterials (7, 107, 207, 307, 307') nach einem der vorhergehenden Ansprüche, weiter **dadurch gekennzeichnet, dass**
dem Schritt der Adsorption des Metallkomplexes (15, 15', 115, 115', 215, 315) im festen Material (8, 8', 108, 108', 208, 208', 308, 308', 308 ") ein Verfahrensschritt einer Oberflächenaktivierung oder ein Verfahrensschritt einer Oberflächenpassivierung des festen Materials (8, 8', 108, 108', 208, 208', 308, 308', 308") vorausgeht.

11. Herstellungsverfahren (2, 102, 202, 302) eines schalenstrukturierten, festen Katalysatormaterials (7, 107, 207, 307, 307') nach einem der vorhergehenden Ansprüche, weiter **dadurch gekennzeichnet, dass**
Imprägnieren des festen Materials (8, 8', 108, 108', 208, 208', 308, 308', 308") mit Metall bei Zirkulation des festen Materials (8, 8', 108, 108', 208, 208', 308, 308', 308") erfolgt.

12. Herstellungsverfahren (2, 102, 202, 302) eines schalenstrukturierten, festen Katalysatormaterials (7, 107, 207, 307, 307') nach einem der vorhergehenden Ansprüche, weiter **dadurch gekennzeichnet, dass**
das feste Katalysatormaterial (7, 107, 207, 307, 307') für heterogene Katalyse ein Katalysator für selektive katalytische Reduktion ist, der die Zersetzung von Stickoxidmolekülen katalysiert, oder ein Katalysator für chemische Synthese.

13. Herstellungsverfahren (2, 102, 202, 302) eines schalenstrukturierten, festen Katalysatormaterials (7, 107, 207, 307, 307') nach einem der vorhergehenden Ansprüche, weiter **dadurch gekennzeichnet, dass**
während der Oxidation durch Einwirkung von oxidierendem Gas eine Temperatur des festen Materials (8, 8', 108, 108', 208, 208', 308, 308', 308") unterhalb einer Tammann-Temperatur des Metallkomplexes (15, 15', 115, 115', 215, 315) gehalten wird.

14. Herstellungsverfahren (2, 102, 202, 302) eines schalenstrukturierten, festen Katalysatormaterials (7, 107, 207, 307, 307') nach einem der vorhergehenden Ansprüche, weiter **dadurch gekennzeichnet, dass**
mindestens einige Strukturen, die die Pore (9') oder die Kavität einschließen, Metall dispergiert als monomere Spezies (m, m1) oder dimere Spezies (o1) von Metall oder Metall gebunden an das oxidierende Gas (17, 17', 117, 217, 317) binden.

15. Verwendung einer Vorrichtung (50, 150) zur Herstellung von schalenstrukturiertem, festem Katalysatormaterial (7, 107, 207, 307, 307'), wobei die Vorrichtung (50, 150) mindestens eine Fluidzufuhrleitung (83, 84, 183, 184), eine Prozesssteuereinheit (51) und einen Reaktor (53, 153) für feste Partikel, wie einen Wirbelschichtreaktor (53) oder Fließbettreaktor (53) oder einen Kreuzstromreaktor (153), der mindestens einen Reaktorbehälter (55, 155, 158) aufweist, umfasst, wobei die mindestens eine Fluidzufuhrleitung (83, 84, 183, 184) mit mindestens einer Fluidzuführung (56, 156), die in Fluidverbindung mit dem mindestens einen Reaktorbehälter (55, 155, 158) steht, verbindbar ist,
**dadurch gekennzeichnet, dass**
die Vorrichtung (50, 150) mindestens einen Durchflussfluidwärmetauscher (47, 47', 47", 48, 48', 48"), wie einen Durchflusserhitzer (47, 47', 47") oder einen Durchflusskühler (48, 48', 48"), und eine Reaktorbehälter-Umgehungsleitung (86, 86', 86", 186, 186') zu Thermalisierung, wie eine erste Umgehungsleitung (86, 186) zur Thermalisierung für ein oxidierendes Fluid (17, 17', 117, 217, 317, 33, 133, 233, 333) und eine zweite Umgehungseitung (86, 186) zur Thermalisierung für ein Metallkomplexfluid (15, 15', 115, 115', 215, 315), umfasst, und die Prozesssteuereinheit (51) einen Zeitgeber (78) umfasst und mindestens ein Ventil (22, 88, 89, 89', 90, 91, 92, 93, 189, 189', 192, 193), wie ein Steuerventil (89, 89', 90, 189, 189'), ansteuert, wobei die Reaktorbehälter-Umgehungsleitung (86, 86', 86", 186, 186') durch mindestens ein Steuerventil (89, 89', 90, 189, 189') mit der wenigstens einen Fluidzufuhrleitung (83, 84, 183, 184) verbindbar ist.

## Revendications

1. Procédé de fabrication (2, 102, 202, 302) d'un matériau catalyseur solide à structure de type enveloppe (7, 107, 207, 307, 307')
qui utilise un matériau solide (8, 8', 108, 108', 208, 208', 308, 308', 308"), qui a au moins un pore (9') ou au moins une cavité, comme un matériau à base de silice mésoporeuse, un zéolite, une mousse métallique, un matériau à base un oxyde d'aluminium ou un oxyde de titane, un charbon actif ou un matériau à base de carbone à surface structurée tel que le graphite expansé, le nanographite, le graphène ou une structure à couche de graphène,
qui est exposé à un complexe métallique (15, 15', 115, 115', 215, 315) fourni dans une phase gazeuse ou une phase vapeur, comme des molécules de carbonyle de métal ou des composés organométalliques, qui entre dans le pore (9') ou la cavité,
cependant que le matériau solide (8, 8', 108, 108', 208, 208', 308, 308', 308") est imprégné de métal par des étapes du procédé de fabrication du type suivant :
- adsorption du complexe métallique (15, 15', 115, 115', 215, 315) dans le pore (9') ou dans la cavité du matériau solide (8, 8', 108, 108', 208, 208', 308, 308', 308") et
- décomposition du complexe métallique (15, 15', 115, 115', 215, 315), **caractérisé en ce que**
l'adsorption du complexe métallique (15, 15', 115, 115', 215, 315) est commandée par un temps d'adsorption (32, 32', 132, 232, 332, 332') du complexe métallique (15, 15', 115, 115', 215, 315) exposé au matériau solide (8, 8', 108, 108', 208, 208', 308, 308', 308") de telle manière que le complexe métallique (15, 15', 115, 115', 215, 315) est lié à une surface du matériau solide (8, 8', 108, 108', 208, 208', 308, 308', 308") dans une première section (10, 10', 110) le long du pore (9') ou de la cavité et
la première section est continuée par une seconde section (11, 11', 111) le long du pore (9') ou de la cavité et
la décomposition est exécutée au moyen d'oxydation due à l'exposition du complexe métallique (15, 15', 115, 115', 215, 315) à un gaz oxydant (17, 17', 117, 217, 317) comme l'air, l'oxygène ou un halogène, qui entre dans le pore (9') ou la cavité,
le métal du complexe métallique (15, 15', 115, 115', 215, 315) étant fixé à la surface du matériau solide (8, 8', 108, 108', 208, 208', 308, 308', 308") dans la première section (10, 10', 110) et la seconde section (11, 11', 111) restant exempte du métal du complexe métallique (15, 15', 115, 115', 215, 315).

2. Procédé de fabrication (2, 102, 202, 302) d'un matériau catalyseur solide à structure de type enveloppe (7, 107, 207, 307, 307') selon la revendication 1, **caractérisé de plus en ce qu'**une quantité de poids de métal dans la première section (10, 10', 110) du matériau catalyseur solide (7, 107, 207, 307, 307') est augmenté par au moins une étape de procédé supplémentaire comprenant l'adsorption du complexe métallique (15, 15', 115, 115', 215, 315).

3. Procédé de fabrication (2, 102, 202, 302) d'un matériau catalyseur solide à structure de type enveloppe (7, 107, 207, 307, 307') selon la revendication 1 ou 2, **caractérisé de plus en ce qu'**une épaisseur (12, 12') de la première section (10, 10', 110) est commandée par le temps d'adsorption (32, 32', 132, 232, 332, 332').

4. Procédé de fabrication (2, 102, 202, 302) d'un matériau catalyseur solide à structure de type enveloppe (7, 107, 207, 307, 307') selon l'une quelconque des revendications précédentes, **caractérisé de plus en ce que** l'adsorption du complexe métallique (15, 15', 115, 115', 215, 315) est commandée par un intervalle de temps d'un flux (32, 132, 232, 332, 332') du complexe métallique (15, 15', 115, 115', 215, 315).

5. Procédé de fabrication (2, 102, 202, 302) d'un matériau catalyseur solide à structure de type enveloppe (7, 107, 207, 307, 307') selon l'une quelconque des revendications précédentes, **caractérisé de plus en ce que** la décomposition du complexe métallique (15, 15', 115, 115', 215, 315) est commandée par un intervalle de temps d'exposition à un flux de gaz oxydant (40, 140).

6. Procédé de fabrication (2, 102, 202, 302) d'un matériau catalyseur solide à structure de type enveloppe (7, 107, 207, 307, 307') selon l'une quelconque des revendications précédentes, **caractérisé de plus en ce que** le complexe métallique (15, 15', 115, 115', 215, 315) comprend un métal de transition comme le fer, le nickel, le cobalt, le molybdène ou un métal précieux comme le rhodium, le platine, le ruthénium, le palladium ou l'iridium ou n'importe quelle combinaison de ceux-ci.

7. Procédé de fabrication (2, 102, 202, 302) d'un matériau catalyseur solide à structure de type enveloppe (7, 107, 207, 307, 307') selon l'une quelconque des revendications précédentes, **caractérisé de plus en ce qu'**une température générale du matériau solide (8, 8', 108, 108', 208, 208', 308, 308', 308") est maintenue dans une plage de température ambiante ou en dessous mais encore au-dessus d'une plage de température de condensation du complexe métallique (15, 15', 115, 115', 215, 315) pendant au moins une étape d'adsorption.

8. Procédé de fabrication (2, 102, 202, 302) d'un matériau catalyseur solide à structure de type enveloppe (7, 107, 207, 307, 307') selon l'une quelconque des revendications précédentes, **caractérisé de plus en ce que** le complexe métallique (15, 15', 115, 115', 215, 315) est alimenté dans un flux régulier et continu d'argon dans une configuration d'écoulement croisé.

9. Procédé de fabrication (2, 102, 202, 302) d'un matériau catalyseur solide à structure de type enveloppe (7, 107, 207, 307, 307') selon l'une quelconque des revendications précédentes, **caractérisé de plus en ce qu'**au moins une particule du matériau solide (8, 8', 108, 108', 208, 208', 308, 308', 308") est fixée à un cadre de support comme un tuyau, une structure alvéolée, une cordiérite ou une mousse métallique.

10. Procédé de fabrication (2, 102, 202, 302) d'un matériau catalyseur solide à structure de type enveloppe (7, 107, 207, 307, 307') selon l'une quelconque des revendications précédentes, **caractérisé de plus en ce que** l'étape d'adsorption du complexe métallique (15, 15', 115, 115', 215, 315) dans le matériau solide (8, 8', 108, 108', 208, 208', 308, 308', 308") est précédée par une étape de procédé d'activation de surface ou une étape de procédé de passivation de surface du matériau solide (8, 8', 108, 108', 208, 208', 308, 308', 308").

11. Procédé de fabrication (2, 102, 202, 302) d'un matériau catalyseur solide à structure de type enveloppe (7, 107, 207, 307, 307') selon l'une quelconque des revendications précédentes, **caractérisé de plus en ce que** l'imprégnation du matériau solide (8, 8', 108, 108', 208, 208', 308, 308', 308") avec du métal est exécutée dans une circulation du matériau solide (8, 8', 108, 108', 208, 208', 308, 308', 308").

12. Procédé de fabrication (2, 102, 202, 302) d'un matériau catalyseur solide à structure de type enveloppe (7, 107, 207, 307, 307') selon l'une quelconque des revendications précédentes, **caractérisé de plus en ce que** le matériau catalyseur solide (7, 107, 207, 307, 307') pour une catalyse hétérogène est un catalyseur pour une réduction catalytique sélective qui catalyse la décomposition des molécules d'oxyde d'azote ou un catalyseur pour une synthèse chimique.

13. Procédé de fabrication (2, 102, 202, 302) d'un matériau catalyseur solide à structure de type enveloppe (7, 107, 207, 307, 307') selon l'une quelconque des revendications précédentes, **caractérisé de plus en ce que** pendant l'oxydation due à l'exposition au gaz oxydant une température du matériau solide (8, 8', 108, 108', 208, 208', 308, 308', 308") est maintenue en dessous d'une température de Tammann du complexe métallique (15, 15', 115, 115', 215, 315).

14. Procédé de fabrication (2, 102, 202, 302) d'un matériau catalyseur solide à structure de type enveloppe (7, 107, 207, 307, 307') selon l'une quelconque des revendications précédentes, **caractérisé de plus en ce qu'**au moins quelques unes des structures qui renferment le pore (9') ou la cavité lient du métal dispersé en tant qu'espèce monomère (m, m1) ou qu'espèce dimère (o1) de métal ou de métal lié au gaz oxydant (17, 17', 117, 217, 317).

15. Utilisation d'un appareil (50, 150) pour la fabrication d'un matériau catalyseur solide à structure de type enveloppe (7, 107, 207, 307, 307'), l'appareil (50, 150) comprenant au moins une conduite d'alimentation en fluide (83, 84, 183, 184), une unité de contrôle du procédé (51) et un réacteur (53, 153) pour des particules solides comme un réacteur à lit fluidisé (53) ou un réacteur à flux croisé (153),
comprenant au moins une cuve de réacteur (55, 155, 158), tandis que la au moins une conduite d'alimentation en fluide (83, 84, 183, 184) peut être reliée à au moins un dispositif d'alimentation en fluide (56, 156) en communication fluidique avec la au moins une cuve de réacteur (55, 155, 158),
**caractérisée en ce que**
l'appareil (50, 150) comprend au moins un échangeur de chaleur à circulation de fluide (47, 47', 47", 48, 48', 48"), comme un radiateur à circulation de fluide (47, 47', 47") ou un refroidisseur à circulation de fluide (48, 48', 48") et une ligne de dérivation de thermalisation cuve-réacteur (86, 86', 86", 186, 186') comme une première ligne de dérivation de thermalisation (86, 186) pour un fluide oxydant (17, 17', 117, 217, 317, 33, 133, 233, 333) et une seconde ligne de dérivation de thermalisation (86, 186) pour un fluide du complexe métallique (15, 15', 115, 115', 215, 315) et l'unité de contrôle du procédé (51) comprenant une minuterie (78) et commandant au moins une vanne (22, 88, 89, 89', 90, 91, 92, 93, 189, 189', 192, 193) comme une vanne de contrôle (89, 89', 90, 189, 189'), la ligne de dérivation de thermalisation cuve-réacteur (86, 86', 86", 186, 186') pouvant être reliée par la au moins une vanne (89, 89', 90, 189, 189') à la au moins une conduite d'alimentation en fluide (83, 84, 183, 184).
